# EUROPÄISCHE PATENTSCHRIFT

(11) **EP 0 980 520 B1**
(45) Veröffentlichungstag und Bekanntmachung des Hinweises auf die Patenterteilung: **06.08.2003**
(21) Anmeldenummer: 98930670.9
(22) Anmeldetag: 04.05.1998
(51) Int. Cl.: G01N 23/04, G01N 23/18, H05K 13/08, G01R 31/304

(54) **VERFAHREN UND SCHALTUNGSANORDNUNG ZUR PRÜFUNG VON LÖTSTELLEN**
PROCESS AND CIRCUITRY FOR INSPECTING WELDING POINTS
PROCEDE ET AGENCEMENT DE CIRCUITS POUR CONTROLER DES POINTS DE SOUDURE

(30) Priorität: 05.05.1997 DE 19718940
(43) Veröffentlichungstag der Anmeldung: 23.02.2000
(73) Patentinhaber: MACROTRON PROCESS TECHNOLOGIES GMBH, 85551 Kirchheim (DE)
(72) Erfinder: SPERSCHNEIDER, Eckhard, D-85579 Neubiberg (DE)
(74) Vertreter: Dosterschill, Peter, Dr.
(86) Internationale Anmeldenummer: EP9802615
(87) Internationale Veröffentlichungsnummer: WO98050784

(56) Entgegenhaltungen:
- EP-A- 0 236 001
- EP-A- 0 433 803
- WO-A-97/17605
- US-A- 5 291 535
- US-A- 5 493 594
- DRIELS M R ET AL: "AUTOMATIC DEFECT CLASSIFICATION OF PRINTED WIRING BOARD SOLDER JOINTS" IEEE TRANSACTIONS ON COMPONENTS,HYBRIDS,AND MANUFACTURING TECHNOLOGY, Bd. 13, Nr. 2, 1. Juni 1990, Seiten 331-340, XP000179243
- PARK J S ET AL: "A SOLDER JOINT INSPECTION SYSTEM FOR AUTOMATED PRINTED CIRCUIT BOARD MANUFACTURING" PROCEEDINGS OF THE INTERNATIONAL CONFERENCE ON ROBOTICS AND AUTOMATION, CINCINNATI, MAY 13 - 18, 1990, Bd. 2, 13. Mai 1990, Seiten 1290-1295, XP000143745 INSTITUTE OF ELECTRICAL AND ELECTRONICS ENGINEERS
- FELDMANN K ET AL: "CLOSED LOOP QUALITY CONTROL IN PRINTED CIRCUIT ASSEMBLY" IEEE TRANSACTIONS ON COMPONENTS, PACKAGING AND MANUFACTURING TECHNOLOGY: PART A, Bd. 17, Nr. 2, 1. Juni 1994, Seiten 270-276, XP000455263

## Beschreibung

Die Erfindung betrifft ein Verfahren und eine Schaltungsanordnung zur Auswahl mindestens eines Meßparameters bei Prüfung einer Lötstelle nach dem Oberbegriff der Ansprüche 1 bzw. 20.

Die Qualität von Lötstellen auf Leiterplatten kann mittels Röntgenstrahlung auf Fehler überprüft werden. Dabei werden lötstellenindividuelle Qualitätsinformationen gebildet, wobei für jede Lötstelle entweder die Information "Lötstelle fehlerfrei oder die Information "Lötstelle fehlerhaft" gebildet wird. Diese Informationen werden leiterplattenbezogen ausgedruckt, wobei dieser Ausdruck zusammen mit der zugehörigen Leiterplatte einem Reparaturarbeitsplatz zugeführt wird. Dort werden die Leiterplatten, die mindestens eine Lötstelle aufweisen, für die die Information "Lötstelle fehlerhaft" gebildet wurde, einer Nachbehandlung unterzogen, wobei die angeblich fehlerhafte Lötstelle visuell überprüft wird. Ergibt sich dabei, daß die Lötstelle tatsächlich fehlerhaft ist, wird die Kontaktstelle mit der ursprünglichen fehlerhaften Lötstelle erneut gelötet. Im Anschluß daran wird erneut geprüft, ob diese Lötstelle nunmehr fehlerfrei ist. Diese Arbeiten werden in einem Protokoll vermerkt, das gegebenenfalls für statistische Auswertungen zur Verfügung steht.

Aus EP 0 236 001 B1 ist bereits ein Verfahren und eine Vorrichtung zum Messen struktureller Eigenschaften ausgewählter Bereiche einer hergestellten Leiterplatte mit darauf vorgesehenen Lötstellen bekannt. Die Vorrichtung weist eine Röntgeneinrichtung zum Erzeugen eines Röntgenstrahls auf, eine Abbildungseinrichtung zum Erfassen der durch die Leiterplatte übertragenen Röntgenstrahlen zum Erzeugen eines entsprechenden elektronischen Bildes, eine Verarbeitungseinrichtung zum Umwandeln des elektronischen Bildes in ein nach einer Grauskala kodiertes Bild und eine Recheneinrichtung, die Messungen auf dem nach einer Grauskala kodierten Bildes auf der Grundlage aus einer Datenbibliothek ausgewählter Meßalgorithmen ausführt, die sich auf vorgebbare elektronische Standard-Bauteile und Anordnungen sowie auf bestimmte Arten von hiermit verbundenen Lötstellendefekten (u.a. "solder ball," "excess solder", "cold solder joint"), beziehen. Die Recheneinrichtung erzeugt weiterhin ein Ausgangssignal, das einer Änderung der Messungen des nach einer Grauskala kodierten Bildes von vorbestimmten Meßstandards entspricht, die ihrerseits gewünschten, in der Bibliothek enthaltenen strukturellen Eigenschaften entsprechen.

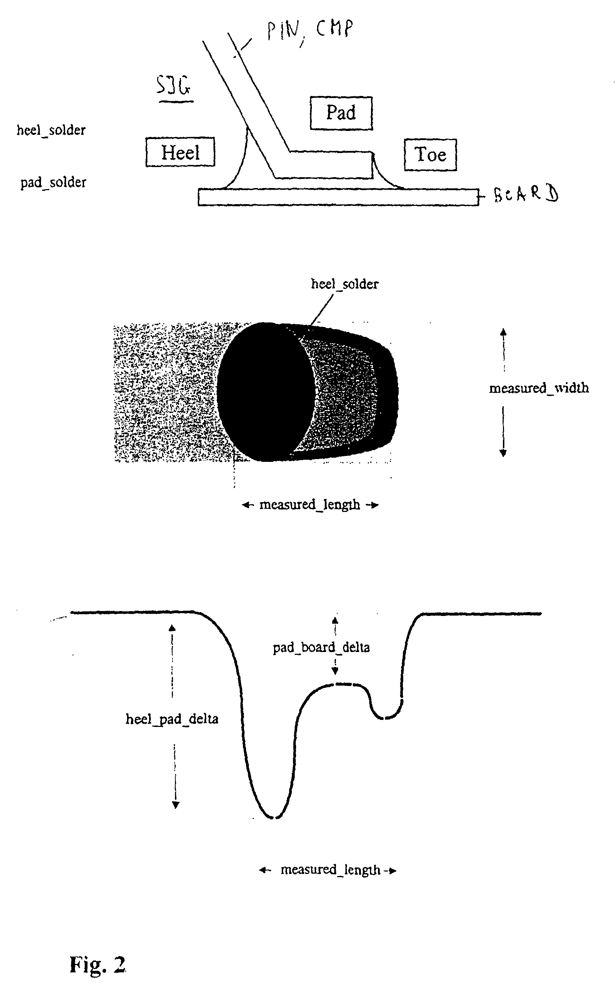

Die Prüfung von Lötstellen auf Fehlertreiheit kann in der Weise erfolgen, daß eine Bedienperson einer Prüfeinrichtung die Messung einer Vielzahl von Referenzlötstellen mittels Röntgenstrahlung auf einen oder mehrere vorgebbare Meßparameter veranlaßt. Diese Meßparameter beschreiben bestimmte Einzelaspekte der Lötstellen, beispielsweise die Längsausdehnung der Lötstellen, die Breitenausdehnung der Lötstellen, die Talbreite eines Querschnitts der Lötstelle und eine Höhendifferenz zwischen Scheitelpunkt und Talpunkt der Lötstellen. Die Messung der Referenzlötstellen mittels Röntgenstrahlung liefert Informationen, die Grauwertdaten der Lötstellen bezeichnen. Beispiele für derartige Informationen sind in den Figuren 2 bis 5, jeweils im unteren Teil dargestellt. Die durch die Messung gelieferten Informationen werden als Bezugsgrößen für eine spätere Prüfung von Lötstellen verwendet. In herkömmlichen Systemen liefern allerdings spätere Prüfungen von Lötstellen in einem erheblichen Umfang Ergebnisse, die objektiv falsch sind: zum einen sind Lötstellen, die als fehlerfrei bewertet worden sind, tatsächlich fehlerhaft und zum anderen sind Lötstellen, die als fehlerfrei bewertet worden sind, tatsächlich fehlerfrei.

Aus PARK J S ET AL:"A SOLDER JOINT INSPECTION SYSTEM FOR AUTOMATED PRINTED CIRCUIT BOARD MANUFACTURING", PROCEEDINGS OF THE INTERNATIONAL CONFERENCE ON ROBOTICS AND AUTOMATION, CINCINNATI, MAY 13-18, 1990, Bd. 2, 13. Mai 1990, Seiten 1290-1295, XP000143745 INSTITUTE OF ELEC-TRICAL AND ELECTRONICS ENGINEERS, ist ein Lötstelleninspektionssystem bekannt, bei dem vier Rahmen von Lötstellenbildern benutzt und 15 Kriterien aus den Bildern extrahiert werden, um die sieben wichtigsten Klassen von Lötstellenfehlern zu bilden.

Ausgehend von diesem Stand der Technik liegt der Erfindung die Aufgabe zugrunde, ein Verfahren und eine Schaltungsanordnung der eingangs genannten Art anzugeben, welche die Wahrscheinlichkeit für das Auftreten von fehlerhaften Ergebnissen von Lötstellenprüfungen reduziert.

Diese Aufgabe wird erfindungsgemäß mit einem Verfahren und einer Schaltungsanordnung gelöst, welche in den Ansprüchen definiert sind.

Erfindungsgemäß werden Meßwertinformationen fehlerfreier Referenzlötstellen eines vorgebbaren Lötstellentyps mit Meßwertinformationen mindestens einer fehlerhaften Referenzlötstelle desselben Lötstellentyps korreliert. Basierend auf dieser Korrelation werden für die Prüfung typgleicher Lötstellen Meßwertparameter ausgewählt. Ausgewählt werden Meßparameter, mit denen es möglich ist, einen spezieller Lötstellenfehlertyp zu detektieren. Die Verwendung der ausgewählten Meßwertparameter führt zu Prüfungsergebnissen, die mit einer hohen Wahrscheinlichkeit korrekt sind. Damit wird einerseits vermieden, daß tatsächlich fehlerfreie Lötstellen, die sonst unzutreffend als fehlerhaft bewertet werden, nicht ausgesondert und eventuell einer tatsächlich nicht erforderlichen Reparatur unterzogen werden, sondern ihrer vorgesehenen Verwendung zugeführt werden. Andererseits wird vermieden, daß tatsächlich fehlerhafte Lötstellen als fehlerfrei bewertet werden und durch ihren Einsatz in elektronischen System zu deren Nichtfunktion führen.

Eine weitere vorteilhafte Ausführungsform des erfindungsgemäßen Verfahrens ist dadurch gekennzeichnet, daß eine Lötstelle bei der Prüfung selbst dann als fehlerfrei bewertet wird, sofern der im Rahmen der Prüfung gebildete Meßparameterwert mindestens gleich groß wie ein zweiter meßparameterindividueller Schwellwert ist, der um eine meßparameterindividuelle Schwellwertabweichung kleiner als ein erster meßparameterindividuelle Schwellwert ist. Damit wird der Umfang der Lötstellen, die sonst als fehlerhaft bewertet werden würden, tatsächlich aber fehlerfrei sind und dementsprechend als fehlerfrei bewertet werden, erhöht.

Die Erfindung wird nun anhand der Zeichnungen beschrieben.

Es zeigt:
- Fig. 1: eine Anordnung von Einrichtungen im-Zusammenhang mit der Durchführung des erfindungsgemäßen Verfahrens;
- Fig. 2: eine Schnittdarstellung, ein Grauwertbild und eine graphische Darstellung eines elektrischen Signals des Grauwertbildes eines ersten Lötstellentyps (SOT-Lötstelle);
- Fig.3: eine Schnittdarstellung, ein Grauwertbild und eine graphische Darstellung eines elektrischen Signals des Grauwertbildes eines zweiten Lötstellentyps (Lötstelle für diskrete Bauelemente);
- Fig. 4: eine Schnittdarstellung, ein Grauwertbild und eine graphische Darstellung eines elektrischen Signals des Grauwertbildes eines dritten Lötstellentyps (Gullwing Pin-Lötstelle);
- Fig. 5: eine Schnittdarstellung, ein Grauwertbild und eine graphische Darstellung eines elektrischen Signals des Grauwertbildes eines vierten Lötstellentyps (Lötstelle für j-förmige Kontaktelemente, "J-Lead Pins");
- Fig. 6: eine Gegenüberstellung einer fehlerfreien Lötstelle SJG und einer fehlerhaften Lötstelle SJB sowie eine Mehrzahl fehlerfreier Lötstellen unterschiedlicher Typen;
- Fig. 7: eine schematische Darstellung von Meßparameterwerten von Referenzlötstellen, von Fehleristwertbereichen, Schwellwerten und Schwellwertabweichungen, die im Rahmen des erfindungsgemäßen Verfahrens gebildet werden;
- Fig. 8: eine Bildschinnanzeige von Meßparameterwerten unterschiedlicher Meßparameter, die im Rahmen des erfindungsgemäßen Verfahrens zur Messung von Lötstellen bestimmt werden;
- Fig. 9: ein Ablaufdiagramm eines Ausführungsbeispiels des erfindungsgemäßen Verfahrens;
- Fig. 10: eine im Rahmen einer Ausführungsform des erfindungsgemäßen Verfahrens gebildete Bildschirmanzeige eines Einzelfehlers;
- Fig. 11: eine im Rahmen einer Ausführungsform des erfindungsgemäßen Verfahrens gebildete Bildschirmanzeige einer Fehlerliste;
- Fig. 12: eine im Rahmen einer Ausführungsform des erfindungsgemäßen Verfahrens gebildete Bildschirmanzeige eines Röntgenbildes einer Leiterplatte mit Lötstellen, wobei eine fehlerhafte Lötstelle markiert ist;
- Fig. 13: eine im Rahmen einer Ausführungsform des erfindungsgemäßen Verfahrens gebildete Bildschirmanzeige von Fehlern (Häufung von Fehlern an einer oder mehreren Stellen der Leiterplatte) in einer grafischen Darstellung des Leiterplattenlayouts;
- Fig. 14, 15 und 16: im Rahmen einer Ausführungsform des erfindungsgemäßen Verfahrens gebildete Bildschirmanzeigen von Fehlern in statistischer Auswertung;
- Fig. 17 und 18: im Rahmen einer Ausführungsform des erfindungsgemäßen Verfahrens gebildete Bildschirmanzeigen im Zusammenhang mit der Konfiguration von Meßwerten bzw. von Referenzwerten;
- Fig. 19: im Rahmen des erfindungsgemäßen Verfahrens gebildete Bildschirmanzeigen von Meßwerten bzw. Fenstern zur Meßwertauswahl; und
- Fig. 20: den Ablauf eines Zyklus im Zusammenhang mit der Verifizierung fehlerfreier Leiterplatten und der Reparatur fehlerhafter Leiterplatten.

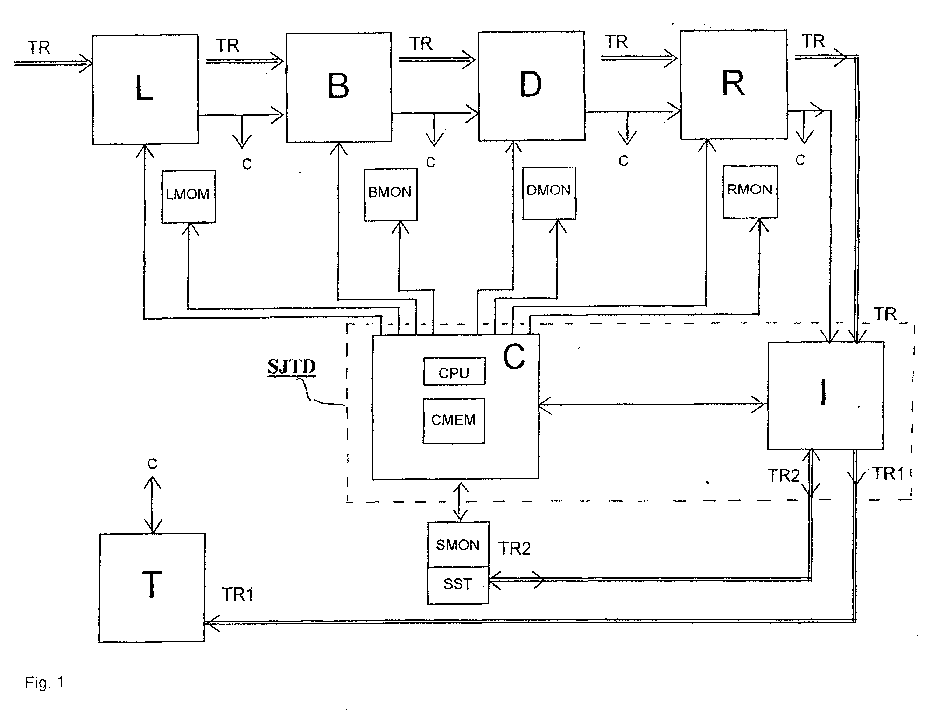

Die in Figur 1 dargestellte Anordnung enthält die erfindungsgemäße Schaltungsanordnung SJTD zur Prüfung von Lötstellen. Die Schaltungsanordnung besteht beispielsweise aus einer Datenverarbeitungseinrichtung C und einer Röntgeninspektionseinrichtung I. Die Datenverarbeitungseinrichtung C und die Röntgeninspektionseinrichtung I dienen der Durchführung des erfindungsgeinäßen Verfahrens zur Prüfung von Lötstellen auf Fehlerfreiheit.

Darüber hinaus können die Datenverarbeitungseinrichtung C und die Röntgeninspektionseinrichtung I auch weitere Meß- und Steuerungsprozeduren zum Beispiel im Zusammenhang mit der Herstellung von Lötstellen durchführen, wie dies anhand von Figur 1 dargestellt ist. Die in Figur 1 dargestellte Anordnung besteht aus einer ersten Einrichtung L, die auf Leiterplattenrohlinge Lötpaste aufträgt, aus einer sogenannten Dispensen-Einrichtung D, aus einer zweiten Einrichtung B, die durch einen Bestückungsautomaten gebildet ist, der die Leiterplatten vorzugsweise in SMD-Technik mit einer oder mehreren Bauelementen bzw. Baugruppen bestückt, aus einer dritten Einrichtung R, die durch eine Reflow-Löteinrichtung gebildet ist, aus der Röntgeninspektionseinrichtung I, aus der Datenverarbeitungseinrichtung C, aus einer Reparaturarbeitsstation SST, die auch für die Verifizierung fehlerfreier Leiterplatten ausgestattet ist (Monitor SMON, der von C generierte Daten anzeigt) und ein nicht dargestelltes Keyboard zur Steuerung der Monitoranzeige bzw. zur Dialogführung mit der Datenverarbeitungseinrichtung C aufweist, sowie aus einer Einrichtung T, die elektrische Baugruppentests durchführt.

Die Einrichtungen L, D, B, R, I und T sind an sich bekannte Einrichtungen. Als Einrichtung L wird beispielsweise ein Produkt der Firma MPM mit der Produktbezeichnung Ultraprint verwendet; als Einrichtung D wird beispielsweise ein Produkt der Firma Cama/lot der 3000-er Serie verwendet; als Einrichtung B wird beispielsweise ein SMD-Bestückungsautomat der Finnen Siemens, Quad, Fuji oder Panasonica MPM verwendet; als Einrichtung R wird beispielsweise ein Ofen der Firma BTU oder ein entsprechendes Produkt der Firma Elektrovert verwendet; als Einrichtung I wird beispielsweise ein Produkt der Firma NICOLET (NIS) mit der Produktbezeichnung CX13000/5000 und MV6000 verwendet, und als Einrichtung T wird beispielsweise ein Produkt der Firma Hewlett Packard mit der Produktbezeichnung HP 3070 verwendet.

Den Einrichtungen L, B, D, R sowie der Reparaturarbeitsstation SST sind Bildschirmmonitore LMON, BMON, DMON, RMON und SMON zugeordnet, die mit der Datenverarbeitungseinrichtung C verbunden sind.

Der Datenverarbeitungseinrichtung C, die die Schaltungsanordnung SJTD bilden kann, ist mindestens ein das erfindungsgemäße Verfahren definierende Steuerungsprogramm zur Prüfung von Lötstellen auf Fehlerfreiheit zugeordnet. Sie ist in Figur 1 schematisch mit ihrem Steuerwerk CPU und mit einem Speicher CMEM dargestellt, der u.a. der Aufnahme der Informationen dient, die im Rahmen des erfindungsgemäßen Verfahrens gebildet werden bzw. auf die zur Bildung dieser Informationen zugegriffen wird.

Zur Herstellung von Lötstellen und zur Steuerung bzw. Regelung des entsprechenden Herstellungsprozesses ist die Datenverarbeitungseinrichtung C mit den Einrichtungen L, D, B, R, I und T verbunden und erhält von diesen Einrichtungen erste Daten, die die in diesen Einrichtungen behandelten Leiterplatten bzw. Lötstellen betreffen, und/oder zweite Daten, die die Einrichtungen selbst betreffen. Die ersten und/oder zweiten Daten können auch von einer Einrichtung (z.B. L) der jeweils nachgeordneten Einrichtung (z.B. B) zugeführt werden. Die Datenverarbeitungseinrichtung C führt den Einrichtungen L, B, D und R Steuer- bzw. Regelinformationen zu, die in Abhängigkeit von lötstellenindividuellen Qualitätsinformationen und/oder den lötstellenindividuellen Meßwertinformationen gebildet werden.

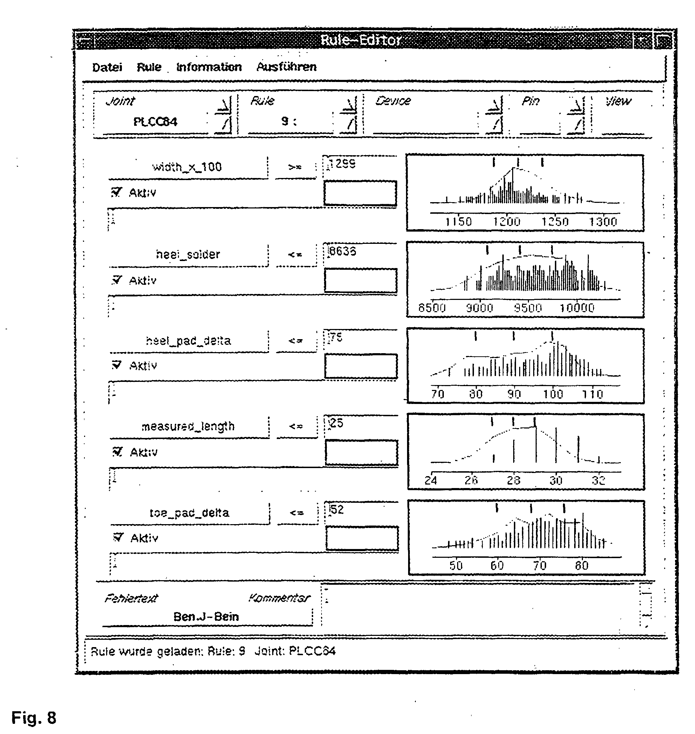

Den Monitoren LMON, BMON, DMON, RMON und SMON führt die Datenverarbeitungseinrichtung C u.a. lötstellenindividuelle Qualitätsinformationen, lötstellenindividuelle Meßwertinformation und gegebenenfalls statistische Informationen über die Häufigkeit des Auftretens von Fehlern zu. Diese Infonnationen werden auf den Monitoren angezeigt. In den Figuren 8, 14 bis 16 und 19 sind derartige Bilschirmanzeigen dargestellt.

Der Transportweg der Leiterplatten ist in Figur 1 mit TR bezeichnet. Vom Ausgang der Röntgeninspektionseinrichtung I führt ein erster Transportweg TR1 zu der Einrichtung T; auf diesem Transportweg werden Leiterplatten transportiert, die von der Röntgeninspektionseinrichtung I bzw. von der Datenverarbeitungseinrichtung C als fehlerfrei erkannt werden. Es kann aber auch vorgesehen sein, daß als fehlerfrei erkannte Leiterplatten der Reparaturstation SST zur Verifizierung der Fehlerfreiheit zugeführt werden.

Weiterhin führt vom Ausgang der Röntgeninspektionseinrichtung I ein zweiter Transportweg TR2 zu der Reparaturarbeitsstation SST; auf diesem Transportweg werden Leiterplatten transportiert, die von der Röntgeninspektionseinrichtung I bzw. von der Datenverarbeitungseinrichtung C als fehlerhaft erkannt werden. Nach der Reparatur können die Leiterplatten auf dem Tranportweg TR2 von der Reparaturarbeitsstation SST zu der Röntgeninspektionseinrichtung I zurücktransportiert werden, wo sie wiederum einer Inspektion unterzogen werden.

Die Röntgeninspektionseinrichtung I kann in an sich bekannter Weise lötstellenindividuelle Informationen bilden, wobei für jede Lötstelle entweder die Information "Lötstelle fehlerfrei" oder die Information "Lötstelle fehlerhaft" gebildet wird. Alternativ hierzu ist vorgesehen, daß die Röntgeninspektionseinrichtung I, die von der Datenverarbeitungseinrichtung C gesteuert wird, Referenzlötstellen und weitere Lötstellen entsprechend dem erfindungsgemäßen Verfahren mißt, wobei die Datenverarbeitungseinrichtung C gebildete Meßwerte ("Meßparameterwerte") bewertet.

Mit dem erfindungsgemäßen Verfahren werden Lötstellen (SJG, SJB in Figuren 2 bis 6) auf Fehlerfreiheit mittels Röntgenstrahlung geprüft, wobei die Lötstellen auf einem Substrat, vorzugsweise auf einer Leiterplatte (BOARD, Figuren 2 bis 6) angeordnet sein können.

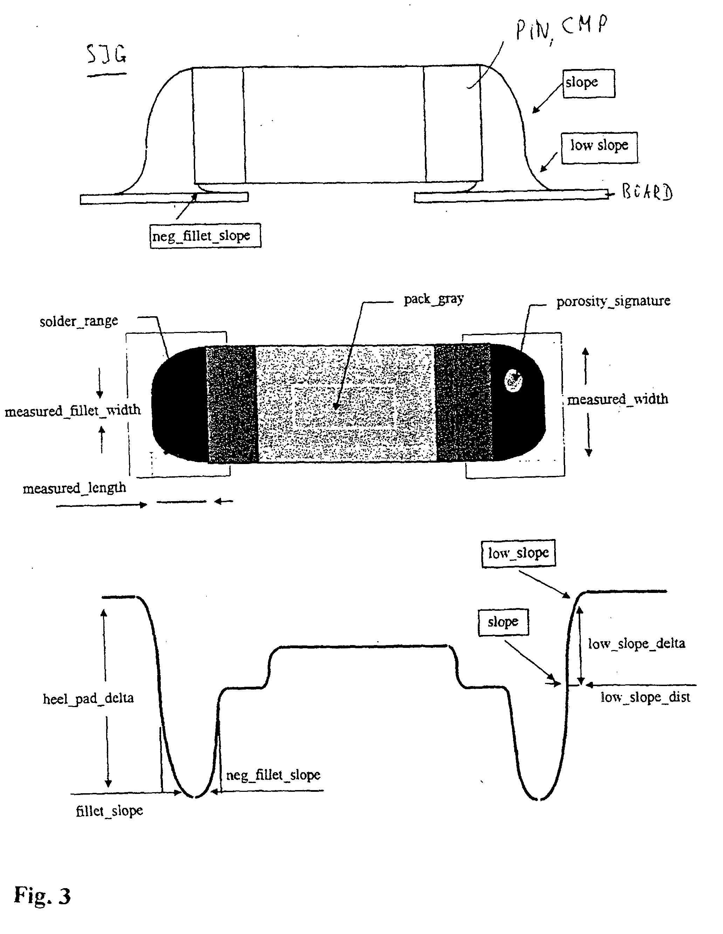

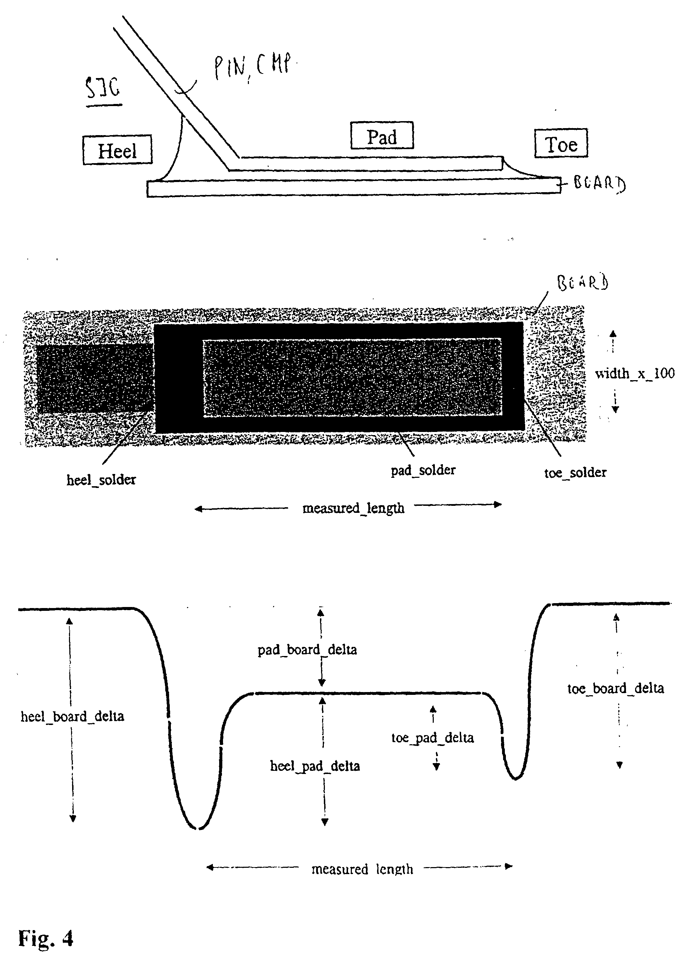

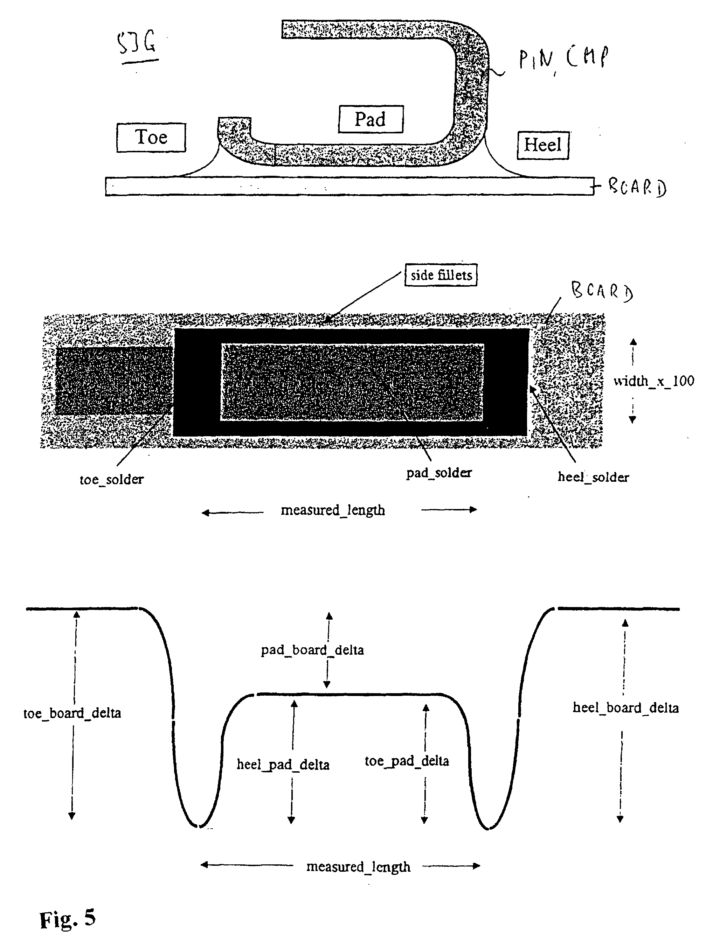

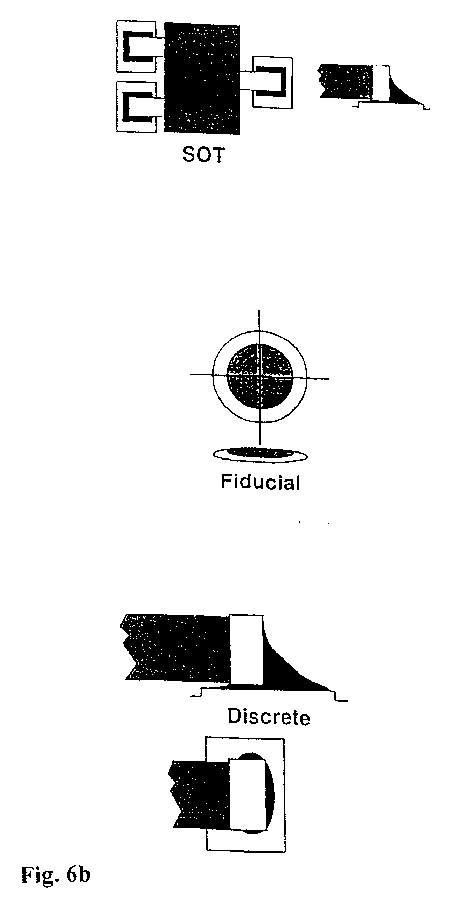

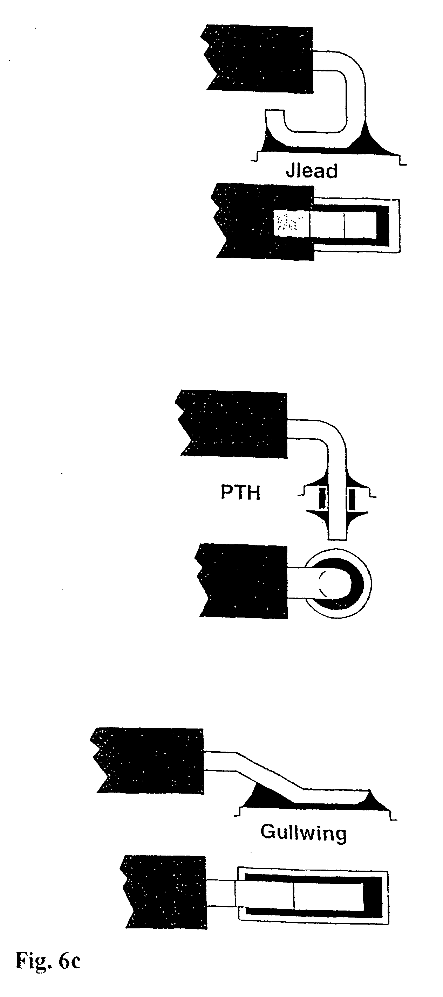

Wie in den Figuren 2 bis 6 dargestellt ist, weist eine fehlerfreie Lötstelle SJG Lötmaterial SM auf, wobei das Lötmaterial SM einer fehlerfreien Lötstelle galvanisch mit einem Kontaktelement PIN eines Bauelements CMP (z.B. Figur 3: diskretes Bauelement wie Kondensator, Widerstand; Integrierte Schaltung IC) verbunden ist. Die Lötstellen sind in Abhängigkeit von der Form des Kontaktelements PIN im Bereich der Lötstelle SJ einem vorgebbaren Lötstellentyp zugeordnet. Beispielsweise ist die in Figur 2 dargestellte Lötstelle eine sogenannte SOT("Small Outline Transistor")-Lötstelle; die in Figur 3 dargestellte Lötstelle ist eine Lötstelle für diskrete Bauelemente, die in Figur 4 dargestellte Lötstelle ist eine Gullwing Pin-Lötstelle; und die in Figur 5 dargestellte Lötstelle ist eine Lötstelle für j-förmige Kontaktelemente PIN (J-Lead PIN-Lötstelle, z.B. Small Outline J-lead SOJ). Im Rahmen des erfindungsgemäßen Verfahrens können Lötstellen aller Lötstellentypen geprüft werden. Beispiele hierfür sind in den Figuren 6b und 6c dargestellt, die noch beschrieben werden.

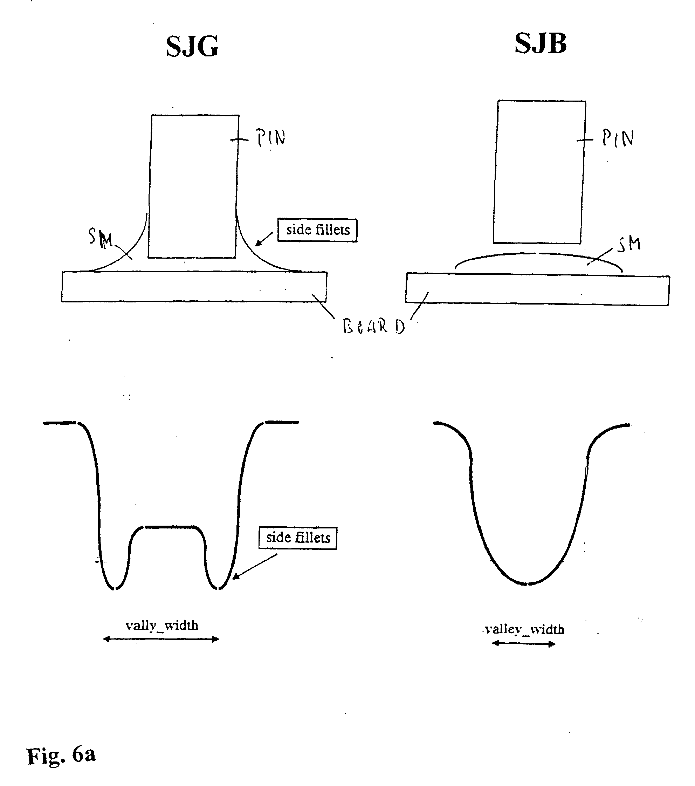

Figur 6a zeigt eine Gegenüberstellung einer fehlerfreien Lötstelle SJG und einer fehlerhaften Lötstelle SJB. Im oberen Teil der Figur 6a ist jeweils ein Schnitt der jeweiligen Lötstelle dargestellt, während im unteren Teil der Figur 6a jeweils der Verlauf eines von der Röntgeninspektionseinrichtung I gebildeten Ausgangssignals dargestellt ist. Bei der fehlerfreien Lötstelle SJG (links in Figur 6a) bildet das Lötmaterial SM sogenannte side fillets (seitliche Menisken bzw. Teile des Lötmaterials, die mit dem Kontaktelement PIN verbunden sind); Lötmaterial SM und Kontaktelement PIN sind galvanisch miteinander verbunden und haben eine gemeinsame Kontaktfläche CTA. Demgegenüber bildet bei der fehlerhaften Lötstelle SJB (rechts in Figur 6a) das Lötmaterial SM keine side fillets; Lötmaterial SM und Kontaktelemente PIN sind galvanisch nicht miteinander verbunden und haben keine gemeinsame Kontaktfläche CTA.

Weitere Ausgestaltungen fehlerfreier Lötstellen SJG unterschiedlichen Lötstellentyps sind in den Figuren 2 bis 5 sowie in den Figuren 6b und 6c dargestellt. In den Figuren 2 bis 5 ist im oberen Teil jeweils ein Schnitt der jeweiligen Lötstelle dargestellt, im mittleren Teil der Figuren 2 bis 5 ist jeweils ein Röntgenbild der betreffenden Lötstelle dargestellt, während im unteren Teil der Figuren 2 bis 5 jeweils der Verlauf eines von der Röntgeninspektionseinrichtung I gebildeten Ausgangssignals dargestellt ist. Figur 6b zeigt jeweils eine Draufsicht und einen Schnitt durch eine SOT ("Small Outline Transistor")-Lötstelle, eine sogenannte Fiducial(Markierungspunkt)-Lötstelle und eine Lötstelle zur Kontaktierung diskreter Bauelemente; Figur 6c zeigt jeweils eine Draufsicht und einen Schnitt durch eine Jlead-Lötstelle, eine sogenannte PTH (Plated Through-hole; Lötstelle an einer durchgehenden Öffnung einer Leiterplatte) und eine Gullwing-Lötstelle.

In den Figuren 2 bis 5 bezeichnen die Bezugszeichen bzw. die Begriffe folgendes:
heel = Lötstellenferse; pad = Lötstellenlandefläche (auf der Leiterplatte); toe = Lötstellenzehe; BOARD = Substrat bzw. Leiterplatte; heel solder = Lotmenge am "heel"; pad solder = Lotmenge an der Lötstellenlandefläche (hier spezifisch mittlerer Bereich der Lötstelle); toe solder = Lotmenge am "toe", measured length = gemessene Länge der gelöteten Fläche; measured width = gemessene Breite der gelöteten Fläche; slope = Anstieg beim Lötmeniskus (der Grauwertkurve).

Weitere Bezugszeichen bzw. Begriffe in den Figuren 2 bis 5 sind in den Tabellen am Ende der Beschreibung angegeben.

Das erfindungsgemäße Verfahren, mit dem Regeln für die Auswahl von Meßparametern gebildet werden, weist folgende Schritte auf:

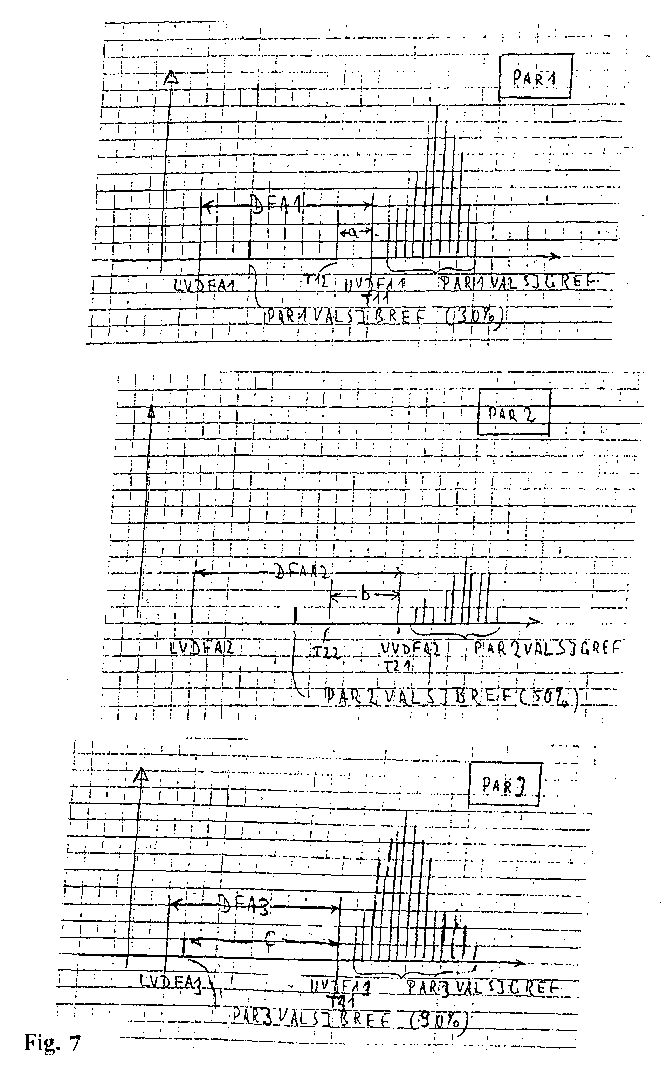

Vor der Prüfung der Lötstelle SJ wird für eine erste Mehrzahl m von Meßparametern (PARi, i = 1...m, in Figur 7: PAR1, PAR2, PAR3), insbesondere Grauwertmeßparametern, jeweils ein unterer Bereichsgrenzwert LVDFAi (Figur 7) und/oder ein oberer Bereichsgrenzwert UVDFAi eines meßparameterindividuellen Fehleristwertbereichs DFAi bestimmt, wobei dem unteren Bereichsgrenzwert LVDFAi ein vergleichsweise großer Fehler der Lötstelle SJ oder ein vergleichsweise kleiner Fehler der Lötstelle SJ entspricht, je nachdem, ob wie in Figur 7 oder in Figur 8, 2 bis 5. Darstellung der Fehleristwertbereich DFAi links oder wie in Figur 8, 1. (oberste) Darstellung rechts von dem zulässigen Bereich (Bereich von Meßparameterwerten fehlerfreier referenzlötstellen)) liegt, wie noch beschreiben wird.

Dem oberen Bereichsgrenzwert UVDFAi entspricht ein vergleichsweise kleiner Fehler der Lötstelle SJ (Figur 7 oder Figur 8, 2 bis 5. Darstellung) oder ein vergleichsweise großer Fehler der Lötstelle SJ (Figur 8, 1. Darstellung) Die Meßparameter PARi beschreiben jeweils die Topographie (geometrische Abmessungen) einer zweiten Mehrzahl n von fehlerfreien Referenzlötstellen (SJGREFj, j = 1...n) und/oder die Innenstruktur der n fehlerfreien Referenzlötstellen (SJGREFj) (z.B. Lufteinschlüsse, Risse), so daß m untere Bereichsgrenzwerte LVDFAi und/oder m obere Bereichsgrenzwerte UVDFAi meßparameterindividueller Fehleristwertbereiche DFAi bestimmt werden.

Weiterhin wird vor der Prüfung der Lötstelle SJ von mindestens einer typgleichen fehlerhaften Referenzlötstelle SJBREF für die erste Mehrzahl m der Meßparameter PARi jeweils ein referenzlötstellenindividueller Meßparameterwert PARiVALSJBREF, insbesondere ein Grauwertmeßparameterwert, ermittelt, so daß mindestens m referenzlötstellenindividuelle Meßparameterwerte PARiVALSJBREF für die m Meßparameter PARi der mindestens einen typgleichen fehlerhaften Referenzlötstelle SJBREF ermittelt werden.

Schließlich wird vor der Prüfung der Lötstelle SJ für die m referenzlötstellenindividuellen Meßparameterwerte PARiVALSJBREF der typgleichen fehlerhaften Referenzlötstellen SJBREF jeweils deren mathematische Zuordnung, insbesondere deren Differenz oder Verhältnis, zu dem unteren Bereichsgrenzwert LVDFAi und/oder zu dem oberen Bereichsgrenzwert UVDFAi des meßparameterindividuellen Fehleristwertbereichs DFAi ermittelt.

Bei der eigentlichen Prüfung der Lötstelle SJ wird ein Meßparameterwert PAR1VALSJ, insbesondere ein Grauwertmeßparameterwert, mindestens eines ersten Meßparameters PAR1 ermittelt, für den der referenzlötstellenindividuelle Meßparameterwert PAR1VALSJBREF der mindestens einen fehlerhaften Referenzlötstelle SJBREF zu dem unteren Bereichsgrenzwert LVDFA1 des meßparameterindividuellen Fehleristwertbereichs DFA1 im Vergleich zu anderen meßparameterindividuellen Fehleristwertbereichen (DFA2, ..., DFAm) am nächsten (Figur 7 oder Figur 8, 2.bis 5. Darstellung) oder am weitesten (Figur 8, oberste Darstellung) angeordnet ist und/oder für den der referenzlötstellenindividuelle Meßparameterwert PAR1VALSJBREF der mindestens einen fehlerhaften Referenzlötstelle SJBREF von dem oberen Bereichsgrenzwert UVDFA1 des meßparameterindividuellen Fehleristwertbereichs DFA1 im Vergleich zu anderen meßparameterindividuellen Fehleristwertbereichen (DFA2, ...,DFAm) am weitesten (Figur 7 oder Figur 8, 2.bis 5. Darstellung) oder am nächsten (Figur 8, oberste Darstellung) angeordnet ist. Es wird also der vorstehend genannte Meßparameter PAR1(in Figur7: "PAR3") für die Prüfung der Lötstelle SJ bzw. für die Detektierung/Ausfilterung eines speziellen Fehlertyps ausgewählt, wie noch anhand der Figuren 7 und 8 beschrieben wird.

Bei der folgenden Beschreibung wird davon ausgegangen, daß der Fehleristwertbereich so wie in Figur 7 und in Figur 8, oberste Darstellung "rechts" von dem zulässigen Bereich mit den Meßparameterwerten fehlerfreier Referenzlötstellen liegt. Die Erfindung bezieht sich aber auch auf Ausführungsformen, bei denen der Fehleristwertbereich so wie in Figur 8, 2. bis 5. Darstellung "Links" von dem zulässigen Bereich mit den Meßparameterwerten fehlerfreier Referenzlötstellen liegt.

Bei der Prüfung der Lötstelle SJ kann mindestens ein zweiter Meßparameterwert PAR2VALSJ eines zweiten Meßparameters PAR2 ermittelt werden. Vorzugsweise werden Meßparameterwerte mehrerer Meßparameter (z.B. fünf) ermittelt, um die Wahrscheinlichkeit für korrekte Informationen "Lötstelle fehlerfrei" bzw. "Lötstelle fehlerhaft" zu erhöhen.

Für den vorstehend genannten zweiten Meßparameter PAR2 (Figur 7) ist der referenzlötstellenindividuelle Meßparameterwert PAR2VALSJBREF der mindestens einen fehlerhaften Referenzlötstelle SJBREF zu dem unteren Bereichsgrenzwert LVDFA2 des meßparameterindividuellen Fehleristwertbereichs DFA2 im Vergleich zu anderen meßparameterindividuellen Fehleristwertbereichen (DFA3, ..., DFAm) am zweitnächsten (Figur 7 oder Figur 8, 2. bis 5. Darstellung) angeordnet. Zusätzlich oder alternativ hierzu kann für diesen zweiten Meßparameter PAR2 der referenzlötstellenindividuelle Meßparameterwert PAR2VALSJBREF der mindestens einen fehlerhaften Referenzlötstelle SJBREF von dem oberen Bereichsgrenzwert UVDFA2 des meßparameterindividuellen Fehleristwertbereichs DFA2 im Vergleich zu anderen meßparameterindividuellen Fehleristwertbereichen (DFA3, ..., DFAm) am zweitweitesten angeordnet sein. Es wird also der vorstehend genannte Meßparameter PAR2. für die Prüfung der Lötstelle SJ ausgewählt, wie noch anhand der Figuren 7 und 8 beschrieben wird.

Es kann vorgesehen sein, daß bei der Prüfung der Lötstelle SJ weitere Meßparameterwerte weiterer Meßparameter ermittelt werden. Beispielsweise werden bei der Prüfung der Lötstelle SJ Meßparameterwerte von fünf Meßparametern ermittelt.

Anstelle nur einer typgleichen fehlerhaften Referenzlötstelle (in Figur 7: PAR1VALSJBREF bzw. PAR2VALSJBREF) kann in dem vorgenannten Verfahrensschritt vor der Prüfung der Lötstelle SJ von einer dritten Mehrzahl o typgleicher fehlerhafter Referenzlötstellen (SJBREFp, p = 1...o) referenzlötstellenindividuelle Meßparameterwerte PARoVALSJBREF der ersten Mehrzahl m der Meßparameter PARi ermittelt werden. Bei diesem Ausführungsbeispiel des erfindungsgemäßen Verfahrens werden vor der Prüfung der Lötstelle SJ aus den jeweils o referenzlötstellenindividuellen Meßparameterwerten PARoVALSJBREF eines jeden Meßparameters PARi mindestens ein Meßparameterwert PARiVALAVESJBREF der fehlerhaften Referenzlötstellen SJBREF nach einem vorgebbaren Algorithmus AL1 abgeleitet.
Vor der Prüfung der Lötstelle SJ wird dann anstelle der mathematischen Zuordnung der referenzlötstellenindividuellen Meßparameterwerte PARiVALSJBREF der typgleichen fehlerhaften Referenzlötstellen SJBREF zu dem unteren Bereichsgrenzwert LVDFAi und/oder dem oberen Bereichsgrenzwert UVDFAi des jeweiligen meßparameterindividuellen Fehleristwertbereichs DFAi die mathematische Zuordnung der abgeleiteten Meßparameterwerte PARiVALAVESJBREF, insbesondere deren Differenz oder Verhältnis, zu dem unteren Bereichsgrenzwert LVDFAi und/oder zu dem oberen Bereichsgrenzwert UVDFAi des jeweiligen meßparameterindividuellen Fehleristwertbereichs DFAi bestimmt.

Bei diesem Ausführungsbeispiel des erfindungsgemäßen Verfahrens kann bei der Prüfung der Lötstelle SJ anstelle des Meßparameterwerts PAR1VALSJ ein weiterer Meßparameterwert PARi'VALSJ mindestens eines weiteren ersten Meßparameters PARi' ermittelt werden, für den der abgeleitete Meßparameterwert PARiVALAVESJBREF der dritten Mehrzahl o der fehlerhaften Referenzlötstellen zu dem unteren Bereichsgrenzwert LVDFAi des Fehleristwertbereichs DFAi im Vergleich zu anderen meßparameterindividuellen Fehleristwertbereichen (DFA3, ...DFAm) am nächsten angeordnet ist und/oder für den der abgeleitete Meßparameterwert PARiVALAVESJBREF der dritten Mehrzahl o der fehlerhaften Referenzlötstellen zu dem oberen Bereichsgrenzwert UVDFAi des Fehleristwertbereichs DFAi im Vergleich zu anderen meßparameterindividuellen Fehleristwertbereichen (DFA3, ..., DFAm) am weitesten angeordnet ist.

Der zuvor genannte vorgebbare Algorithmus ist insbesondere ein Algorithmus, mit dem der arithmetische Mittelwert gebildet wird. Hierauf ist die Erfindung jedoch nicht eingeschränkt.

Der untere Bereichsgrenzwert LVDFAi oder der obere Bereichsgrenzwert (Figur 8, oberste Darstellung) des meßparameterindividuellen Fehleristwertbereichs (DFAi) wird in Abhängigkeit eines Meßparameterwerts, bei dem die fehlerhafte Lötstelle eine unzureichende Kontaktfläche zwischen Lötmaterial und Kontaktelement (PIN) aufweist, bestimmt, insbesondere in Abhängigkeit des physikalischen Grenzwerts.

Der obere Bereichsgrenzwert UVDFAi des meßparameterindividuellen Fehleristwertbereichs DFAi oder der untere Bereichsgrenzwert LVDFAi (Figur 8, oberste Darstellung) wird vorzugsweise in Abhängigkeit der Verteilungsfunktion der fehlerfreien Referenzlötstellen SJGREF bestimmt.

Die Verteilungsfunktion der fehlerfreien Referenzlötstellen ist insbesondere eine Normalverteilung. In diesem Fall wird der obere Bereichsgrenzwert UVDFAi des meßparameterindividuellen Fehleristwertbereichs DFAi vorzugsweise in Abhängigkeit der Standardabweichung (σ) bestimmt.

Der obere Bereichsgrenzwert UVDFAi des meßparameterindividuellen Fehleristwertbereichs DFAi (Figur 7 und Figur 8, 2.bis 5. Darstellung) wird insbesondere auf einen Wert festgesetzt, der geringfügig kleiner als der Meßparameterwert einer noch fehlerfreien Referenzlötstelle SFGREF ist.

Die Lötstelle SJ wird bei der Prüfung als fehlerfrei bewertet, sofern der Meßparameterwert mindestens gleich groß wie ein vorgebbarer erster meßparameterindividueller Schwellwert Ti1(in Figur 7: T11, T21, T31) ist.

Insbesondere ist der erste meßparameterindividuelle Schwellwert Ti1 gleich groß wie der obere Bereichsgrenzwert UVDFAi des meßparameterindividuellen Fehleristwertbereichs DFAi.

Es kann auch vorgesehen sein, daß die Lötstelle SJ bei der Prüfung als fehlerfrei bewertet wird, sofern der Meßparameterwert mindestens gleich groß wie ein vorgebbarer zweiter meßparameterindividueller Schwellwert Ti2 (in Figur 7: T12, T22, T32) ist, der um eine meßparameterindividuelle Schwellwertabweichung ia (in Figur 7: a, b, c) kleiner bzw. größer als der erste meßparameterindividuelle Schwellwert Ti1 ist.

Die Größe einer zulässigen meßparameterindividuellen Schwellwertabweichung a eines ersten Meßparameters und/oder die Größen weiterer zulässiger meßparameterindiviueller Schwellwertabweichungen (b, c) weiterer Meßparameter werden in Abhängigkeit eines vorgebbaren Bezugswerts CTAREF einer Kontaktfläche CTA bestimmt, die zwischen Lötmaterial SM und Kontaktelement PIN einer zu prüfenden Lötstelle SJ gebildet ist.

Die Größe einer zulässigen meßparameterindividuellen Schwellwertabweichung (a) eines ersten Meßparameters und/oder die Größen weiterer zulässiger meßparameterindiviueller Schwellwertabweichungen (b, c) weiterer Meßparameter können auch in Abhängigkeit eines vorgebbaren Bezugswerts (CTAREF) einer mathematischen Verknüpfung der Schwellwertabweichungen (a, b, c), insbesondere einer Produktbildung, einer Mittelwertbildung und/oder einer Summenbildung der Schwellwertabweichungen bestimmt werden.

Weiterhin können die Schwellwertabweichungen auch in Abhängigkeit von einem vorgebbaren Qualitätsgrad der Kontaktfläche zwischen Lötmaterial und Kontaktelement festgesetzt werden. Beispielsweise wird für Produkte mit hohen Sicherheitsanforderungen der Qualitätsgrad relativ hoch angesetzt, während z.B. für Produkte der Unterhaltungselektronik der Qualitätsgrad relativ niedrig angesetzt wird.

In Abhängigkeit von Meßparameterwerten erster Meßparameter wird eine Information gebildet, die eine Wahrscheinlichkeit (insbesondere größer 50%) für die Existenz eines galvanischen Kontakts zwischen Lötmaterial SM und Kontaktelement PIN bezeichnet, und mittels Meßparameterwerte zweiter Meßparameter wird die Größe der Kontaktfläche CTA hinreichend genau bestimmt.

Beispiele für die vorstehend genannten ersten Meßparameter sind insbesondere die Meßparameter, die einen Meniskus einer Lötstelle und/oder seitlich am Kontaktelement PIN angeordnetes Lötmaterial (side fillets) SM bezeichnen.

Die Größe der Kontaktfläche CTA wird mittels zweiter Meßparameter bzw. mittels einer Information bestimmt, die eine Längenausdehnung ml der Lötstelle SJ, SJREF und/oder eine Breitenausdehnung b der Lötstelle SJ und/oder eine Talbreite v eines Querschnitts der Lötstelle SJ und/oder eine erste Höhendifferenz hpd zwischen einem Scheitelpunkt heel und einem Talpunkt pad der Lötstelle und/oder eine zweite Höhendifferenz phd zwischen dem Talpunkt pad der Lötstelle SJ und dem Substrat BOARD und/oder ein Gefälle neg in einem Randbereich der Lötstelle SJ und/oder einen Anstieg s1 in einem Randbereich der Lötstelle SJ und/oder eine Materialmenge d in einem vorgebbaren Bereich der Lötstelle SJ bezeichnet.
Weitere Meßparameter sind am Ende des Beschreibungsteil angegeben.

Vor der Prüfung der Lötstelle SJ durchzuführende Verfahrensschritte können zeitlich versetzt durchgeführt werden. Insbesondere können Meßparameterwerte der Datenverarbeitungseinrichtung C (Figur 1) von einem externen Speicher zur Verfügung gestellt werden. In diesem Fall hat die erfindungsgemäße Schaltungsanordnung keine Einrichtung I aufzuweisen.

Als Ergebnis der Prüfung wird entweder eine erste Information INFSJG gebildet wird, die die Fehlerfreiheit einer geprüften, fehlerfreien Lötstelle SJ bezeichnet, und oder es wird eine zweite Information INFSJB gebildet, die ein Nichtvorliegen von Fehlerfreiheit einer geprüften, fehlerhaften Lötstelle SJ bezeichnet. Die erste Information INFSJG und/oder die zweite Information INFSJB wird insbesondere zur Steuerung eines Prozesses zur Herstellung von Lötstellen verwendet.

Allgemein gilt für das erfindungsgemäße Verfahren , daß lötstellenindividuellen Qualitätsinformationen und/oder lötstellenindividuellen Meßwertinformationen, die gemessene physikalische Meßparameter überprüfter Lötstellen bezeichnen, mit Grauwertmeßparametern von Röntgenbildern von Referenzlötstellen korreliert werden und daß basierend auf der Korrelation Kriterien für die Bildung von Regeln für die Messung der zu prüfenden Lötstellen generiert werden.

Allgemein gilt für die erfindungsgemäße Schaltungsanordnung, daß diese ein Steuerwerk CPU (Figur 1) aufweist, dem ein das erfindungsgemäße Verfahren definierendes Steuerungsprogramm zugeordnet ist, wobei das erfindungsgemäße Verfahren so wie beschrieben und beansprucht (Schaltungsanordnungsansprüche 17 bis 33) ausgestaltet ist.

In Figur 7 sind jeweils für einen Meßparameter PAR1, PAR2 und PAR3 (rechts) auf der x-Achse Meßparameterwerte PARiVALSJGREF von fehlerfreien Referenzlötstellen angegeben, die typengleich zu einer bzw. mehreren später zu prüfenden Lötstellen SJ sind.

Auf der y-Achse ist die jeweilige Anzahl der entsprechenden Meßparameterwerte angegeben.

Auf der x-Achse ist - links von den Meßparameterwerten PARiVALSJGREF der fehlerfreien Referenzlötstellen - weiterhin jeweils ein Fehleristwertbereich DFAi angegeben, der einen oberen Bereichsgrenzwert UVDFAi und einen unteren Bereichsgrenzwert LVDFAi hat. Der obere Bereichsgrenzwert UVDFAi ist zugleich einem ersten Schwellwert Ti1, mit dem der Meßparameterwert PARVALSJ der zu prüfenden Lötstelle SJ verglichen wird.

Von dem ersten Schwellwert Ti1 ist ein zweiter Schwellwert Ti2 (um eine Schwellwertabweichung a, b bzw. d) beabstandet angeordnet, mit dem in einer bevorzugten Ausführungsform des erfindungsgemäßen Verfahrens der Meßparameterwert PARVALSJ der zu prüfenden Lötstelle SJ verglichen wird.

In Figur 7 ist im jeweiligen Fehleristwertbereich DFA der Meßparameterwert einer fehlerhaften Referenzlötstelle SJBREF angeordnet. Ordnet man dem Fehleristwertbereich 100%, so läßt sich die Anordnung des Meßparameterwerts der fehlerhaften Referenzlötstelle SJBREF in % ausdrücken, wobei die 100 % dem oberen Bereichsgrenzwert UVDFA oder dem unteren Bereichsgrenzwert LVDFA zugeordnet sind. In Figur 7a gilt für PAR1VALSJBREF 30%, für PAR2VALSJBREF 50%, und für PAR1VALSJBREF 10% bezogen auf den unteren Bereichsgrenzwert. Entsprechend gilt für PAR1VALSJBREF 70%, für PAR2VALSJBREF 50%, und für PAR1VALSJBREF 90% bezogen auf den oberen Bereichsgrenzwert.

Da PAR3VALSJBREF (= 70%) > PAR2VALSJBREF (=50%) > PAR1VALSJBREF (= 10%), bezogen auf den unteren Bereichsgrenzwert LVDFA, ist, wird mindestens der Meßparameter PAR3 für die Prüfung der Lötstelle SJ bzw. für die Detektierung/Ausfilterung eines speziellen Lötstellenfehlertyps verwendet; gegebenenfalls wird auch der Meßparameter PAR2 verwendet

Geht man davon aus, daß aus z.B. 7 Meßparametern PAR1, ..., PAR7, denen Meßparameterwerte PAR1ALSJBREF, ..., PAR7VALSJBREF zugeordnet sind, 5 Meßparameter ausgewählt werden, wobei PAR7ALSJBREF > PAR1VALSJBREF > PAR2VALSJBREF > PAR3VALSJBREF = PAR5VALSJBREF > PAR6VALSJBREF > PAR4VALSJBREF f gilt, so werden die Meßparameter PAR7, PAR1, PAR2, PAR3, und PAR5 für die Prüfung der Lötstelle SJ bzw. für die Detektierung/Ausfilterung eines speziellen Fehlers verwendet.

In Figur 8 ist ein Rule-Editor der erfindungsgemäßen Schaltungsanordnung SJTD mit 5 Fenster dargestellt, die jeweils Meßparameterwerte fehlerfreier Referenzlötstellen jeweils eines Meßparameters und ein Fehleristwertbereich zeigen. Der Fehleristwertbereich ist als graue Fläche in den Fenstern dargestellt. In dem obersten Fenster befindet sich der Fehleristwertbereich rechts neben den Meßparameterwerte fehlerfreier Referenzlötstellen, während sich in den darunter angeordneten Fenstern der jeweilige Fehleristwertbereich links neben den Meßparameterwerte fehlerfreier Referenzlötstellen befindet.

In dem obersten Fenster sind Meßparameterwerte des Meßparameters "Breite der gelöteten Fläche" (width) dargestellt und in den weiteren Fenstern sind Meßparameterwerte der Meßparameter "heel solder", "heel pad delta" (Höhenunterschied zwischen Meniskus und Leiterplattenfläche), "measured length" (gemessene Länge der gelöteten Fläche) und "toe pad delta" (Höhenunterschied zwischen Lötstellenzehe und Leiterplattenfläche) dargestellt. Die Hüllkurve zeigt die Meßwertverteilung z.B. über mehrere Leiterplatten an. Die oben drei vertikalen Striche bezeichnen den Mittelwert und die +/- Standardabweichung.

Wie schon beschrieben, mißt die Einrichtung I physikalische Parameter (Meßparameter PAR in Figuren 7 und 8; Tabellen am Ende des Beschreibungsteils) der Lötstellen, wie beispielsweise die Topographie (geometrische Abmessungen) und/oder die Innenstruktur (z.B. Lufteinschlüsse, Risse) von Lötstellen bzw. das Lotvolumen, und bildet entsprechende Meßwertinformationen (z.B. Meßparameterwerte PAR1VALSJGREF fehlerfreier Referenzlötstellen SJGREF, Meßparameterwerte PAR1VALSJBREF fehlerhafter Referenzlötstellen SJBREF, Meßparameterwerte PAR1VALSJ von Lötstellen SJ in Figur 7). Zu jeder Lötstelle, insbesondere zu jeder Referenzlötstelle, können, wie noch beschrieben wird, eine Mehrzahl von Meßwertinformationen gebildet werden.

Die Einrichtung I verfügt hierzu über die entsprechende datenverarbeitende Funktionalität; alternativ hierzu wird die entsprechende Datenverarbeitung von der Einrichtung C durchgeführt.

Insgesamt stellt die in Figur 1 dargestellte Anordnung eine Regelanordnung dar, mit der Leiterplatten im Hinblick auf ihre Bestückung mit elektronischen Bauelementen vorbehandelt , bestückt, gelötet und auf ihre Qualität überprüft werden.

Die lötstellenindividuellen Qualitätsinformationen und/oder lötstellenindividuellen Meßwertinfonnationen, die gemessene physikalische Parameter überprüfter Lötstellen bezeichnen, werden zur Reparatur überprüfter fehlerhafter Lötstellen, zur Verifizierung überprüfter Lötstellen und/oder zur Steuerung der Herstellung weiterer Lötstellen on-line, also in dem laufenden Produktionsprozeß verwendet, in welchem die Lötstellen geprüft werden.

Beispielsweise werden das Lotvolumen der Lötstellen und/oder die Höhe mindestens eines Meniskus der Lötstellen und/oder Abmessungen der Kontaktfläche der Lötstellen auf der Leiterplatte gemessen und aus diesen Meßwerten werden die Meßwertinformationen gebildet.

In diesem Zusammenhang ist weiterhin vorgesehen, daß anhand der lötstellenindividuellen Qualitätsinformationen und/oder anhand der lötstellenindividuellen Meßwertinformationen für fehlerhafte Lötstellen geprüft wird, was für ein Fehler vorliegt. Diese Prüfung kann mittels an sich bekannter Algorithmen erfolgen, die beispielsweise in der EP 0 236 001 B1 beschrieben sind. Zu diesen Fehlertypen gehören z.B. "Kaltlötstelle" und "falsche Positionierung einer Lötstelle".

Die Einrichtung I bildet sogenannte Tagfiles, d.h. Dateien, in der Fehlermeldungen für eine Leiterplatte (Board) enthalten sind.

Das dem Steuerwerk CPU der Datenverarbeitungseinrichtung C zugeordnete Steuerungsprogramm ordnet die erkannten Fehler jeweils einem Fehlertyp bzw. einer Fehlerklasse zu. Beispielsweise sind die Fehlerklassen "Lötpastenfehler", "Bestückungsfehler" und "Lötfehler" vorgesehen.

Beispielsweise sind die Fehler "Lotmangel" und "Lotüberschuß" Fehler der Fehlerklasse "Lötpastenfehler"; der Fehler "Versatz eines bestückten Bauteils" ist ein Fehler der Fehlerklasse "Bestückungsfehler"; und "Benetzungsfehler" (Lot verschmilzt nicht ordnungsgemäß mit Pin) ist ein Fehler der Fehlerklasse "Lötfehler".

Eine fehlerharte Lötstelle kann mehrere Fehler aufweisen, so daß einer solchen Lötstelle mehrere Fehlertypen bzw. Fehlerklassen zugeordnet werden.

In Abhängigkeit von der jeweiligen Fehlerklasse (Lötpastenfehler, Bestückungsfehler, Lötfehler) führt die Datenverarbeitungseinrichtung C der Einrichtung L, B oder R eine Steuerinformation zu. Hat die Datenverarbeitungseinrichtung C z.B. einen Fehler der Fehlerklasse "Lötpastenfehler" erkannt, steuert sie die Einrichtung L an. Hat die Datenverarbeitungseinrichtung C z.B. einen Fehler der Fehlerklasse "Lötpastenfehler" und zusätzlich einen Fehler der Fehlerklasse "Bestückungsfehler" erkannt, steuert sie die Einrichtung L und die Einrichtung B an. Die Steuerinformation kann beispielsweise aus einem Fehlerwarnsignal bestehen, das an den Einrichtungen L, B oder R oder an den zugeordneten Monitoren anzeigbar ist, oder aus Daten, die den Betrieb der jeweiligen Einrichtung modifizieren. Beispiele hierfür sind Änderungen der jeweils zugeführten Lötpastenmenge und Änderung der Temperatur des Lötmittels.

Ein Fehler kann mehrere Ursachen haben. Beispielsweise kann der Fehler "Lotmangel" auf einem "Lötpastenfehler" (= Fehler beim Auftragen von Lötpaste) und auf einem "Bestückungsfehler" (= Fehler beim Bestücken, z.B. Bauteil ist in der Weise versetzt, daß nur ein Teil der normalerweise zu benetzenden Fläche (lead) des Bauteils mit ausreichend Lot versorgt wird) beruhen, so daß in diesem Fall dem Fehler "Lotmangel" die beiden Fehlerklassen "Lötpastenfehler" und "Bestükungsfehler" zugeordnet wird.

Die Einrichtung I bildet für vorgebbare Stellen der zu prüfenden Leiterplatte mindestens einen Meßwert, wobei auch vorgesehen sein kann, daß für eine bestimmte Stelle der Leiterplatte eine Mehrzahl von Meßwerten gebildet wird. Die Einrichtung I gibt für jede vorgebbare Lötstelle eine Meßwertinformation bzw. eine Kombination ("Rule") von mehreren Meßwertinformationen an die Datenverarbeitungseinrichtung C.

Das dem Steuerwerk CPU der Datenverarbeitungseinrichtung C zugeordnete Steuerungsprogramm zur Herstellung von Lötstellen mittels der Anordnung nach Figur 1 ist in der Weise ausgestaltet, daß jede Meßwertinformation mit einem Sollwert (FehlerBereichsgrenzwert) bzw. mit einer unteren und oberen Grenze (z.B. T11 in Figur 7) eines zulässigen (bzw. eines unzulässigen) Bereichs verglichen wird. Die Sollwerte (FehlerBereichsgrenzwerte) bzw. die Grenzen zulässiger Bereiche sind vorgebbar oder stehen in einer festen Relation zu einem statistischen Mittelwert, der sich bei einem als gut erkannten Prozeß ergeben hat. Es kann vorgesehen sein, daß die Bereichsgrenzwerte meßwertartspezifisch nur um vorgebbare Bereiche von dem jeweiligen statistischen Mittelwert eines als gut erkannten Prozesses abweichen dürfen.

Besteht eine Meßwertinformationskombination z.B. aus drei Meßwertinformationen, so wird jeder der drei Meßwertinfonnationen mit seinem zugehörigen Sollwert (Fehlerbereichsgrenzwert), der nicht überschritten oder nicht unterschritten werden darf, bzw. mit dem unteren und oberen Bereichsgrenzwert eines zulässigen Bereichs verglichen.

Ergibt sich dabei, daß jede Meßwertinfonnation der Meßwertinformationskombination den zugehörigen Sollwert, der nicht überschritten werden darf, nicht überschreitet, bzw. den zugehörigen Sollwert, der nicht unterschritten werden darf, nicht unterschreitet, bzw. innerhalb der Grenzen des zulässigen Bereichs liegt, so wird die ("erste") lötstellenindividuelle Qualitätsinformation "Lötstelle fehlerfrei" gebildet. Andernfalls wird die ("zweite") lötstellenindividuelle Qualitätsinformation "Lötstelle fehlerhaft" gebildet.

Ist die zweite Qualitätsinformation "Lötstelle fehlerhaft" zu bilden, überschreitet also der Meßwert einen zulässigen oberen Bereichsgrenzwert oder unterschreitet er einen zulässigen unteren Bereichsgrenzwert, wird, sofern zu der betreffenden Lötstelle diejenige Meßwertinformation ermittelt, die von dem jeweiligen zugeordneten Bereichsgrenzwert die größte relative Abweichung aufweist.

Ergibt sich dabei, daß z.B. die zweite Meßwertinformation der Meßwertinformationskombination die relativ größte Abweichung von seinem zugehörigen Sollwert aufweist, wird in Abhängigkeit dieser Meßwertinformation genau eine der Einrichtungen L, B, D oder R angesteuert.

Es kann vorgesehen sein, daß diejenigen zwei Meßwertinformationen einer Meßwertinformationskombination ermittelt werden, die die relativ größten Abweichungen jeweils von ihrem jeweiligen Fehlerbereichsgrenzwert aufweisen. Gilt dies in dem Beispiel der aus drei Meßwertinformationen bestehenden Meßwertinformationskombination für die erste und die zweite Meßwertinformation, so wird in Abhängigkeit dieser beiden Meßwertinformationen (erste und zweite Meßwertinformation) genau die Einrichtung L, B, D oder R angesteuert, die für das Auftreten des betreffenden Fehlers ursächlich ist. Für das Auftreten von Meßwertinformationskombinationen können auch mehrere Einrichtungen L, B, D, R fehlerverursachend sein. In diesem Fall werden die entsprechenden Einrichtungen angesteuert.

Darüber hinaus lassen sich auch drei und mehr Meßwertinformationen einer Meßwertinformationskombination auf diese Weise auswerten, um jeweils diejenigen Einrichtungen L, B, D oder R anzusteuern, die für den jeweiligen Fehler ursächlich sind.

Die Fehlergrenz- bzw. Sollwerte sind vorgebbar und entsprechen vorzugsweise den statistischen Mittelwerten eines als gut erkannten Prozesses; jedoch können die Fehlergrenz- bzw. Sollwerte auch von diesen Mittelwerten abweichen.

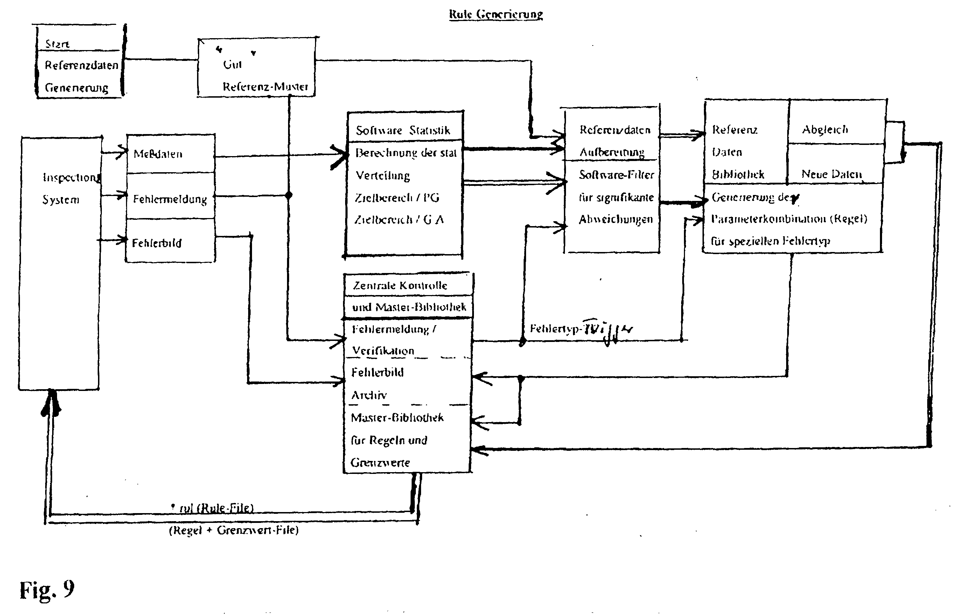

Beträgt z.B. die Breite einer vorgebbaren Lötstelle im statistischen Mittel (im Scheitel der Gauß'schen Verteilung) x Millimeter, so können als Fehlerbereichsgrenzwerte x + a, x - b, 1,1x, etc. vorgesehen werden. Damit können typische Fehlercharakteristika ausgefiltert werden (Figur 9). x kann 20 Millimeter und der vorgebbare untere Fehlerbereichsgrenzwert kann 16 Millimeter (a = 4 Millimeter) betragen. Ein aktueller Meßwert mit 18 Millimeter wird dann als ausreichend bewertet. Die relative Abweichung des aktuellen Meßwerts vom Fehlerbereichsgrenzwert beträgt dann (18-16)/18 x 100 % = + 11,11%.

Zum Beispiel besteht eine Meßwertinformationskombination (Kombination von Meßparameterwerten von fehlerfreien Referenzlötstellen, die demselben Typ angehören, wie eine oder mehrere später zu prüfende Lötstelle SJ) aus folgenden drei Meßwertinformationen (PARiVALSJGREF für i = 1, 2 , 3; vgl. Figur 7):
- Meßwertinformation 1:: measured_width (gemessene Lötstellenbreite) = 22 Millimeter
- Meßwertinformation 2:: heel solder (Lötmenge) entsprechend 6000 normierte Grauwertanteile in einem definierten Prüffenster
- Meßwertinformation 3:: heel pad delta (Lotmeniskushöhe) = 1500 Mikrometer.

Die statistischen Mittelwerte betragen z.B.
bei der Meßwertinformation 1:20 Millimeter
bei der Meßwertinfonnation 2:10000 normierte Grauwertanteile
bei der Meßwertinformation 3:3000 Mikrometer.

Damit ergibt sich für die Meßwertinformation 3 bzw. für den Meßparameter PAR3 die größte relative Abweichung. Der Meßparameter PAR3 wird daher für ein Regel verwendet, nach der Lötstellen SJ zu einem späteren Zeitpunkt geprüft werden.

Weiterhin kann der Meßwertinformation 3 ist eine erste Information zugeordnet sein, die den Fehler "Lötfehler" und "Lötpastenfehler" kennzeichnet. Mit der ersten Information werden die Einrichtungen L und R angesteuert.

Werden bei diesem Beispiel die beiden Meßwertinformationen bzw. Meßparameter PARi mit den größten relativen Abweichungen ermittelt, so sind dies die Meßwertinformation 3 und die Meßwertinformation 2. Dieser Kombination der Meßwertinformationen 3 und 2 ist eine zweite Information zugeordnet, die den Fehler "Lötfehler" kennzeichnet. Mit dieser zweiten Information wird die Einrichtung R angesteuert.

Wertet man alle drei Meßwertinformationen der Kombination aus, wird dieser Kombination eine dritte Information zugeordnet, die ebenfalls den Fehler "Lötfehler" kennzeichnet. Mit der dritten Information wird ebenfalls die Einrichtung R angesteuert.

Die erste, zweite und dritte Information gibt zunächst an, welche der Einrichtungen L, B, D oder R angesteuert wird. Weiterhin gibt die erste, zweite und dritte Information jeweils eine Steuergröße an, d.h. Betriebsparameter bzw. Betriebsparameteränderungen der jeweiligen Einrichtung (z.B. Erhöhung oder Verringerung der aufzutragenden Lötpastenmenge, Erhöhung oder Verringerung des aufzutragenden Lots).

Den drei Fehlerklassen "Bestückungsfehler", "Lötpastenfehler" und "Lötfehler" sind mehrere (z.B. die folgenden) Fehlertypen zugeordnet:
- "Ben.Gullw.: A", (Benetzung Gullwing)
- "Ben.J-Bein: B", (Benetzung J-Bein)
- "Ben.quad.SMD: C", (Benetzung quaderförmiger SMD)
- "SMD_versetzt: D",
- "sonst.Loetf.: E",
- "nicht_geloetet: F",
- "Lotbrücke: G",
- "wegg./hochg.: H", (Anschlußpin weggebogen/hochgebogen)
- "SMD_versetzt: I",
- "sonst.Loetf.: J",
- "Lotperlen: K",
- "INSUFF_TOE: L", (magere Lötstelle)
- "Blase.SMD: V", (Lötblase).

Weiterhin kann vorgesehen sein, daß die erkannten Fehler bzw. Meßwertinformationen einem Fehlertyp - wie z.B. vorstehend aufgelistet - zugeordnet werden und daß die Fehlertypen einer Fehlerklasse (Lötpastenfehler, Bestückungsfehler, Lötfehler) zugeordnet werden.

Die lötstellenindividuellen Qualitätsinformationen und/oder die lötstellenindividuellen Meßwertinformationen, die die gemessenen physikalischen Parameter überprüfter Lötstellen bezeichnen, und/oder statistische Informationen über die Häufigkeit des Auftretens von Fehlern werden auf den Monitoren LMON, BMON, RMON angezeigt, die den Einrichtungen L, B, R zugeordnet sind.

Die Datenverarbeitungseinrichtung C und die Reparaturarbeitsstation SST können beispielsweise in folgenden zwei Varianten ausgeführt werden:
1. PC-Variante

| | |
|---|---|
| CPU z | HP Vectra VL2 4/66 HP Vectra VL2 5/60 |
| Hauptspeicher | 24 MB |
| Festplatte | 500 MB |
| Swap | 60 MB |
| Grafikkarte | Ultra VGA 1024x768 B |
| Monitor | 15" oder 17" |
| Betriebsystem | Solaris x86 2.4 |
| Netzwerkkarte | 16-Bit BNC, TP, AOI |

| ***Optionen*** | |
|---|---|
| Eingabe | Numerisches Keypad Trackball RS-232 Barcodescanner |
| Lichtzeiger | Heeb OM-500 Royonic 500 |
| Drucker | HP DeskJet 1200C/PS HP LaserJet 5MP |
| Datensicherung | Magnetband (QIC oder DAT) Magneto-Optische Laufwerke |

2. Workstation-Variante

| | |
|---|---|
| CPU | Sun SparcStation |
| Hauptspeicher | 32 MB |
| Festplatte | 1 GB |
| Swap | 60 MB |
| Grafikkarte | 1024x768, 1152x900 Bildpunkte |
| Monitor | 15" oder 17" |
| Betriebsystem | Solaris 2.4 |
| Netzwerkkarte | eingebaut |

| ***Optionen*** | |
|---|---|
| Eingabe | 3 ½" Diskettenlaufwerk Numerisches Keypad RS-322 Barcodescanner |
| Lichtzeiger | Heeb OM-500 Royonic 500 |
| Drucker | HP DeskJet 1200C/PS HP LaserJet 5MP |
| Datensicherung | Magnetband (QIC oder DAT) Magneto-Optische Laufwerke |

Das das erfindungsgemäße Verfahren definierende Steuerungsprogramm ist beispielsweise eine UNIX-Applikation, die auf dem Betriebssystem Solaris von SunSoft aufsetzt.

Das Steuerungsprogramm realisiert unter anderem:
a) eine Anzeige der von der Einrichtung I generierten Röntgeninspektionsergebnisse *(z.B. Figur 8);*
b) eine Anzeige der bei der Röntgeninspektion gefundenen Fehler schrittweise in einer grafischen Darstellung des Leiterplattenlayouts;
c) eine Anzeige der bei der Röntgeninspektion gefundenen Fehler schrittweise mit Hilfe eines Laser/Licht-Zeigers auf der Originalleiterplatte;
d) eine Anzeige von Fehlern (Häufung von Fehlern an einer oder mehreren Stellen der Leiterplatte) in einer grafischen Darstellung des Leiterplattenlayouts;
e) eine Verifizierung, Quittierung und Weiterverarbeitung der bei der Röntgeninspektion gefundenen Fehler, gegebenenfalls schrittweise durch eine Bedienperson des Reparaturarbeitsplatzes SST mit einem Dialogmenü; und
f) Speicherung bearbeiteter Fehlerdaten als Schnittstelle zu einem Programmodul oder zu Qualitätssicherungssystemen.

Im folgenden werden die vorstehend genannten Elemente des Steuerungsprogramms beschrieben:

a) Anzeige der von der Einrichtung I generierten Röntgeninspektionsergebnisse in Textform.

Diese Anzeige erfolgt auf dem Monitor SMON der Reparaturarbeitsplatzstation SST.

Der Programmarbeitsbereich besteht aus einem Hauptfenster mit Menüleiste. Weitere Fenster können eingeblendet werden.

Die Menüleiste umfaßt folgende Menüs mit den Optionen:
- **Datei** Dateifunktionen
   - **Editor**: Aufruf eines Texteditors
   - **Beenden**: Programm verlassen
- **Betriebsart** Auswahl der Betriebsarten
   - **Einzelfehler**: Einzelfehleranzeige
   - **Fehlerübersicht**: Anzeige der Fehlerübersicht
   - **Röntgenbild**: Darstellung des Röntgenbildes
- **Konfiguration** Konfigurationseinstellungen
   - **Licht-/Laserzeiger >**: Auswahl des Licht-/Laserzeigers
   **Royonic 500** Lichtzeiger Royonic 500
   **Heeb Laser** Heeb LL-2A oder OM-500
   - **Betriebsart >**: Einstellen der Standardbetriebsart(en)
   **Einzelfehler** Einzelfehleranzeige
   **Fehlerübersicht** Fehlerübersicht
   **Röntgenbild** Röntgenbildfenster
   - **Dateipfade>**: Angabe der Dateipfade
   **CXI-Tag-Dateien** Pfad zu den CXI-Tag-Dateien
   **Röntgenbilddateien** Pfad zu den Röntgenviews
   **CAD-Dateien** Pfad zu den CAD-Dateien
   **Ergebnisdateien** Pfad zu den Ergebnisdateien
   **Fehlertypreferenz** Pfad zur Fehlertypreferenzdatei

### Verifizierdialog>

- **GUT-Boards autom.**: Fehlerlose Boards automatisch übernehmen
- **Optionen>**: Optionsmenü für diverse Einstellungen
- **Symbolleiste**: Symbolleiste ein- und ausblenden
- **Speichern bei Beenden**: Einstellungen bei Beenden speichern

Die zuvor beschriebene Menüleiste wird bei geänderten oder zusätzlichen Bedienschritten entsprechend angepaßt.

b) Anzeige der bei der Röntgeninspektion gefundenen Fehler schrittweise in einer grafischen Darstellung des Leiterplattenlayouts

b1) Betriebsart: Einzelfehleranzeige

Die Steuerung der Einzelfehleranzeige durch den Bediener der Reparahirarbeitsstation SST erfolgt mit einem Dialogfenster, das die Elemente
- Kopfbereich (Header),
- Optionsgruppe Anzeige,
- Optionsgruppe Seite,
- Fehlerliste,
- Knöpfe Weiter, Zurück, Echter Fehler, Pseudofehler, Neuer Fehler, Fehlertyp ändern, Bauteil weiter, Fertig, Abbruch,
enthält.

Im "Kopfbereich (Header)" werden die Daten aus dem Kopf der Daten des Röntgensystems I angezeigt.

Mit der "Optionsgruppe Anzeige" kann der Bediener die Anzeigeformen für die Einzelfehleranzeige auswählen. Zur Verfügung stehen die Möglichkeiten "**Layout**", für die Darstellung des grafischen Leiterplattenlayouts auf dem Bildschinn, und **"Zeiger",** für die Anzeige auf der Originalleiterplatte mit einem Licht-/Laserzeiger.

Mit Hilfe der "Optionsgruppe Seite" wird die angezeigte Seite der Leiterplatte ausgewählt. Zur Verfügung stehen **Oberseite** und **Unterseite**.

Die "Fehlerliste" enthält alle vom Röntgensystem gefundenen oder vom Bediener hinzugefügten Fehler der Leiterplatte. Der aktuell im Leiterplattenlayout und/oder vom Licht-/Laserzeiger angezeigte Fehler ist in der Fehlerliste hervorgehoben.

Der Knopf "Weiter" zeigt den nächsten Fehler in der Fehlerliste im Leiterplattenlayout und/oder mit dem Licht-/Laserzeiger an.

Der Knopf "Zurück" zeigt den vorhergehenden Fehler in der Fehlerliste im Leiterplattenlayout und/oder mit dem Licht-/Laserzeiger an.

Der Knopf "Echter Fehler" markiert den aktuellen Fehler als echten Fehler.

Der Knopf "Pseudofehler" markiert den aktuellen Fehler als Pseudofehler.

Der Knopf "Neuer Fehler" fügt einen neuen Fehler in die Liste ein und zeigt ihn im Leiterplattenlayout und/oder mit dem Licht-/Laserzeiger an.

Der Knopf "Fehlertyp ändern" gestattet es, den Fehlertyp eines bereits markierten Fehlers wieder zu ändern.

Der Knopf "Bauteil weiter" springt zum nächsten Bauteil in der Fehlerliste. Wird diese Taste gedrückt, werden die Einzelfehler gelöscht und der Fehlercode für den Bauteilsummenfehler in die Ergebnisdatei eingetragen.

Der Knopf "Fertig" oder die Taste "Enter" nach dem letzten Fehlereintrag trägt die markierten echten Fehler und die markierten Pseudofehler in die Ergebnisdatei ein und schließt den Verifiziervorgang für diese Baugruppe ab. Bei vorzeitigem Abbruch wird in die Ergebnisdatei als letzte Zeile eine Abbruchmeldung eingetragen (siehe auch Knopf "Abbruch").

Der Knopf "Abbruch" schließt das Dialogfenster und das Fenster mit dem grafischen Leiterplattenlayout und/oder fährt den Licht-/Laseranzeiger in eine Ruheposition. In die Ergebnisdatei (siehe unten) wird als letzte Zeile eine Abbruchmeldung eingetragen.

Über eine standardisierte Softwareschnittstelle wird der ausgewählte Fehler an die Programmodule für die Anzeige im grafischen Leiterplattenlayout und mit dem Licht-/Laserzeiger übergeben.

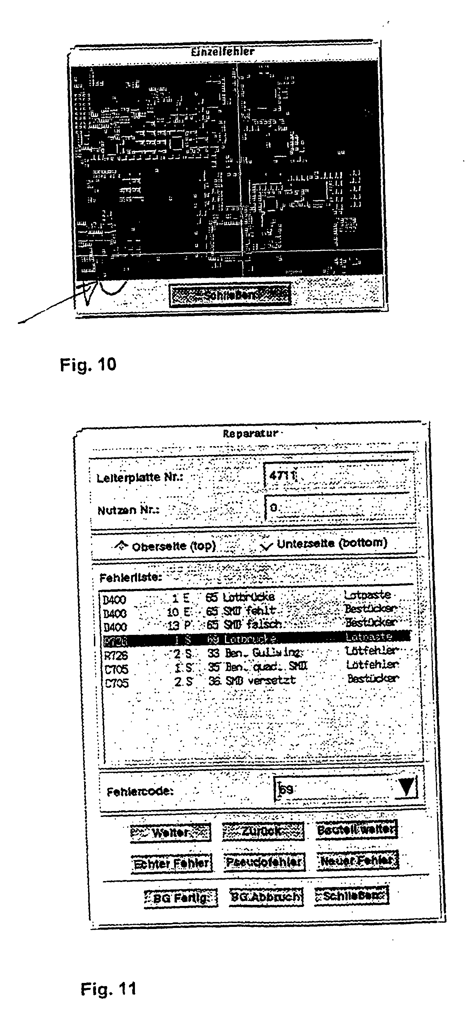

Ist die Anzeige des Leiterplattenlayouts aktiviert, so wird jeder Fehler in der Fehlerliste durch eine Markierung in einem grafischen Leiterplattenlayout, das aus leiterplattenbeschreibenden CAD-Daten erzeugt wird, angezeigt. Eine Anzeige ist in Figur 10 dargestellt, wobei beispielsweise der mit dem (externen) Pfeil markierten Lötstelle in der tatsächlichen Bildschirmanzeige eine Markierung zugeordnet ist, die in Figur 10 nicht erkennbar ist.

In einer Standardeinstellung werden alle Baugruppen der Leiterplatte im grafischen Layout angezeigt. Fehlerdaten werden über eine standardisierte Softwareschnittstelle entgegengenommen und die entsprechenden Fehler werden angezeigt. Fehler werden farblich hervorgehoben.

Es kann die gesamte Leiterplatte oder lediglich ein Ausschnitt, vorzugsweise in vergrößertem Maßstab, dargestellt werden.

b2) Betriebsart: Fehlerübersicht

Diese Betriebsart ermöglicht es, auf einer grafischen Darstellung des Leiterplattenlayouts die markierten echten Fehler der Fehlerliste zusammen oder getrennt nach Fehlern darzustellen.

Die Fehler, die die Einrichtung I erkennt, werden den Fehlertypen "Bestükungsfehler", "Lötfehler" und "Lötpastenfehler" zugeordnet. "Bestückungsfehler" werden in blauer Farbe, "Lötfehler" in gelber Farbe und "Lötpastenfehler" in grüner Farbe dargestellt.

Im Fenster wird angezeigt, auf welcher Seite (Oberseite/Unterseite) der Leiterplatte sich die Bauelemente befinden.

In Figur 11 ist ein Beispiel einer auf dem Bildschirm angezeigten Fehlerliste dargestellt.

b3) Betriebsart: Röntgenbildanzeige

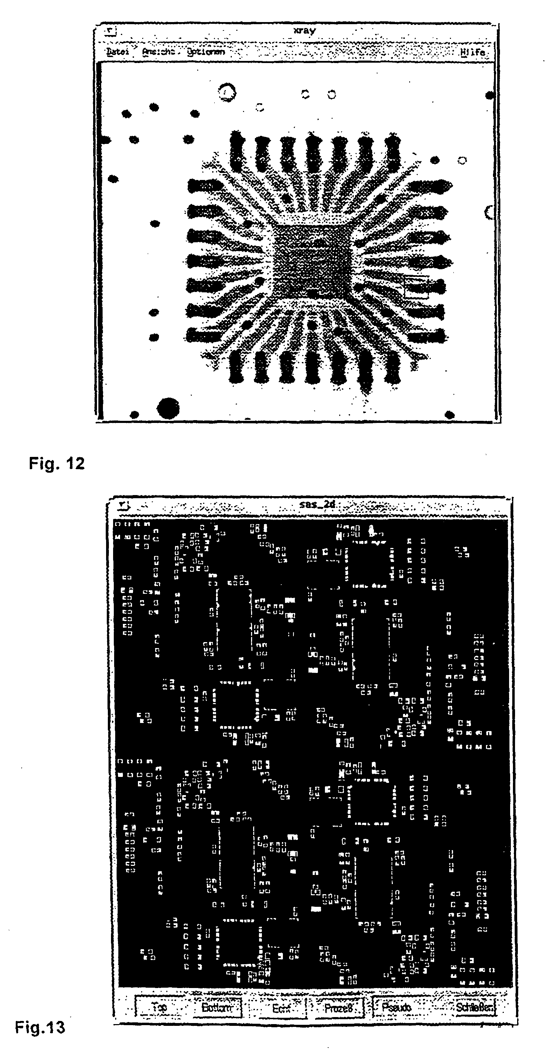

In einem gesonderten Fenster kann zu den von der Einrichtung I generierten Daten das passende Röntgenbild dargestellt werden. Ein Beispiel eines solchen Fensters ist in Figur 12 dargestellt, wobei eine fehlerhafte Lötstelle rechts im Fenster mit einem quadratischen Rahmen markiert ist. Optional kann in dieses Fenster die komplette Bauteileliste des Bildes eingeblendet werden.

c) Anzeige der bei der Röntgeninspektion gefundenen Fehler schrittweise mit Hilfe eines Laser/Licht-Zeigers auf der Originalleiterplatte;

Ist im Dialogfenster die Anzeige mit dem Licht-/Laserzeiger aktiviert, so wird der Fehler auf der Originalleiterplatte mit einem Lichtpunkt angezeigt. Beispielsweise können die Licht-/Laserzeiger Royonic Lichtzeiger 500 oder Heeb Laserlite LL-2-A bzw. 500 verwendet werden.

d) Anzeige von Fehlern (Häufung von Fehlern an einer oder mehreren Stellen der Leiterplatte) in einer grafischen Darstellung des Leiterplattenlayouts;

Ein Beispiel einer derartigen Anzeige ist in Figur 13 dargestellt, wobei in der Figur 13 die eigentlichen Fehlerdaten, die den zugehörigen Lötstellen bei der tatsächlichen Bildschirmanzeige benachbart zugeordnet sind, nicht erkennbar sind.

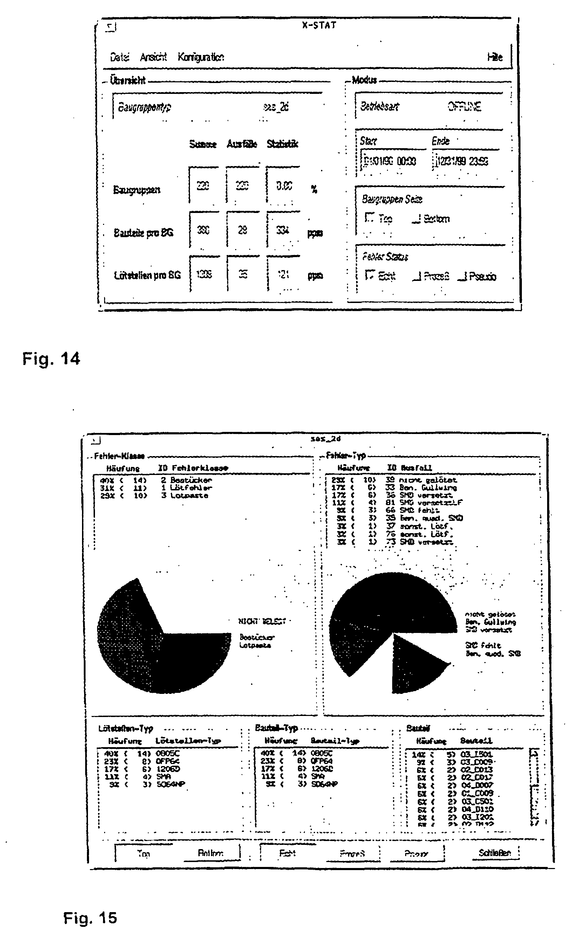

Weitere Anzeigen von Fehlern in statistischer Auswertung sind in den Figuren 14, 15 und 16 dargestellt.

e) Verifizierung, Quittierung und Weiterverarbeitung der bei der Röntgeninspektion gefundenen Fehler, gegebenenfalls schrittweise durch eine Bedienperson der Reparaturarbeitsstation SST mit einem Dialogmenü.

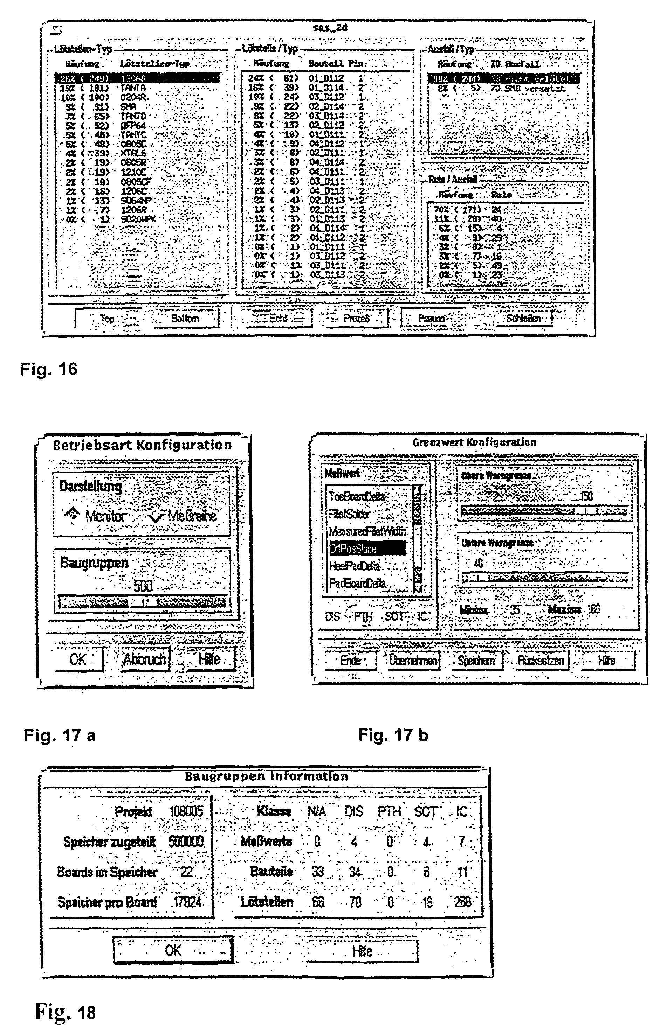

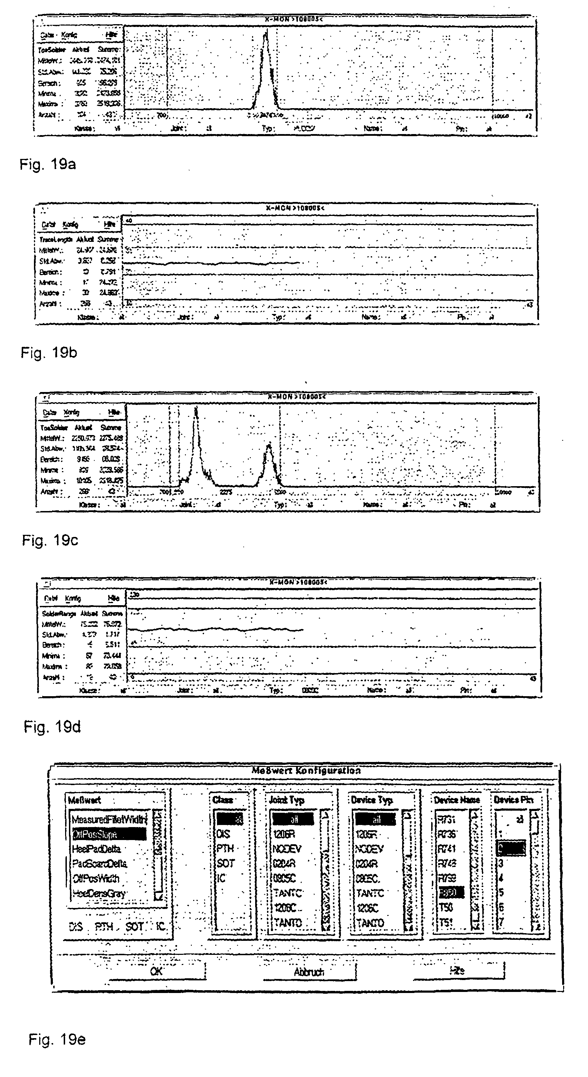

Im folgenden wird der Ablauf eines Zyklus im Zusammenhang mit der Verifizierung fehlerfreier Leiterplatten und der Reparatur fehlerhafter Leiterplatten beschrieben, der auch in Figur 18 dargestellt ist.

Für die Verifizierung und Reparatur von Leiterplatten muß die Betriebsart Einzelfehleranzeige aktiviert sein. Ein Reparaturzyklus beginnt mit dem Einlesen der Leiterplattennummer mit einem Barcode-Lesestift.

Alternativ kann die Reparatur auch mit der Selektion einer Fehlertag-Datei über Tastatur oder Maus beginnen.

Anhand der eingelesenen Leiterplattennummer wird das zugehörige Tagfile für die Leiterplatte gesucht, geöffnet und der Dateikopf und die Fehlerliste eingelesen. Handelt es sich um eine fehlerfreie Leiterplatte, so werden in Abhängigkeit des Schalters GOOD_BOARDS zwei Fälle unterschieden:
- GOOD_BOARDS = AUTO
   Es wird eine Meldung angezeigt, daß die Leiterplatte fehlerfrei ist, und es wird automatisch ein Eintrag in der Ergebnisdatei erzeugt bzw. eine neue Ergebnisdatei angelegt, in der die fehlerfreie Leiterplatte vermerkt ist.
- GOOD_BOARDS =MANU
   Es wird wie bei fehlerhaften Leiterplatten fortgefahren mit der Ausnahme, daß die Fehlerliste leer ist.

Bei einer fehlerhaften Leiterplatte werden anhand der im Dateikopf des Tagfiles enthaltenen Baugruppen-Ident-Nummer die CAD-Dateien gesucht, geöffnet und die Geometriedaten der Baugruppe eingelesen. Ist die Baugruppen-Ident-Nummer der aktuellen Leiterplatte mit der zuvor geprüften identisch, so entfällt das erneute Einlesen der Geometriedaten.

Die Fehlerliste wird im Dialogfenster angezeigt, der erste Fehler markiert und auf dem Leiterplattenlayout auf dem Bildschirm und/oder mit dem Licht/Laserzeiger angezeigt.

Mit Hilfe der im Abschnitt "Einzelfehleranzeige" beschriebenen Schaltflächen des Dialogfensters können die Fehler in der Liste nun vom Bediener klassifiziert und markiert werden. Nachdem ein Fehler markiert ist, wird automatisch zum nächsten Fehler gesprungen. Hat der Bediener alle Fehler in der Liste markiert (bearbeitet) bzw. mit "Bauteil weiter" als Summenfehler markiert, so werden diese in die Ergebnisdatei eingetragen.

Nach der Bearbeitung der Leiterplatte (Board) werden die leiterplattenbezogenen Testdateien (I-Tag-Dateien, Röntgenbilder) entfernt, wenn ein Schalter DEL_TAG = On gesetzt ist. Standardwert ist DEL_TAG=Off.

Ist für die aktuelle Leiterplatte (Board) kein Test-Tag vorhanden, wird die Ergebnisdatei nach einem Eintrag für diese Leiterplatte (Board) bzw. das entsprechende Verzeichnis nach einer Ergebnisdatei für diese Leiterplatte (Board) durchsucht und wie folgt verfahren:
- Ausgabe einer Fehlermeldung, wenn das Board auch in der Ergebnisdatei nicht vorhanden ist bzw. wenn für dieses Board keine eigene Ergebnisdatei existiert.
- Handelt es sich um ein fehlerfreies Board, zu dem die Tag-Datei vorhanden ist, so wird in Abhängigkeit von dem Schalter GOOD_BOARDS wie oben beschrieben verfahren.
- Handelt es sich um die erneute Bearbeitung des Boards (keine Tag-Datei, aber Eintrag in der Ergebnisdatei bzw. eigene Ergebnisdatei), so wird die weitere Arbeitsweise vom Schalter REWORK_BOARDS beeinflußt. Lautet der Eintrag in der Konfigurationsdatei RE-WORK_BOARDS=On so kann die Leiterplatte nochmals unter Verwendung der Fehlerdaten aus der Ergebnisdatei bearbeitet werden. Ist der Eintrag dagegen REWORK_BOARDS=Off, so wird eine Meldung ausgegeben, daß das wiederholte Bearbeiten nicht möglich ist.

f) Speicherung bearbeiteter Fehlerdaten als Schnittstelle zu einem Programmodul oder zu Qualitätssicherungssystemen.

Die Datenverarbeitungseinrichtung C bearbeitet u.a. Bestückdaten mit den folgenden Feldern:

| **Feldname** | **Datenformat** | **Beschreibung** |
|---|---|---|
| **Joint** | long int | fortlaufende Nummer der Lötstelle (1 bis max_joint) |
| **Pin / Device** | long int | fortlaufende Nummer der Pins pro Bauteil (1 bis max_pin) |
| **Pin X** | long int | X-Koordinate des Pins bezogen auf den Boardnullpunkt |
| **Pin Y** | long int | Y-Koordinate des Pins bezogen auf den Boardnullpunkt |
| **Pad X** | long int | Padlänge in X-Richtung |
| **Pad Y** | long int | Padlänge in Y-Richtung |
| **Seite** | char | Baugruppenseite (T \| B) |
| **Device Name** | char[15] | Bezeichnung des Bauteils (ohne '\0') |
| **Device Typ** | char[25] | Bezeichnung des Bauteiltyps (ohne '\0') |
| **View** | long int | fortlaufende Nummer der View (1 bis no_of_views) |
| **View X** | long int | X-Koordinate des Pins bezogen auf die View |
| **View Y** | long int | Y-Koordinate des Pins bezogen auf die View |

Weiterhin bearbeitet die Datenverbeitungseinrichtung C eine Fehlertypenreferenzdatei.

Wie bereits beschrieben, wird jedem von der Einrichtung I erkannten Fehler eine Fehlerklasse "Bestückungsfehler", "Lötfehler" und "Lötpastenfehler" zugeordnet. Der Inhalt der Datei gliedert sich in einzelne Datensätze mit z.B. vier Datenfeldern. Jede Zeile der Datei beschreibt eine Referenz. Die Felder haben folgende Bedeutung:

| **Feldname** | **Feldlänge** | **Beschreibung** |
|---|---|---|
| **Fehler** | 3 Zeichen (long) | Fehlernummer |
| **Fehlernachricht** | 20 Zeichen | laut Defect-Tag |
| **Fehlerklasse** | 3 Zeichen (long) | Fehlerklasse |
| **Fehlerklassennachricht** | 20 Zeichen | Meldung für Bildschirmausgaben |
| **Farbe** | 10 Zeichen | Farbe, mit der dieser Fehler auf dem Bildschirm angezeigt wird. |
| **Symbol** | 10 Zeichen | Symbol, das zur Darstellung des Fehlers am Licht-/Laser-zeiger verwendet wird. |

Ein Beispiel einer Fehlertypenreferenzdatei ist folgendermaßen ausgestaltet;

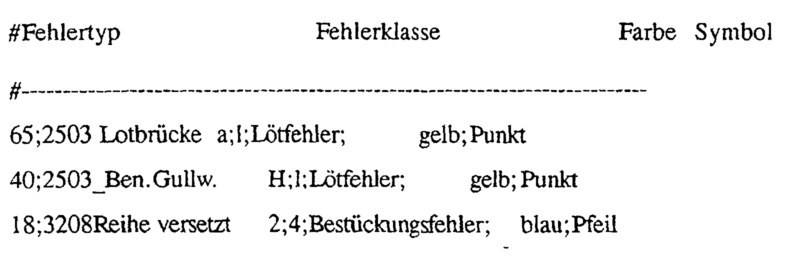

Für jede Leiterplatte kann eine eigene Ergebnisdatei erzeugt werden. Alternativ hierzu kann eine gemeinsame Ergebnisdatei für eine Mehrzahl bearbeiteter Leiterplatten, insbesondere für alle bearbeiteten Leiterplatten erzeugt werden. Für beide Arten von Ergebnisdateien erzeugt jeder Fehler einen Eintrag in dieser Datei.

Für die behandelte Baugruppe wird zunächst ein Header-Datensatz erstellt, der aus folgenden Feldern besteht:

| **Feldname** | **Feldlänge** | **Beschreibung** |
|---|---|---|
| **Datensatztyp** | 1 Zeichen | immer "H" bei Headerzeile |
| **Seriennummer der Baugruppe** | 25 Zeichen | laut Defect-Tag bzw. Barcode |
| **Nutzer ID** | 2 Zeichen (long) | laut Defect-Tag |
| **Baugruppentyp** | 20 Zeichen | laut Defect-Tag |
| **Testsystem ID** | 12 Zeichen | laut Defect-Tag |
| **Datum der Inspektion** | tt:mm:jj | laut Defect-Tag |
| **Uhrzeit der Inspektion** | hh:mm:ss | laut Defect-Tag |
| **UserID des Prüfers** | 4 Zeichen (long) | laut/etc./passwd Datei |
| **Datum der Reparatur** | tt:mm:jj | laut Systemzeit |
| **Uhrzeit der Reparatur** | hh:mm:ss | laut Systemzeit |
| **Status** | 1 Zeichen (long) | 0 = keine Reparatur; 1, 2... Anzahl der Reparaturen |

Im Anschluß an diese Headerzeile folgt für jeden Fehler eine Datenzeile, die aus den folgenden Feldern besteht.

| **Feldname** | **Feldlänge** | **Beschreibung** |
|---|---|---|
| **Datensatztyp** | 1 Zeichen | immer "D" bei Datenzeile |
| **Bauteilname** | 15 Zeichen | laut Defect-Tag |
| **Pinnummer** | 3 Zeichen (long) | laut Defect-Tag |
| **Fehlercode 1** | 3 Zeichen (long) | laut Fehlercode-Tabelle |
| **Fehlercode 2** | 3 Zeichen (long) | laut Eingabe des Prüfers |
| **Rule** | 2 Zeichen (long) | laut Defeet-Tag (DL-Feld) |
| **Fehlerklasse** | 3 Zeichen (long) | laut Referenztabelle |
| **Fehlerstatus** | 2 Zeichen (long) | Code (0 = bestätigt, 1 = geändert, 2 = Pseudo) |

Das vorstehend beschriebene Verfahren kann eines von mehreren Programmodulen des dem Steuerwerk CPU zugeordneten Steuerungsprogramms sein. Das vorzugsweise modular aufgebaute Steuerungsprogramm kann weitere Programmodule aufweisen, die Gegenstand der Verfahrensansprüche sind. Jedes Programmodul ist für sich alleine oder zusammen mit einem oder mehreren anderen Programmodulen einsetzbar.

Ein Programmodul des Steuerungsprogramms ist wie bereits beschrieben in der Weise ausgestaltet, daß die von der Einrichtung I erzeugten Röntgenbilder bzw. aus diesen erzeugte elektronische Bilder und aus CAD-Daten erzeugte Bilder des grafischen Layouts der Leiterplatten auf dem Monitor SMON an der Reparaturarbeitsstation SST anzeigbar sind.

Dabei werden die Röntgenbilder bzw. die elektronischen Bilder sowie die Leiterplattenlayout-Bilder gemeinsam mit lötstellenindividuellen Meßwertinformationen angezeigt, die gemessene, physikalische Parameter überprüfter fehlerhafter Lötstellen bezeichnen, gegebenenfalls gemeinsam mit statistischen Informationen über die Häufigkeit des Auftretens von Fehlern. Die Informationen werden in alphanumerischer Darstellung und/oder in Symboldarstellung in den Röntgenbildem dargestellt.

Ein weiteres Programmodul des Steuerungsprogramms ist in der Weise ausgestaltet, daß die lötstellenindividuellen Qualitätsinformationen und/oder lötstellenindividuellen Meßwertinformationen, die gemessene physikalische Parameter überprüfter Lötstellen bezeichnen, mit vorgebbaren Herstellungsprozeßschwellwerten verglichen werden, und daß, in Abhängigkeit des Vergleichs, Prozeßsteuerdaten gebildet werden. Beispielsweise wird als Herstellungsprozeßschwellwert eine bestimmte Lotmenge vorgegeben, die pro vorgebbarer Lötstelle aufzubringen ist. Ergibt sich anhand eines Vergleichs dieses Herstellungsprozeßschwellwerts bzw. Herstellungsprozeßreferenzwerts mit den entsprechenden Lotmengen-Meßwertinformationen, daß dieser Schwell- bzw. Referenzwert um einen vorgebbaren Toleranzbereich über- oder unterschritten wird, bildet die Datenverarbeitungseinrichtung C alphanumerische und/oder grafische Informationen, die den Referenzwert, und/oder die Meßwertinformationen und/oder den Umfang des Über- bzw. Unterschreitens des Referenzwerts bezeichnen. Weiterhin kann die Datenverarbeitungseinrichtung diejenige Einrichtung(en) (L, B, R) bestimmen, die das Über- bzw. Unterschreiten der Lotmengen verursachen. Diese Informationen werden dem Monitor SMON der Reparaturarbeitsstation SST und dem Monitor derjenigen Einrichtung (z.B. R) zugeführt, die das Über- bzw. Unterschreiten der Lotmengen verursacht. Entsprechende Bildschirmanzeigen sind in Figur 19 dargestellt.

Weiterhin kann die Datenverarbeitungseinrichtung C eine Steuerinformation für diese Einrichtung (z.B. R) bilden, die eine Änderung der Betriebsparameter dieser Einrichtung bewirken. Wird beispielsweise der Referenzwert in einem bestimmten Umfang überschritten, werden die Steuerinformationen (d.h. Prozeßsteuerdaten) in der Weise gebildet, daß die Einrichtung R die Lotmenge pro Lötstelle entsprechend reduziert. Diese Prozeduren, die zur unmittelbaren Steuerung des laufenden Herstellungsprozesses durchgeführt werden, können bereits vor dem Auftreten von Lötfehlern on-line durchgeführt werden, also zu Zeitpunkten, zu denen noch Qualitätsinformationen "Lötstelle fehlerfrei" gebildet werden.

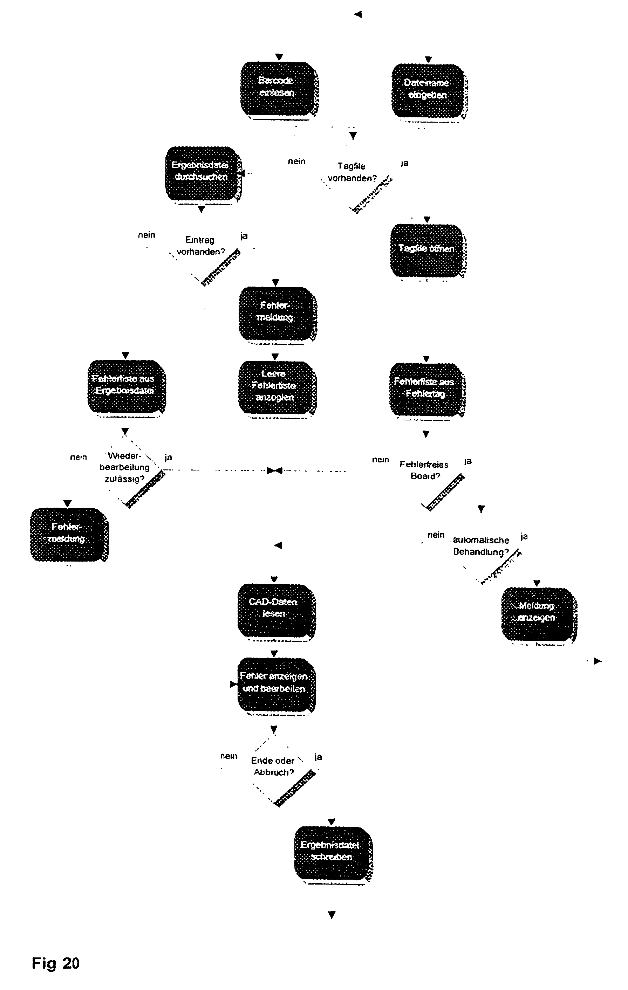

Bildschirmanzeigen im Zusammenhang mit der Konfiguration von Meßwerten bzw. von Referenzwerten ("Obere Warngrenze", "Untere Warngrenze") sind in den Figuren 19c, 17, 20 und 21 dargestellt.

Anhand der lötstellenindividuellen Qualitätsinfonnationen und/oder anhand der lötstellenindividuellen Meßwertinfonnationen wird also für Lötstellen, deren physikalische Parameter von den vorgebbaren Herstellungsprozeßschwell- bzw. - referenzwerten abweichen, geprüft, welcher der ersten und/oder der zweiten und/oder der dritten Einrichtung L, B, R diese Abweichung zuzuordnen ist. In Abhängigkeit dieser Zuordnung wird die erste und/oder die zweite und/oder die dritte Einrichtung (L, B, R) gegebenenfalls auch die zugehörige optische Anzeigeeinrichtung (LMON, BMON, RMON) mit den Prozeßsteuerdaten angesteuert. Den Anzeigeeinrichtungen werden insbesondere die von der Datenverarbeitungseinrichtung C gebildeten alphanumerischen und/oder grafischen Informationen zugeführt, die den Referenzwert und/oder die Meßwertinformationen und/oder den Umfang des Über- bzw. Unterschreitens des Referenzwerts bezeichnen.

Ein weiteres Programmodul ist in der Weise ausgestaltet, daß die lötstellenindividuellen Qualitätsinformationen und/oder die lötstellenindividuelle Meßwertinformationen, die gemessene physikalische Parameter überprüfter Lötstellen bezeichnen, mit Grauwertparametern von Röntgenbildern der Lötstellen korreliert werden und basierend auf der Korrelation Kriterien für die Bildung der lötstellenindividuellen Qualitätsinformationen und von Lötstellenherstellungsprozeßschwellwerten generiert werden.

Es werden also Gesetzmäßigkeiten (rules) für die Bildung der lötstellenindividuellen Qualitätsinfonnationen und von Lötstellenherstellungsprozeßschwellwerten generiert. Ausgangspunkt sind die Meßwertinfonnationen von fehlerfreien und fehlerhaften Leiterplatten bzw. Lötstellen, welche statistisch aufbereitet werden, sowie bauteilindividuelle Parameter, die in einer Skalierungsbibliothek abgelegt sind.

Wie bereits beschrieben, mißt die Einrichtung I physikalische Parameter der Lötstellen, beispielsweise geometrische Abmessungen bzw. das Profil der Lötstellen. Ein oder vorzugsweise mehrere Profilparameter wie beispielsweise zwei Höhenpunkte des Meniskus, die Differenz zwischen diesen Höhenpunkten bzw. zwischen jedem der Höhenpunkte und tiefstem Punkt auf der Lötstellenoberfläche, eine vertikale Querschnittsfläche der Lötstelle werden ausgewählt. Diese Profilparameter von Lötstellen besonders guter bzw. besonders schlechter Qualität werden mit Grauwertparametern der Röntgenbilder der entsprechenden Lötstellen kombiniert bzw. korreliert. Als Ergebnis werden selbsttätig bestimmte Profilparameter und Bereichsgrenzwerte ausgewählt, die neue Entscheidungskriterien für künftige Bewertungen der Qualität von Lötstellen bilden.

Im Rahmen einer Ausführungsform des erfindungsgemäßen Verfahrens werden lötstellenindividuelle Meßwertinformationen on-line ausgewertet und an unterschiedliche Einrichtungen des Herstellungsprozesses übertragen. Röntgen-Fehlerbilder werden on-line am Reparaturarbeitsplatz genutzt. Qualitätsinformationen, und zwar u.a. Meßwertinformationen werden zu einzelnen Fertigungsschritten bzw. den entsprechenden Einrichtungen zugeordnet und dort angezeigt. Durch Rückkopplung dieser Informationen wird der Fertigungsprozeß geregelt. Weiterhin wird on-line eine layoutorientierte Statistik durchgeführt. Schließlich werden unter Verwendung von bauteilrelevanten Daten und von statistisch aufbereiteten Meßwertinformationen lötstellentyp-bezogene Gesetzmäßigkeiten für die Erkennung von Lötfehlern und ProzeßBereichsgrenzwerten definiert.

| **Meßwertparameter für die Prüfung von Lötstellen zur Kontaktierung integrierter Schaltungen** | | |
|---|---|---|
| **Meßwertname** | **Abk.** | **Erklärung** |
| **measured_length** | l | Länge der Lötstelle |
| **percent_bridged** | | Anteil dunkler Bereiche zwischen Pins → Brücken zwischen Pins |
| **off_pos_width** | o | Breite von Pad, Pin und Zinn → versetzte Pins |
| **trace_length** | tl | Länge des Zinns auf dem Pad außerhalb des Toes → geliftete Pins |
| **with_x_100** | x | genaue Breite der Lötstelle (mittlere Breite der Lötstelle * 100 ) |
| **heel_solder** | h | Zinnmenge am Heel |
| **pad_solder** | p | Zinnmenge auf dem Pad |
| **toe_solder** | t | Zinnmenge am Toe |
| **valley_width** | v | Talbreite der Grauwertkurve vom Querschnitt → geliftete Pins |
| **max_toe_slope** | ts | Maximaler Zinnanstieg am Toe |
| **heel_pad_delta** | htpd-1 | Grauwertdifferenz zwischen Heel und Pad |
| **toe_pad_delta** | htpd-2 | Grauwertdifferenz zwischen Toe und Pad |
| **heel_board_delta** | hptbd-1 | Grauwertdifferenz zwischen Heel und Board |
| **pad_board_delta** | hptbd-2 | Grauwertdifferenz zwischen Pad und Board |
| **toe_board_delta** | hptbd-3 | Grauwertdifferenz zwischen Toe und Board |
| **toe_heel_dist** | th | ----------------------- |
| **delta_heel_maxes** | dh | ----------------------- |
| **fillet_solder** | s | Summe der Zinnmengen von Heel und Toe |

| **Meßwertparameter für die Prüfung von SOT-Lötstellen** | | |
|---|---|---|
| **Meßwertname** | **Abk.** | **Erklärung** |
| **measured_length** | ml | Länge der Lötstelle |
| **measured_width** | m | Breite der Lötstelle |
| **valley_width** | v | Taalbreite der Querschnitt-Grauwertkurve → geliftete Pins |
| **off_pos_width** | ow | Versatz des Pins auf dem Pad → versetzte Pins |
| **heel_pad_delta** | hp | Grauwertdifferenz zwischen Heel und Pad |
| **pad_board_delta** | pbd | Grauwertdifferenz zwischen Pad und Board |
| **neg_fillet_slope** | neg | Negativer Anstieg der Grauwertkurve |
| **fillet_slope** | sl | Positiver Anstieg der Grauwertkurve |
| **heel_solder** | d | Zinmenge am Heel |
| **heel_dens_gray** | g | |

| **Meßwertparameter für die Prüfung von Lötstellen zur Kontaktierung diskreter Bauelemente** | | |
|---|---|---|
| **Meßwertname** | **Abk.** | **Erklärung** |
| **pack_gray** | | Grauwert des Bauelementes → Bauelement nicht oder falsch bestückt |
| **measured_width** | w | Breite der Lötstelle |
| **measured_length** | l | Länge der Lötstelle |
| **neg_fillet_slope** | n | Negativer Anstieg der Grauwertkurve Übergang zwischen Zinn und Bauelement |
| **fillet_slope** | s | Positiver Anstieg der Grauwertkurve → Anstieg des Zinn am Bauelement |
| **measured_fillet_width** | fw | Breitenmessung an der Rundung |
| **heel_pad_delta** | hpd | Grauwertdifferenz zwischen Heel und Pad |
| **pad_board_delta** | pdb | ------------------------- |
| **low_slope_distance** | sds | Abstand zwischen Low_Slope und Slope |
| **low_slope_delta** | sdl | Grauwertdifferenz zwischen Low_Slope & Slope |
| **disc_skew** | | Winkel des verdrehten Bauelementes |
| **Ta_polarity_defect** | | Polarität bei Tantal-Kondensatoren |
| **mom_ratio** | m | Verhältnis von Breite zu Höhe der Lötstelle |
| **porosity_signature** | p | Porösität der Lötstelle (Lufteinschlüsse) |
| **solder_range** | r | Zinnmenge an der Lötstelle |

### Bezugszeichen

- SJ: Lötstelle
- PARiVALSJ: Meßparameterwert einer Lötstelle (Parameter i)

- SJG: fehlerfreie Lötstelle
- SJB: fehlerhafte Lötstelle
- SJREF: Referenzlötstelle
- SJGREF: fehlerfreie Referenzlötstelle
- j = 1,...,n: Mehrzahl fehlerfreier Referenzlötstellen
- SJBREF: fehlerhafte Referenzlötstelle
- PARiVALSJBREF: Meßparameterwert einer fehlerhaften Referenzlötstelle
- PARiVALAVESJBREF: aus Meßparameterwerten fehlerhafter Referenzlötstellen abgeleiteter Meßparameterwert

- BOARD: Substrat, Leiterplatte
- SM: Lötmaterial
- PIN: Kontaktelement
- CMP: Bauelement
- CTA: Kontaktfläche
- CTAREF: Kontaktflächenreferenzwert

- PAR: Meßparameter
- 1,...,m: Mehrzahl von Meßparametem
- 1,...,o: Mehrzahl fehlerhafter Referenzlötstellen

- DFAi: meßparameterindividueller Fehleristwertbereich (Parameter PARi)
- UVDFAi: oberer Bereichsgrenzwert von DFAi
- LVDFAi: unterer Bereichsgrenzwert von DFAi
- Ti1: erster meßparameterindividueller Schwellwert
- Ti2: zweiter meßparameterindividueller Schwellwert
- a, b, c: meßparameterindividuelle Schwellwertabweichung

- ml: Längenausdehnung einer Lötstelle (SJ, SJREF)
- b: Breitenausdehnung einer Lötstelle (SJ, SJREF)
- v: Talbreite eines Querschnitts einer Lötstelle (SJ, SJREF)
- hp: Höhendifferenz zwischen Scheitelpunkt (heel) und Talpunkt (pad) einer Lötstelle
- phd: Höhendifferenz zwischen dem Talpunkt (pad) der Lötstelle (SJ) und Substrat (BOARD)
- neg: Gefälle in einem Randbereich einer Lötstelle (SJ, SJREF)
- sl: Anstieg in einem Randbereich der Lötstelle (SJ, SJREF)
- d: Materialmenge in einem vorgebbaren Bereich der Lötstelle (SJ, SJREF)

## Patentansprüche

1. Verfahren zur Auswahl mindestens eines Meßparameters bei Prüfung einer Lötstelle (SJ) auf Fehlerfreiheit mittels Röntgenstrahlung,
wobei die Lötstelle (SJ) auf einem Substrat (BOARD) anordenbar ist,
wobei eine fehlerfreie Lötstelle (SJG) Lötmaterial (SM) aufweist, und
wobei das Lötmaterial (SM) einer fehlerfreien Lötstelle (SJG) galvanisch
mit einem Kontaktelement (PIN) eines Bauelements (CMP) verbunden ist,
wobei die Lötstelle (SJ) in Abhängigkeit von der Form des Kontaktelements (PIN) im Bereich der Lötstelle (SJ) einem vorgebbaren Lötstellentyp zugeordnet ist,
bestehend aus folgenden Schritten:
vor der Prüfung der Lötstelle (SJ) wird für eine erste Mehrzahl (m) von Meßparametern (PARi, i = 1...m), insbesondere Grauwertmeßparametern, jeweils ein unterer ßereichsgrenzwert (LVDFAi) und/oder ein oberer Bereichsgrenzwert (UVDFAi) eines meßparameterindividuellen Fehleristwertbereichs (DFAi) bestimmt, wobei dem unteren Bereichsgrenzwert (LVDFAi) ein vergleichsweise großer Fehler der Lötstelle (SJ) oder ein vergleichsweise kleiner Fehler der Lötstelle (SJ) entspricht, wobei dem oberen Bereichsgrenzwert (UVDFAi) ein vergleichsweise kleiner Fehler der Lötstelle (SJ) oder ein vergleichsweise großer Fehler der Lötstelle (SJ) entspricht, wobei die Meßparameter (PARi) jeweils die Topographie einer zweiten Mehrzahl (n) von fehlerfreien Referenzlötstellen (SJGREFj, j = 1...n) und/oder die Innenstruktur der n fehlerfreien Referenzlötstellen (SJGREFj) beschreiben, so daß m untere Bereichsgrenzwerte (LVDFAi) und/oder m obere Bereichsgrenzwerte (UVDFAi) meßparameterindividueller Fehleristwertbereiche (DFAi) bestimmt werder ;
vor der Prüfung der Lötstelle (SJ) wird von mindestens einer typgleichen fehlerhaften Referenzlötstelle (SJBREF) für die erste Mehrzahl (m) der Meßparameter (PARi) jeweils ein referenzlötstellenindividueller Meßparameterweit (PARiVALSJBREF), insbesondere ein Grauwertmeßparameterwert, ermittelt, so daß mindestens m referenzlötstellenindividuelle Meßparameterwerte (PARiVALSJBREF) für die m Meßparameter (PARi) der mindestens einer typgleichen fehlerhaften Referenzlötstelle (SJBREF) ermittelt werden;
vor der Prüfung der Lötstelle (SJ) wird für die m referenzlötstellenindividuellen Meßparameterwerte (PARiVALSJBREF) der typgleichen fehlerhaften Referenzlötstellen (SJBREF) jeweils deren mathematische Zuordnung, insbesondere deren Differenz oder Verhältnis, zu dem unteren Bereichsgrenzwert (LVDFAi) und/oder zu dem oberen Bereichsgrenzwert (UVDFAi) des meßparameterindividuellen Fehleristwertbereichs (DFAi) ermittelt;
bei der Prüfung der Lötstelle (SJ) wird ein Meßparameterwert (PAR1VALSJ). insbesondere ein Grauwertmeßparameterwert, mindestens eines ersten Meßparameters (PAR ) ermittelt, für den der referenzlötstellenindividuelle Meßparameterwert (PAR1VALSJ*BREF*) der mindestens einen fehlerhaften Referenzlötstelle (SJBREF) zu dem unteren Bereichsgrenzwert (LVDFA1) des meßparameterindividuellen Fehleristwertbereichs (DFA1) im Vergleich zu anderen meßparameterindividuellen Fehleristwertbereichen (DFA2, ..., *DFAm*) am nächsten oder am weitesten angeordnet ist und/oder für den der referenzlötstellenindividuelle Meßparameterwert (PAR1VALSJ*BREF*) der mindestens einen fehlerhaften Referenzlötstelle (SJBREF) von dem oberen Bereichsgrenzwert (UVDFA1) des meßparameterindividuellen Fehleristwertbereichs (DFA1) im Vergleich zu anderen meßparameterindividuellen Fehleristwertbereichen (DFA2, ...,DFAm) am weitesten oder am nächsten angeordnet ist.

2. Verfahren nach Anspruch 1, **dadurch gekennzeichnet, daß** bei der Prüfung der Lötstelle (SJ) mindestens ein zweiter Meßparameterwert (PAR2VALSJ) eines zweiten Meßparameters (PAR2) ermittelt wird, für den der referenzlötstellenindividuelle Meßparameterwert (PAR2VALSJ*BREF*)der mindestens einen fehlerhaften Referenzlötstelle (SJBREF) zu dem unteren Bereichsgrenzwert (LVDFA2) des meßparameterindividuelien Fehleristwertbereichs (DFA2) im Vergleich zu anderen meßparameterindividuellen Fehleristwertbereichen (DFA3, ..., *DFAm*) am zweitnächsten oder am zweitweitesten angeordnet ist und/oder für den der referenzlötstellenindividuelle Meßparameterwert (PAR2VASJ*BREF*) der mindestens einen fehlerhaften Referenzlötstelle (SJBREF) von dem oberen Bereichsgrenzwert (UVDFA2) des meßparameterindividuellen Fehleristwertbereichs (DFA2) im Vergleich zu anderen meßparameterindividuellen Fehleristwertbereichen (DFA3, ..., DFAm) am zweitweitesten oder am zweitnächsten angeordnet ist.

3. Verfahren nach einem der vorstehenden Ansprüche, **dadurch gekennzeichnet,**
**daß** vor der Prüfung der Lötstelle (SJ) von einer dritten Mehrzahl (o) typgleicher fehlerhafter Referenzlötstellen (SJBREFp, p = 1...o) referenzlötstellenindividuelle Meßparameterwerte (PARoVALSJBREF) der ersten Mehrzahl (m) der Meßparameter (PARi) ermittelt werden,
**daß** vor der Prüfung der Lötstelle (SJ) aus den jeweils o referenzlötstellenindividuellen Meßparameterwerten (PARoVALSJBREF) eines jeden Meßparameters (PARi) mindestens ein Meßparameterwert (PARiVAL-AVESJBRHT) der fehlerhaften Referenzlötstellen (SJBREF) nach einem vorgebbaren Algorithmus (AL1) abgeleitet wird;
**daß** vor der Prüfung der Lötstelle (SJ) anstelle der mathematischen Zuordnung der referenzlötstellenindividuellen Meßparameterwerte (PARiVALSBREF) der typgleichen fehlerhaften Referenzlötstellen (SJBREF) zu dem unteren Bereichsgrenzwert (LVDFAi) und/oder dem oberen Bereichsgrenzwert (UVDFAi) des jeweiligen meßparameterindividuellen Fehleristwertbereichs (DFAi) die mathematische Zuordnung der abgeleiteten Meßparameterwerte (PARiVAL*AVE*SJBREF), insbesondere deren Differenz oder Verhältnis, zu dem unteren Bereichsgrenzwert (LVDFAi) und/oder zu dem oberen Bereichsgrenzwert (UVDFAi) des jeweiligen meßparameterindividuellen Fehleristwertbereichs (DFAi) bestimmt wird; und
**daß** bei der Früfung der Lötstelle (SJ) anstelle des Meßparameterwerts (PAR1VALSJ) ein weiterer Meßparameterwert (PARi'VALSJ) mindestens eines weiteren ersten Meßparameters (PARi') emittelt wird, für den der abgeleitete Meßparameterwert (PARiVAL*AVE*SJBREF) der dritten Mehrzahl (o) der fehlerhaften Referenzlötstellen zu dem unteren Bereichsgrenzwert (LVDFAi) des Behleristwertbereichs (DFAi) im Vergleich zu anderen meßparameterindividuellen Fehleristwertbereichen (DFA3, ...DFAm) am nächsten oder am weitesten angeordnet ist und/oder für den der abgeleitete Meßparameteruert (PARiVAL*AVE*SJBREF) der dritten Mehrzahl (o) der fehlerhaften Referenzlötstellen zu dem oberen Bereichsgrenzwert (UVDFAi) des Fehleristwertbereichs (DFAi) im Vergleich zu anderen meßparameterindividuellen Fehleristwertbereichen (DFA3, ..., DFAm) am weitesten oder am nächsten angeordnet ist.

4. Verfahren nach einem der vorstehenden Ansprüche, **dadurch gekennzeichnet, daß** der untere Bereichsgrenzwert (LVDFAi) oder der obere Bereichsgrenzwert des meßparameterindividuellen Fehleristwertbereichs (DFAi) in Abhängigkeit eines Meßparameterwerts, bei dem die fehlerhafte Lötstelle eine unzureichende Kontaktfläche zwischen Lötmaterial und Kontaktelement (PTN) aufweist, bestimmt wird.

5. Verfahren nach einem der vorstehenden Ansprüche, **dadurch gekennzeichnet, daß** der obere Bereichsgrenzwert (UVDFAi) oder der untere Bereichsgrenzwert (LVDFAi) des meßparameterindividuellen Fehleristwertbereichs (DFAi) in Abhängigkeit der Verteilungsfunktion von Meßparameterwerten (PARi) der fehlerfreien Referenzlötstellen (SJGREF) bestimmt wird.

6. Verfahren nach Anspruch 5, **dadurch gekennzeichnet, daß** die Verteilungsfunktion von Meßparameterwerten (PARi) der fehlerfreien Referenzlötstellen eine Normalverteilung ist und daß der obere Bereichsgrenzwert (UVDFAi) oder der untere Bereichsgrenzwert des meßparameterindividuellen Fehleristwertbereichs (DFAi) in Abhängigkeit der Standardabweichung bestimmt wird.

7. Verfahren nach einem der Ansprüche 1 bis 4, **dadurch gekennzeichnet, daß** der obere Bereichsgrenzwert (UVDFAi) oder der untere Bereichsgrenzwert des meßparameterindividuellen Fehleristwertbereichs (DFAi) auf einen Wert festgesetzt wird, der geringfügig kleiner oder größer als der Meßparameterwert einer noch fehlerfreien Referenzlötstelle (SFGREF) ist.

8. Verfahren nach einem der vorstehenden Ansprüche, **dadurch gekennzeichnet, daß** die Lötstelle (SJ) bei der Prüfung als fehlerfrei bewertet wird, sofern der Meßparameterwert mindestens gleich groß oder maximal so groß wie ein vorgebbarer erster meßparameterindividueller Schwellwert (Ti1) ist.

9. Verfahren nach Anspruch 8, **dadurch gekennzeichnet, daß** der erste meßparameterindividuelle Schwellwert (Ti1) gleich groß wie der obere Bereichsgrenzwert (UVDFAi) des meßparameterindividuellen Fehleristwertbereichs (DFAi) ist.

10. Verfahren nach einem der Ansprüche 8 oder 9, **dadurch gekennzeichnet, daß** die Lötstelle (SJ) bei der Prüfung als fehlerfrei bewertet wird, sofern der Meßparameter wert mindestens gleich groß wie ein vorgebbarer zweiter meßparameterindividueller Schwellwert (Ti2) ist, der um eine meßparameterindividuelle Schwellwertabweichung (ia) kleiner oder größer als der erste meßparameterindividuelle Schwellwert (Ti1) ist.

11. Verfahren nach Anspruch 10, **dadurch gekennzeichnet, daß** die Größe einer zulässigen meßparameterindividuellen Schwellwertabweichung (a) eines ersten Meßparameters und/oder die Größen weiterer zulässiger meßparameterindiviueller Schwellwertabweichungen (b, c) weiterer Meßparameter in Abhängigkeit eines vorgebbaren Bezugswerts (CTAREF) einer Kontaktfläche (CTA) bestimmt wird, die zwischen Lötmaterial (SM) und Kontaktelement (PIN) einer zu prüfenden Lötstelle (SJ) gebildet ist.

12. Verfahren nach Anspruch 10 oder 11, **dadurch gekennzeichnet, daß** die Größe einer zulässigen meßparameterindividuellen Schwellwertabweichung (a) eines ersten Meßparameters und/oder die Größen weiterer zulässiger meßparameterindiviueller Schwellwertabweichungen (b, c) weiterer Meßparameter in Abhängigkeit eines vorgebbaren Bezugswerts (CTAREF) einer mathematischen Verknüpfung der Schwellwertabweichungen (a, b, c), insbesondere einer Produktbildung, einer Mittelwertbildung und/oder einer Summenbildung der Schwellwertabweichungen bestimmt wird.

13. Verfahren nach Anspruch 11, **dadurch gekennzeichnet, daß** in Abhängigkeit von Meßparameterwerten erster Meßparameter eine Information gebildet wird, die eine Wahrscheinlichkeit für die Existenz eines galvanischen Kontakts zwischen Lötmaterial (SM) und Kontaktelement (PIN) bezeichnet, und daß mittels Meßparameterwerte zweiter Meßparameter die Größe der Kontaktfläche (CTA) bestimmt wird.

14. Verfahren nach Anspruch 12 der 13, **dadurch gekennzeichnet, daß** die Größe der Kontaktfläche (CTA) mittels einer Information bestimmt wird, die eine Längenausdehnung (ml) der Lötstelle (SJ, SJREF) und/oder eine Breitenausdehnung (b) der Lötstelle (SJ) und/oder eine Talbreite (v) eines Querschnitts der Lötstelle (SJ) und/oder eine erste Höhendifferenz (hp) zwischen einem Scheitelpunkt (heel) und einem Talpunkt (pad) der Lötstelle und/oder eine zweite Höhendifferenz (phd) zwischen dem Talpunkt (pad) der Lötstelle (SJ) und dem Substrat (BOARD) und/oder ein Gefälle (neg) in einem Randbereich der Lötstelle (SJ) und/oder einen Anstieg (sl) in einem Randbereich der Lötstelle (SJ) und/oder eine Materialmenge (d) in einem vorgebbaren Bereich der Lötstelle (SJ) bezeichnet.

15. Verfahren nach einem der vorstehenden Ansprüche, **dadurch gekennzeichnet, daß** vor der Prüfung der Lötstelle (SJ) durchzuführende Verfahrensschritte zeitlich versetzt durchgeführt werden.

16. Verfahren nach einem der vorstehenden Ansprüche, **dadurch gekennzeichnet, daß** als Ergebnis der Prüfung entweder eine erste Information (INFSJG) gebildet wird, die die Fehlerfreiheit einer geprüften, fehlerfreien Lötstelle (SJ) bezeichnet, und oder eine zweite Information (INFSJB), die ein Nichtvorliegen von Fehlerfreiheit einer geprüften, fehlerhaften Lötstelle (SJ) bezeichnet, und daß die erste Information (INFSJG) und/oder die zweite Information (INFSJB) zur Steuerung eines Prozesses zur Herstellung von Lötstellen verwendet wird.

17. Schaltungsanordnung (SJTD) zur Auswahl mindestens eines Meßparameters bei Prüfung einer Lötstelle (SJ) auf Fehlerfreiheit mittels Röntgenstrahlung,
wobei die Schaltungsanordnung eine Datenverarbeitungseinrichtung (C) mit einem zugeordneten Steuerungsprogramm aufweist,
wobei die Lötstelle (SJ) auf einem Substrat (BOARD) anordenbar ist,
wobei eine fehlerfreie Lötstelle (SJG) Lötmaterial (SM) aufweist, und
wobei das Lötmaterial (SM) einer fehlerfreien Lötstelle (SJG) galvanisch mit einem Kontaktelement (PIN) eines Bauelements (CMP) verbunden ist,
wobei die Lötstelle (SJ) in Abhängigkeit von der Form des Kontaktelements (PlN) im Bereich der Lötstelle (SJ) einem vorgebbaren Lötstellentyp zugeordnet ist,
**dadurch gekennzeichnet, daß** das Steuerungsprogramm das Verfahren nach einem der vorhergehenden Ansprüche definiert.

18. Schaltungsanordnung nach Anspruch 17,
**dadurch gekennzeichnet, daß** das Steuerungsprogramm in der Weise ausgestaltet ist,
daß vor der Prüfung der Lötstelle (SJ) für eine erste Mehrzahl (m) von Meßparametern (PARi, i = 1...m), insbesondere Grauwertmeßparametern, jeweils ein unterer Bereichsgrenzwert (LVDFAi) und/oder ein oberer Bereichsgrenzwert (UVDFAi) eines meßparameterindividuellen Fehleristwertbereichs (DFAi) bestimmt wird, wobei dem unteren Bereichsgrenzwert (LVDFAi) ein vergleichsweise großer Fehler der Lötstelle (SJ) oder ein vergleichsweise kleiner Fehler der Lötstelle (SJ) entspricht, wobei dem oberen Bereichsgrenzwert (UVDFAi) ein vergleichsweise kleiner Fehler der Lötstelle (SJ) oder ein vergleichsweise großer Fehler der Lötstelle (SJ) entspricht, wobei die Meßparameter (PARi) jeweils die Topographie ciner zweiten Mehrzahl (n) von Fehlerfreien Referenzlötstellen (SJGREFj, j = 1...n) und/oder die Innenstruktur der n fehlerfreien Referenzlötstellen (SJGREFj) beschreiben, so daß m untere Bereichsgrenzwerte (LVDFAi) und/oder m obere Bereichsgrenzwerte (UVDFAi) meßparameterindividueller Fehleristwertbereiche (DFAi) bestimmt werden;
daß vor der Prüfung der Lötstelle (SJ) von mindestens einer typgleichen fehlerhaften Referenzlötstelle (SJBREF) für die erste Mehrzahl (m) der Meßparameter (PARi) jeweils ein referenzlötstellenindividueller Meßparameterwert (PARiVALSJBREF), insbesondere ein Grauwertmeßparameterwert ermittelt wird, so daß mindestens m referenzlötstellenindividuelle Meßparameterwerte (PARiVALSJBREF) für die m Meßparameter (PARi) der mindestens einer typgleichen fehlerhaften Referenzlötsteile (SJBREF) ermittelt werden;
daß vor der Prüfung der Lötstelle (SJ) für die m referenzlötstellenindividuellen Meßparameterwerte (PARiVALSJBREF) der typgleichen fehlerhaften Referenzlötstellen (SJBREF) jeweils deren mathematische Zuordnung, in besondere deren Differenz oder Verhältnis, zu dem unteren Bereichsgrenzwert (LVDFAi) und/oder zu dem oberen Bereichsgrenzwert (UVDFAi) des meßparameterindividuellen Fehleristwertbereichs (DFAi) ermittelt wird;
daß bei der Prüfung der Lötstelle (SJ) ein Meßparameterwert (PARIVALSJ), insbesondere ein Grauwertmeßparameterwert, mindestens eines ersten Meßparameters (PAR1) ermittelt wird, für den der referenzlötstellenindividuelle Meßparameterwert (PAR1VALSJ*BREF*) der mindestens einen fehlerhaften Referenzlötstelle (SJBREF) zu dem unteren Bereichsgrenzwert (LVDFA1) des meßparameterindividuellen Fehleristwertbereichs (DFA1) im Vergleich zu anderen meßparameterindividuellen Fehleristwertbereichen (DFA2, ..., *DFAm*) am nächsten oder am weitesten angeordnet ist und/oder für den der referenzlötstellenindividuelle Meßparameterwert (PAR1VALSJ*BREF*) der mindestens einen fehlerhaften Referenzlötstelle (SJBREF) von dem oberen Bereichsgrenzwert (UVDFA1) des meßparameterindividuellen Fehleristwertbereichs (DFA1) im Vergleich zu anderen meßparameterindividuellen Fehleristwertbereichen (DFA2, ..., DFAm) am weitesten oder am nächsten angeordnet ist.

19. Schaltungsanordnung nach Anspruch 17 oder 18, **dadurch gekennzeichnet, daß** das Steuerungsprogramm weiterhin in der Weise ausgestaltet ist, daß bei der Prüfung der Lötstelle (SJ) mindestens ein zweiter Meßparameterwert (PAR2VALSJ) eines zweiten Meßparameters (PAR2) ermittelt wird, für den der referenzlötstellenindividuelle Meßparameterwert (PAR2VASJ*BREF*) der mindestens einen fehlerhaften Referenzlötstelle (SJBREF) zu dem unteren Bereichsgrenzwert (LVDFA2) des meßparameterindividuellen Fehleristwertbereichs (DFA2) im Vergleich zu anderen meßparameterindividuellen Fehleristwertbereichen (DFA3, ..., *DFAm*.) am zweitnächsten oder am zweitweitesten angeordnet ist und/oder für den der referenzlötstelleindividuelle Meßparameterwert (PAR2VALSJ*BREF*) der mindestens einen fehlerhaften Referenzlötstelle (SJBREF) von dem oberen Bereichsgrenzwert (UVDFA2) des meßparameterindividuellen Fehleristwertbereichs (DFA2) im Vergleich zu anderen meßparameterindividuellen Fehleristwertbereichen (DFA3, ..., DFAm) am zweitweitesten oder am zweitnächsten angeordnet ist.

20. Schaltungsanordnung nach einem der Ansprüche 17 bis 19, **dadurch gekennzeichnet, daß** das Steuerungsprogramm weiterhin in der Weise ausgestaltet ist,
daß vor der Prüfung der Lötstelle (SJ) von einer dritten Mehrzahl (o) typgleicher fehlerhafter Referenzlötstellen (SJBREFp, p = 1...o) referenzlötstellenindividuelle Meßparameterwerte (PARoVALSJBREF) der ersten Mehrzahl (m) der Meßparameter (PARi) ermittelt werden,
daß vor der Prüfung der Lötstelle (SJ) aus den jeweils o referenzlötstellen individuellen Meßparameterwerten (PARoVALSJBREF) eines jeden Meßparameters (PARi) mindestens ein Meßparameterwert (PARiVAL AVESJBREF) der fehlerhaften Referenzlötstellen (SJBRFF) nach einem vorgebbaren Algorithmus (AL1) abgeleitet wird,
daß vor der Prüfung der Lötstelle (SJ) anstelle der mathematischen Zuordnung der referenzlötstellenindividuellen Meßparameterwerte (PARiVALSJBREF) der typgleichen fehlerhaften Referenzlötstellen (SJBREF) zu dem unteren Bereichsgrenzwert (LVDFAi) und/oder dem oberen Bereichsgrenzwert (UVDFAi) des jeweiligen meßparameterindividuellen Fehleristwertbereichs (DFAi) die mathematische Zuordnung der abgeleiteten Meßparameterwerte (PARiVAL*AVE*SJBREF), insbesondere deren Differenz oder Verhältnis, zu dem unteren Bereichsgrenzwert (LVDFAi) und/oder zu dem oberen Bereichsgrenzwert (UVDFAi) des jeweiligen meßparameterindividuellen Fehleristwertbereichs (DFAi) bestimmt wird; und
daß bei der Prüfung der Lötstelle (SJ) anstelle des Meßparameterwerts (PARiVALSJ) ein weiterer Meßparameterwert (PARi'VALSJ) mindestens eines weiteren ersten Meßparameters (PARi') ermittelt wird, für den der abgeleitete Meßparameterwert (PARiVATL*AVE*SJBREF) der dritten Mehrzahl (o) der fehlerhaften Referenzlötstellen zu dem unteren Bereichsgrenzwert (LVDFAi) des Fehleristwerbereichs (DFAi) im Vergleich zu anderen meßparameterindividuellen Fehleristwertbereichen (DFA3, ...DFAm) am nächsten oder am weitesten angeordnet ist und/oder für den der abgeleitete Meßparameterwert (PARiVAL*AVE*SJBREF) der dritten Mehrzahl (o) der fehlerhaften Referenzlötstellen zu dem oberen Bereichsgrenzwert (UVDFAi) des Fehleristwertbereichs (DFAi) im Vergleich zu anderen meßparameterindividueller. Fehleristwertbereichen (DFA3, ..., DFAm) am weitesten oder am nächsten angeordnet ist.

21. Schaltungsanordnung nach einem der Ansprüche 17 bis 20, **dadurch gekennzeichnet, daß** das Steuerungsprogramm weiterhin in der Weise ausgestaltet ist, daß der untere Bereichsgrenzwert (LVDFAi) oder der obere Bereichsgrenzwert des meßparameterindividuellen Fehleristwertbereichs (DFAi) in Abhängigkeit eines Meßparameterwert bei dem die fehlerhafte Lötstelle eine unzureichende Kontaktfläche zwischen Lötmaterial und Kontaktelement (PIN) aufweist, bestimmt wird.

22. Schaltungsanordnung nach einem der Ansprüche 17 bis 21, **dadurch gekennzeichnet, daß** das Steuerungsprogramm weiterhin in der Weise ausgestaltet ist, daß der obere Bereichsgrenzwert (UVDFAi) oder der untere Bereichsgrenzwert des meßparameterindividuellen Fehleristwertbereichs (DFAi) in Abhängigkeit der Verteilungsfunktion von Meßparameterwerten (PARi) der fehlerfreien Referenzlötstellen (SJGREF) bestimmt wird.

23. Schaltungsanordnung nach einem der Ansprüche 17 bis 22, **dadurch gekennzeichnet, daß** das Steuerungsprogramm weiterhin in der Weise ausgestaltet ist, daß die Verteilungsfunktion von Meßparameterwerten (PARi) der fehlerfreien Referenzlötstellen eine Normalverteilung ist und daß der obere Bereichsgrenzwert (UVDFAi) oder der untere Bereichsgrenzwert des meßparameterindividuellen Fehleristwertbereichs (DFAi) in Abhängigkeit der Standardat weichung bestimmt wird.

24. Schaltungsanordnung nach einem der Ansprüche 17 bis 23, **dadurch gekennzeichnet, daß** das Steuerungsprogramm weiterhin in der Weise ausgestaltet ist, daß der obere Bereichsgrenzwert (UVDFAi) des meßparameterindividuellen Fehleristwertbereichs (DFAi) auf einen Wert festgesetzt wird, der geringfügig kleiner oder geringfügig größer als der Meßparameterwert einer noch fehlerfreien Referenzlötstelle (SFGREF) ist.

25. Schaltungsanordnung nach einem der Ansprüche 17 bis 24, **dadurch gekennzeichnet, daß** das Steuerungsprogramm weiterhin in der Weise ausgestaltet ist, daß die Lötstelle (SJ) bei der Prüfung als fehlerfrei bewertet wird, sofern der Meßparameterwert mindestens gleich groß oder maximal so groß wie ein vorgebbarer erster meßparameterindividueller Schwellwert (Ti1) ist.

26. Schaltungsanordnung nach Anspruch 25, **dadurch gekennzeichnet, daß** das Steuerungsprogramm weiterhin in der Weise ausgestaltet ist, daß der erste meßparameterindividuelle Schwellwert (Ti1) gleich groß wie der obere Bereichsgrenzwert (UVDFAi) des meßparameterindividuellen Fehleristwertbereichs (DFAi) ist.

27. Schaltungsatiordnung nach einem der Ansprüche 25 oder 26, **dadurch gekennzeichnet, daß** das Steuerungsprogramm weiterhin in der Weise ausgestaltet is, daß die Lötstelle (SJ) bei der Prüfung als fehlerfrei bewertet wird, sofern der Meßparameterwert mindestens gleich oder maximal so groß wie ein vorgebbarer zweiter meßparameterindividueller Schwellwert (Ti2) ist, der um eine meßparameterindividuelle Schwellwertabweichung (ia) kleiner oder größer als der erste meßparameterindividuelle Schwellwert (Ti1) ist.

28. Schaltungsanordnung nach einem der Ansprüche 17 bis 27, **dadurch gekennzeichnet, daß** das Steuerungsprogramm weiterhin in der Weise ausgestaltet ist, daß die Größe einer zulässigen meßparameterindividuellen Schwellwertabweichung (a) eines ersten Meßparameters und/oder die Größen weiterer zulässiger meßparameterindiviueller Schwellwertabweichungen (b, c) weiterer Meßparameter in Abhängigkeit eines vorgebbaren Bezugswerts (CTAREF) einer Kontaktfläche (CTA) bestimmt wird, die zwischen Lötmaterial (SM) und Kontaktelement (PIN) einer zu prüfenden Lötstelle (SJ) gebildet ist.

29. Schaltungsar ordnung Anspruch 27 oder 28, **dadurch gekennzeichnet, daß** das Steuerungsprogramm weiterhin in der Weise ausgestaltet ist, daß die Größe einer zulässigen meßparameterindividuellen Schwellwertabweichung (a) eines ersten Meßparameters und/oder die Größen weiterer zulässiger meßparameteindiviueller Schwellwertabweichungen (b, c) weiterer Meßparameter in Abhängigkeit eines vorgebbaren Bezugswerts (CTAREF) einer mathematischen Verknüpfung der Schwellwertabweichungen (a, b, c), insbesondere einer Produktbildung, einer Mittelwertbildung und/oder einer Summenbildung der Schwellwertabweichungen bestimmt wird.

30. Schaltungsanordnung nach Anspruch 28, **dadurch gekennzeichnet, daß** das Steuerungsprogramm weiterhin in der Weise ausgestaltet ist, daß in Abhängigkeit von Meßparameterwerten erster Meßparameter eine Information gebildet wird, die eine Wahrscheinlichkeit für die Existenz eines galvanischen Kontakts zwischen Lötmaterial (SM) und Kontaktelement (PIN) bezeichnet, und daß mittels Meßparameterwerten zweiter Meßparameter die Größe der Kontaktfläche (CTA) bestimmt wird.

31. Schaltungsanordnung nach einem der Ansprüche 29 oder 30, **dadurch gekennzeichnet**, caß das Steuerungsprogramm weiterhin in der Weise ausgestaltet ist, daß die Größe der Kontaktfläche (CTA) mittels einer Information bestimmt wird, die eine Längenausdehnung (ml) der Lötstelle (SJ, SJREF) und/oder eine Breitenausdehnung (b) der Lötstelle (SJ) und/oder eine Talbreite (v) eines Querschnitts der Lötstelle (SJ) und/oder eine erste Höhendifferenz (hp) zwischen einem Scheitelpunkt (heel) und einem Talpunkt (pad) der Lötstelle und/oder eine zweite Höhendifferenz (phd) zwischen dem Talpunkt (pad) der Lötstelle (SJ) und dem Substrat (BOARD) und/oder ein Gefälle (neg) in einem Randbereich der Lötstelle (SJ) und/oder einen Anstieg (s1) in einem Randbereich der Lötstelle (SJ) und/oder eine Materialmenge (d) in einem vorgebbaren Bereich der Lötstelle (SJ) bezeichnet.

32. Schaltungsanordnung nach einem der Ansprüche 17 bis 31, **dadurch gekennzeichnet, daß** das Steuerungsprogramm weiterhin in der Weise ausgestaltet ist, daß vor der Prüfung der Lötstelle (SJ) durchzuführende Verfahrensschritte zeitlich versetzt durchgeführt werden.

33. Schaltungsanordnung nach einem der Ansprüche 17 bis 32, **dadurch gekennzeichnet, daß** das Steuerungsprogramm weiterhin in der Weise ausgestaltet ist, daß als Ergebnis der Prüfung entweder eine erste Information (INFSJG) gebildet wird, die die Fehlerfreiheit einer geprüften, fehlerfreien Lötstelle (SJ) bezeichnet, und oder eine zweite Information (INFSJB), die ein Nichtvorliegen von Fehlerfreiheit einer geprüften, fehlerhaften Lötstelle (SJ) bezeichnet, und daß die erste Information (TNFSJG) und/oder die zweite Information (INFSJB) zur Steuerung eines Prozesses zur Herstellung von Lötstellen verwendet wird.

## Claims

1. Process of selecting at least one measuring parameter when testing a solder joint (SJ) for freedom from faults by means of X-rays,
where the solder joint (SJ) can be arranged on a substrate (BOARD),
where a fault-free solder joint (SJG) has solder material (SM), and
where the solder material (SM) of a fault-free solder joint (SJG) is electrically connected to a contact element (PIN) of a component (CMP),
where the solder joint (SJ) is assigned to a predefinable solder-joint type as a function of the shape of the contact element (PIN) in the region of the solder joint (SJ),
comprising the following steps:
before the solder joint (SJ) is tested, for a first number (m) of measuring parameters (PARi, i = 1...m), especially grey-value measuring parameters, in each case a lower range limiting value (LVDFAi) and/or an upper range limiting value (UVDFAi) of a fault actual-value range (DFAi) specific to a measuring parameter is determined, a comparatively large fault in the solder joint (SJ) or a comparatively small fault in the solder joint (SJ) corresponding to the lower range limiting value (LVDFAi), a comparatively small fault in the solder joint (SJ) or a comparatively large fault in the solder joint (SJ) corresponding to the upper range limiting value (UVDFAi), the measuring parameters (PARi) in each case describing the topography of a second number (n) of fault-free reference solder joints (SJGREFj, j = 1...n) and/or the internal structure of the n fault-free reference solder joints (SJGREFj), so that m lower range limiting values (LVDFAi) and/or m upper range limiting values (UVDFAi) of fault actual-value ranges (DFAi) specific to measuring a parameter are determined;
before the solder joint (SJ) is tested, for the first number (m) of measuring parameters (PARi), in each case a measuring parameter value (PARiVALSJBREF) specific to a reference solder joint, in particular a grey-value measuring parameter, is ascertained from at least one faulty reference solder joint (SJBREF) of an identical type, so that at least m measuring parameter values (PARiVALSJBREF) specific to reference solder joints are ascertained for the m measuring parameters (PARi) of the at least one faulty reference solder joint (SJBREF) of an identical type;
before the solder joint (SJ) is tested, for the m measuring parameter values (PARiVALSJBREF), specific to a reference solder joint, of the faulty reference solder joints (SJBREF) of an identical type, in each case their mathematical association, especially their difference or ratio, to the lower range limiting value (LVDFAi) and/or to the upper range limiting value (UVDFAi) of the fault actual-value range (DFAi) specific to a measuring parameter is ascertained;
during the testing of the solder joint (SJ), a measuring parameter value (PAR1VALSJ), especially a grey-value measuring parameter value, of at least one first measuring parameter (PAR1) is ascertained, for which the measuring parameter value (PARiVALSJBREF), specific to a reference solder joint, of the at least one faulty reference solder joint (SJBREF) is arranged closest to or furthest from the lower range limiting value (LVDFA1) of the fault actual-value range (DFA1) specific to a measuring parameter, as compared with other fault actual-value ranges (DFA2, ..., DFAm) specific to a measuring parameter, and/or for which the measuring parameter value (PAR1VALSJBREF), specific to a reference solder joint, of the at least one faulty reference solder joint (SJBREF) is arranged furthest from or closest to the upper range limiting value (UVDFA1) of the fault actual-value range (DFA1) specific to a measuring parameter, as compared with other fault actual-value ranges (DFA2, ..., DFAm) specific to a measuring parameter.

2. Process according to claim 1, **characterized in that**, during the testing of the solder joint (SJ), at least one second measuring parameter value (PAR2VALSJ) of a second measuring parameter (PAR2) is ascertained, for which the measuring parameter value (PAR2VALSJBREF) specific to a reference solder joint of the at least one faulty reference solder joint (SJBREF) is arranged second closest to or second furthest from the lower range limiting value (LVDFA2) of the fault actual-value range (DFA2) specific to a measuring parameter, as compared with other fault actual-value ranges (DFA3, ..., DFAm) specific to a measuring parameter, and/or for which the measuring parameter value (PAR2VALSJBREF) specific to a reference solder joint of the at least one faulty reference solder joint (SJBREF) is arranged second furthest from or second closest to the upper range limiting value (UVDFA2) of the fault actual-value range (DFA2) specific to a measuring parameter, as compared with other fault actual-value ranges (DFA3, ..., DFAm) specific to a measuring parameter.

3. Process according to one of the preceding claims, **characterized,**
**in that** before the solder joint (SJ) is tested, measuring parameter values (PARoVALSJBREF) of the first number (m) of measuring parameters (PARi) are ascertained from a third number (o) of faulty reference solder joints (SJBREFp, p = 1...o) of an identical type,
**in that** before the solder joint (SJ) is tested, at least one measuring parameter value (PARiVALAVESJBREF) of the faulty reference solder joints (SJBREF) is derived from the respective o measuring parameter values (PARoVALSJBREF), specific to a reference solder joint, of each measuring parameter (PARi) in accordance with a predefinable algorithm (AL1);
**in that** before the solder joint (SJ) is tested, instead of the mathematical association of the measuring parameter values (PARiVALSJBREF), specific to a reference solder joint, of the faulty reference solder joints (SJBREF) of an identical type to the lower range limiting value (LVDFAi) and/or the upper range limiting value (UVDFAi) of the respective fault actual-value range (DFAi) specific to a measuring parameter, the mathematical association of the derived measuring parameter values (PARiVALAVESJBREF), in particular their difference or ratio, to the lower range limiting value (LVDFAi) and/or to the upper range limiting value (UVDFAi) of the respective fault actual-value range (DFAi) specific to a measuring parameter is determined; and
**in that** during the testing of the solder joint (SJ), instead of the measuring parameter value (PAR1VALSJ), a further measuring parameter value (PARi'VALSJ) of at least one further first measuring parameter (PARi') is ascertained, for which the derived measuring parameter value (PARiVALAVESJBREF) of the third number (o) of the faulty reference solder joints is arranged closest to or furthest from the lower range limiting value (LVDFAi) of the fault actual-value range (DFAi), as compared with other fault actual-value ranges (DFA3, ...DFAm) specific to a measuring parameter, and/or for which the derived measuring parameter value (PARiVALAVESJBREF) of the third number (o) of faulty reference solder joints is arranged furthest from or closest to the upper range limiting value (UVDFAi) of the fault actual-value range (DFAi), as compared with other fault actual-value ranges (DFA3, ..., DFAm) specific to a measuring parameter.

4. Process according to one of the preceding claims, **characterized in that** the lower range limiting value (LVDFAi) or the upper range limiting value of the fault actual-value range (DFAi) specific to a measuring parameter is determined as a function of a measuring parameter value in which the faulty solder joint has an inadequate contact area between solder material and contact element (PIN).

5. Process according to one of the preceding claims, **characterized in that** the upper range limiting value (UVDFAi) or the lower range limiting value (LVDFAi) of the fault actual-value range (DFAi) specific to a measuring parameter is determined as a function of the distribution function of measuring parameter values (PARi) of the fault-free reference solder joints (SJREF).

6. Process according to claim 5, **characterized in that** the distribution function of measuring parameter values (PARi) of the fault-free reference solder joints is a normal distribution, and **in that** the upper range limiting value (UVDFAi) or the lower range limiting value (LVDFAi) of the fault actual-value range (DFAi) specific to a measuring parameter is determined as a function of the standard deviation.

7. Process according to one of claims 1 to 4, **characterized in that** the upper range limiting value (UVDFAi) or the lower range limiting value of the fault actual-value range (DFAi) specific to a measuring parameter is fixed to a value which is slightly smaller or greater than the measuring parameter value of a still fault-free reference solder joint (SFGREF).

8. Process according to one of the preceding claims, **characterized in that** the solder joint (SJ) is judged to be fault-free during the testing if the measuring parameter value is at least as large or at most as large as a predefinable, first threshold value (Ti1) specific to a measuring parameter.

9. Process according to claim 8, **characterized in that** the first threshold value (Ti1) specific to a measuring parameter is of the same size as the upper range limiting value (UVDFAi) of the fault actual-value range (DFAi) specific to a measuring parameter.

10. Process according to either of claims 8 and 9, **characterized in that** the solder joint (SJ) is judged to be fault-free during the testing if the measuring parameter value is at least as large as a predefinable, second threshold value (Ti2) specific to a measuring parameter, which threshold value is smaller or greater, by a threshold value deviation (ia) specific to a measuring parameter, than the first threshold value (Ti1) specific to a measuring parameter.

11. Process according to claim 10, **characterized in that** the magnitude of a permissible threshold value deviation (a), specific to a measuring parameter, of a first measuring parameter, and/or the magnitudes of further permissible threshold value deviations (b, c), specific to a measuring parameter, of further measuring parameters is determined as a function of a predefinable reference value (CTAREF) of a contact area (CTA), which is formed between the solder material (SM) and contact element (PIN) of a solder joint (SJ) to be tested.

12. Process according to claim 10 or 11, **characterized in that** the magnitude of a permissible threshold value deviation (a), specific to a measuring parameter, of a first measuring parameter, and/or the magnitudes of further permissible threshold value deviations (b, c), specific to a measuring parameter, of further measuring parameters is determined as a function of a predefinable reference value (CTAREF) of a mathematical combination of the threshold value deviations (a, b, c), in particular the formation of a product, the formation of an average and/or the formation of a sum of the threshold value deviations.

13. Process according to claim 11, **characterized in that** an item of information which designates the probability of the existence of an electrical contact between the solder material (SM) and contact element (PIN) is formed as a function of measuring parameter values of first measuring parameters, and **in that** the magnitude of the contact area (CTA) is determined by means of measuring parameter values of second measuring parameters.

14. Process according to claim 12 or 13, **characterized in that** the magnitude of the contact area (CTA) is determined by means of an item of information which designates a longitudinal extent (ml) of the solder joint (SJ, SJREF) and/or a width extent (b) of the solder joint (SJ) and/or a valley width (v) of a cross section of the solder joint (SJ) and/or a first height difference (hp) between a vertex point (heel) and a valley point (pad) of the solder joint and/or a second height difference (phd) between the valley point (pad) of the solder joint (SJ) and the substrate (BOARD) and/or a fall (neg) in an edge region of the solder joint (SJ) and/or a rise (sl) in an edge region of the solder joint (SJ) and/or a quantity of material (d) in a predefinable region of the solder joint (SJ).

15. Process according to one of the preceding claims, **characterized in that** process steps to be carried out before the solder joint (SJ) is tested are carried out with a time offset.

16. Process according to one of the preceding claims, **characterized in that** as a result of the test, either a first item of information (INFSJG) is formed, which designates the freedom from faults of a tested, fault-free solder joint (SJ), and/or a second item of information (INFSJB), which designates the absence of freedom from faults of a tested, faulty solder joint (SJ), and **in that** the first item of information (INFSJG) and/or the second item of information (INFSJB) are used to control a process for producing solder joints.

17. Circuit arrangement (SJTD) for selecting at least one measuring parameter when testing a solder joint (SJ) for freedom from faults by means of X-rays,
where the circuit arrangement has a data processing device (C) with an associated control program,
where the solder joint (SJ) can be arranged on a substrate (BOARD),
where a fault-free solder joint (SJG) has solder material (SM), and
where the solder material (SM) of a fault-free solder joint (SJG) is connected electrically to a contact element (PIN) of a component (CMP),
where the solder joint (SJ) is assigned to a predefinable solder-joint type as a function of the shape of the contact element (PIN) in the region of the solder joint (SJ),
wherein the control program defines the Process according to one of the preceding claims.

18. Circuit arrangement according to claim 17,
wherein the control program is configured in such a way
that before the solder joint (SJ) is tested, for a first number (m) of measuring parameters (PARi, i = 1...m), especially grey-value measuring parameters, in each case a lower range limiting value (LVDFAi) and/or an upper range limiting value (UVDFAi) of a fault actual-value range (DFAi) specific to a measuring parameter is determined, a comparatively large fault in the solder joint (SJ) or a comparatively small fault in the solder joint (SJ) corresponding to the lower range limiting value (LVDFAi), a comparatively small fault in the solder joint (SJ) or a comparatively large fault in the solder joint (SJ) corresponding to the upper range limiting value (UVDFAi), the measuring parameters (PARi) in each case describing the topography of a second number (n) of fault-free reference solder joints (SJGREFj, j = 1...n) and/or the internal structure of the n fault-free reference solder joints (SJGREFj), so that m lower range limiting values (LVDFAi) and/or m upper range limiting values (UVDFAi) of fault actual-value ranges (DFAi) specific to measuring a parameter are determined;
that before the solder joint (SJ) is tested, for the first number (m) of measuring parameters (PARi), in each case a measuring parameter value (PARiVALSJBREF) specific to a reference solder joint, in particular a grey-value measuring parameter, is ascertained from at least one faulty reference solder joint (SJBREF) of an identical type, so that at least m measuring parameter values (PARiVALSJBREF) specific to reference solder joints are ascertained for the m measuring parameters (PARi) of the at least one faulty reference solder joint (SJBREF) of an identical type;
that before the solder joint (SJ) is tested, for the m measuring parameter values (PARiVALSJBREF), specific to a reference solder joint, of the faulty reference solder joints (SJBREF) of an identical type, in each case their mathematical association, especially their difference or ratio, to the lower range limiting value (LVDFAi) and/or to the upper range limiting value (UVDFAi) of the fault actual-value range (DFAi) specific to a measuring parameter is ascertained;
that during the testing of the solder joint (SJ), a measuring parameter value (PAR1VALSJ), especially a grey-value measuring parameter value, of at least one first measuring parameter (PAR1) is ascertained, for which the measuring parameter value (PAR1VALSJBREF), specific to a reference solder joint, of the at least one faulty reference solder joint (SJBREF) is arranged closest to or furthest from the lower range limiting value (LVDFA1) of the fault actual-value range (DFA1) specific to a measuring parameter, as compared with other fault actual-value ranges (DFA2, ..., DFAm) specific to a measuring parameter, and/or for which the measuring parameter value (PAR1VALSJBREF), specific to a reference solder joint, of the at least one faulty reference solder joint (SJBREF) is arranged furthest from or closest to the upper range limiting value (UVDFA1) of the fault actual-value range (DFA1) specific to a measuring parameter, as compared with other fault actual-value ranges (DFA2, ..., DFAm) specific to a measuring parameter.

19. Circuit arrangement according to claim 17 or 18, **characterized in that** the control program is configured in such a way that
during the testing of the solder joint (SJ), at least one second measuring parameter value (PAR2VALSJ) of a second measuring parameter (PAR2) is ascertained, for which the measuring parameter value (PAR2VALSJBREF) specific to a reference solder joint of the at least one faulty reference solder joint (SJBREF) is arranged second closest to or second furthest from the lower range limiting value (LVDFA2) of the fault actual-value range (DFA2) specific to a measuring parameter, as compared with other fault actual-value ranges (DFA3, ..., DFAm) specific to a measuring parameter, and/or for which the measuring parameter value (PAR2VALSJBREF) specific to a reference solder joint of the at least one faulty reference solder joint (SJBREF) is arranged second furthest from or second closest to the upper range limiting value (UVDFA2) of the fault actual-value range (DFA2) specific to a measuring parameter, as compared with other fault actual-value ranges (DFA3, ..., DFAm) specific to a measuring parameter.

20. Circuit arrangement according to one of claims 17 to 19, **characterized in that** the control program is configured in such a way
that before the solder joint (SJ) is tested, measuring parameter values (PARoVALSJBREF) of the first number (m) of measuring parameters (PARi) are ascertained from a third number (o) of faulty reference solder joints (SJBREFp, p = 1...o) of an identical type,
that before the solder joint (SJ) is tested, at least one measuring parameter value (PARiVALAVESJBREF) of the faulty reference solder joints (SJBREF) is derived from the respective o measuring parameter values (PARoVALSJBREF), specific to a reference solder joint, of each measuring parameter (PARi) in accordance with a predefinable algorithm (AL1);
that before the solder joint (SJ) is tested, instead of the mathematical association of the measuring parameter values (PARiVALSJBREF), specific to a reference solder joint, of the faulty reference solder joints (SJBREF) of an identical type to the lower range limiting value (LVDFAi) and/or the upper range limiting value (UVDFAi) of the respective fault actual-value range (DFAi) specific to a measuring parameter, the mathematical association of the derived measuring parameter values (PARiVALAVESJBREF), in particular their difference or ratio, to the lower range limiting value (LVDFAi) and/or to the upper range limiting value (UVDFAi) of the respective fault actual-value range (DFAi) specific to a measuring parameter is determined; and
that during the testing of the solder joint (SJ), instead of the measuring parameter value (PAR1VALSJ), a further measuring parameter value (PARi'VALSJ) of at least one further first measuring parameter (PARi') is ascertained, for which the derived measuring parameter value (PARiVALAVESJBREF) of the third number (o) of the faulty reference solder joints is arranged closest to or furthest from the lower range limiting value (LVDFAi) of the fault actual-value range (DFAi), as compared with other fault actual-value ranges (DFA3, ...DFAm) specific to a measuring parameter, and/or for which the derived measuring parameter value (PARiVALAVESJBREF) of the third number (o) of faulty reference solder joints is arranged furthest from or closest to the upper range limiting value (UVDFAi) of the fault actual-value range (DFAi), as compared with other fault actual-value ranges (DFA3, ..., DFAm) specific to a measuring parameter.

21. Circuit arrangement according to one of claims 17 to 20, **characterized in that** the control program is configured in such a way that the lower range limiting value (LVDFAi) or the upper range limiting value of the fault actual-value range (DFAi) specific to a measuring parameter is determined as a function of a measuring parameter value in which the faulty solder joint has an inadequate contact area between solder material and contact element (PIN).

22. Circuit arrangement according to one of claims 17 to 21, **characterized in that** the control program is configured in such a way that the upper range limiting value (UVDFAi) or the lower range limiting value of the fault actual-value range (DFAi) specific to a measuring parameter is determined as a function of the distribution function of measuring parameter values (PARi) of the fault-free reference solder joints (SJGREF).

23. Circuit arrangement according to one of the claims 17 to 22, **characterized in that** the control program is configured in such a way that the distribution function of measuring parameter values (PARi) of the fault-free reference solder joints is a normal distribution, and **in that** the upper range limiting value (UVDFAi) or the lower range limiting value of the fault actual-value range (DFAi) specific to a measuring parameter is determined as a function of the standard deviation.

24. Circuit arrangement according to one of claims 17 to 23, **characterized in that** the control program is configured in such a way that the upper range limiting value (UVDFAi) or the lower range limiting value of the fault actual-value range (DFAi) specific to a measuring parameter is fixed to a value which is slightly smaller or greater than the measuring parameter value of a still fault-free reference solder joint (SFGREF).

25. Circuit arrangement according to one of claims 17 to 24, **characterized in that** the control program is configured in such a way that the solder joint (SJ) is judged to be fault-free during the testing if the measuring parameter value is at least as large or at most as large as a predefinable, first threshold value (Ti1) specific to a measuring parameter.

26. Circuit arrangement according to claim 25, **characterized in that** the control program is configured in such a way that the first threshold value (Ti1) specific to a measuring parameter is of the same size as the upper range limiting value (UVDFAi) of the fault actual-value range (DFAi) specific to a measuring parameter.

27. Circuit arrangement according to either of claims 25 and 26, **characterized in that** the control program is configured in such a way that the solder joint (SJ) is judged to be fault-free during the testing if the measuring parameter value is at least as large as a predefinable, second threshold value (Ti2) specific to a measuring parameter, which threshold value is smaller or greater, by a threshold value deviation (ia) specific to a measuring parameter, than the first threshold value (Ti1) specific to a measuring parameter.

28. Circuit arrangement according to either of claims 17 and 27, **characterized in that** the control program is configured in such a way that the magnitude of a permissible threshold value deviation (a), specific to a measuring parameter, of a first measuring parameter, and/or the magnitudes of further permissible threshold value deviations (b, c), specific to a measuring parameter, of further measuring parameters is determined as a function of a predefinable reference value (CTAREF) of a contact area (CTA), which is formed between the solder material (SM) and contact element (PIN) of a solder joint (SJ) to be tested.

29. Circuit arrangement according to claim 27 or 28, **characterized in that** the control program is configured in such a way that the magnitude of a permissible threshold value deviation (a), specific to a measuring parameter, of a first measuring parameter, and/or the magnitudes of further permissible threshold value deviations (b, c), specific to a measuring parameter, of further measuring parameters is determined as a function of a predefinable reference value (CTAREF) of a mathematical combination of the threshold value deviations (a, b, c), in particular the formation of a product, the formation of an average and/or the formation of a sum of the threshold value deviations.

30. Circuit arrangement according to claim 28, **characterized in that** the control program is configured in such a way that an item of information which designates the probability of the existence of an electrical contact between the solder material (SM) and contact element (PIN) is formed as a function of measuring parameter values of first measuring parameters, and **in that** the magnitude of the contact area (CTA) is determined by means of measuring parameter values of second measuring parameters.

31. Circuit arrangement according to claim 29 or 30, **characterized in that** the control program is configured in such a way that the magnitude of the contact area (CTA) is determined by means of an item of information which designates a longitudinal extent (ml) of the solder joint (SJ, SJREF) and/or a width extent (b) of the solder joint (SJ) and/or a valley width (v) of a cross section of the solder joint (SJ) and/or a first height difference (hp) between a vertex point (heel) and a valley point (pad) of the solder joint and/or a second height difference (phd) between the valley point (pad) of the solder joint (SJ) and the substrate (BOARD) and/or a fall (neg) in an edge region of the solder joint (SJ) and/or a rise (sl) in an edge region of the solder joint (SJ) and/or a quantity of material (d) in a predefinable region of the solder joint (SJ).

32. Circuit arrangement according to one of claims 17 to 31, **characterized in that** the control program is configured in such a way that process steps to be carried out before the solder joint (SJ) is tested are carried out with a time offset.

33. Circuit arrangement according to one of claims 17 to 32, **characterized in that** the control program is configured in such a way that as a result of the test, either a first item of information (INFSJG) is formed, which designates the freedom from faults of a tested, fault-free solder joint (SJ), and/or a second item of information (INFSJB), which designates the absence of freedom from faults of a tested, faulty solder joint (SJ), and **in that** the first item of information (INFSJG) and/or the second item of information (INFSJB) are used to control a process for producing solder joints.

## Revendications

1. Procédé de sélection d'au moins un paramètre de mesure lors du contrôle de l'absence de défaut dans une brasure (SJ) à l'aide de rayons X,
la brasure (SJ) pouvant être disposée sur un substrat (BOARD),
une brasure sans défaut (SJG) présentant de l'agent à braser (SM) et
l'agent à braser (SM) d'une brasure sans défaut (SJG) étant connecté électriquement à un élément de contact (PIN) d'un composant (CMP),
la brasure (SJ) étant assignée à un type de brasure définissable préalablement en fonction de la forme de l'élément de contact (PIN) dans la zone de la brasure (SJ),
comprenant les étapes suivantes :
avant le contrôle de la brasure (SJ), pour un premier nombre (m) de paramètres de mesure (PARi, i = 1...m), en particulier des paramètres de mesure de valeur de gris, on détermine chaque fois une valeur limite inférieure d'intervalle (LVDFAi) et/ou une valeur limite supérieure d'intervalle (UVDFAi) d'un intervalle de valeurs effectives de défaut (DFAi) spécifique du paramètre de mesure, un défaut comparativement gros de la brasure (SJ) ou un défaut comparativement petit de la brasure (SJ) correspondant à la valeur limite inférieure d'intervalle (LVDFAi), un défaut comparativement petit de la brasure (SJ) ou un défaut comparativement gros de la brasure (SJ) correspondant à la valeur limite supérieure de l'intervalle (UVDFAi), les paramètres de mesure (PARi) décrivant chaque fois la topographie d'un second nombre (n) de brasures sans défaut de référence (SJGREFj, j = 1...n) et/ou la structure interne des brasures sans défaut de référence (SJGREFj), de façon à déterminer m valeurs limites inférieures d'intervalle (LVDFAi) et/ou m valeurs limites supérieures d'intervalle (UVDFAi) d'intervalles de valeurs effectives de défaut (DFAi) spécifiques du paramètre de mesure ;
avant le contrôle de la brasure (SJ), on calcule chaque fois, à partir d'au moins une brasure défectueuse de référence (SJBREF) de type identique, pour le premier nombre (m) des paramètres de mesure (PARi), une valeur de paramètre de mesure (PARiVALSJBREF) spécifique d'une brasure de référence, en particulier une valeur de paramètre de mesure de valeur de gris, de façon à déterminer au moins m valeurs de paramètre de mesure spécifique de la brasure de référence (PARiVALSJBREF) pour les m paramètres de mesure (PARi) de brasure défectueuse de référence (SJBREF), au moins une, de type identique;
avant le contrôle de la brasure (SJ), on calcule chaque fois, pour les m valeurs de paramètre de mesure spécifique de brasure de référence (PARiVALSJbrEF) des brasures défectueuse de référence (SJBREF) de type identique, leur correspondance mathématique, en particulier leur différence ou rapport, à la valeur limite inférieure d'intervalle (LVDFAi) et/ou la valeur limite supérieure d'intervalle (UVDFAi) de l'intervalle de valeurs effectives de défaut (DFAi) spécifique du paramètre de mesure ;
lors du contrôle de la brasure (SJ), on calcule une valeur de paramètre de mesure (PAR1VALSJ), en particulier une valeur de paramètre de valeur de gris, au moins d'un premier paramètre de mesure (PAR1), pour laquelle la valeur de paramètre de mesure (PAR1VALSJBREF) spécifique de brasure de référence de la brasure défectueuse de référence (SJBREF), au moins une, se trouve le plus près ou le plus loin de la valeur limite inférieure d'intervalle (LVDFA1) de l'intervalle de valeurs effectives de défaut (DFA1) spécifique du paramètre de mesure par comparaison à d'autres intervalles de valeurs effectives de défaut (DFA2, ..., DFAm) spécifiques du paramètre de mesure, et/au pour laquelle la valeur de paramètre de mesure (PAR1VALSJBREF) spécifique du paramètre de mesure de la brasure défectueuse de référence (SJBREF), au moins une, se trouve le plus loin ou le plus près de la valeur limite supérieure d'intervalle (UVDFA1) de l'intervalle de valeurs effectives de défaut (DFA1) spécifique du paramètre de mesure par comparaison à d'autres intervalles de valeurs effectives de défaut (DFA2, ..., DFAm) spécifiques du paramètre de mesure.

2. Procédé selon la revendication 1, **caractérisé en ce que** lors du contrôle de la brasure (SJ), on calcule au moins une deuxième valeur de paramètre de mesure (PAR2VALSJ) d'un deuxième paramètre de mesure (PAR2), pour laquelle la valeur de paramètre de mesure (PAR2VALSJBREF) spécifique de brasure de référence de la brasure défectueuse de référence (SJBREF), au moins une, est la deuxième la plus proche ou la deuxième la plus éloignée de la valeur limite inférieure d'intervalle (LVDFA2) de l'intervalle de valeurs effectives de défaut (DFA2) spécifique du paramètre de mesure, par comparaison à d'autres intervalles de valeurs effectives de défaut (DFA3, ..., DFAm) spécifiques du paramètre de mesure, et/ou pour laquelle la valeur de paramètre de mesure (PAR2VALSJBREF) spécifique de la brasure de référence de la brasure défectueuse de référence (SJBREF), au moins une, est la deuxième la plus éloignée ou la deuxième la plus proche de la valeur limite supérieure d'intervalle (UVDFA2) de l'intervalle des valeurs effectives de défaut (DFA2) spécifique du paramètre de mesure par comparaison à d'autres intervalles de valeurs effectives de défaut (DFA3, ..., DFAm) spécifique du paramètre de mesure.

3. Procédé selon l'une des revendications qui précèdent, **caractérisé**
**en ce qu'**avant le contrôle de la brasure (SJ), on calcule à partir d'un troisième nombre (o) de brasures défectueuses de référence (SJBREFp, p = 1...o) de même type, des valeurs de paramètre de mesure (PARoVALSJBREF) spécifiques de brasure de référence du premier nombre (m) des paramètres de mesure (PARi),
**en ce qu'**avant le contrôle de la brasure (SJ), on déduit des valeurs de paramètre de mesure (PARoVALSJBREF) spécifiques de o brasures de référence présentées par chaque paramètre de mesure (PARi), au moins une valeur de paramètre de mesure (PARiVAL AVESJBREF) des brasures défectueuses de référence (SJBREF) selon un algorithme (AL1) définissable préalablement ;
**en ce qu'**avant le contrôle de la brasure (SJ), au lieu de déterminer la correspondance mathématique des valeurs de paramètres de mesure (PARiVALSJBREF) spécifiques de la brasure de référence des brasures défectueuses de référence (SJBREF) de même type, à la valeur limite inférieure d'intervalle (LVDFAi) et/ou à la valeur limite supérieure d'intervalle (UVDFAi) de l'intervalle de valeurs effectives de défaut (DFAi) concerné spécifique du paramètre de mesure, on détermine la correspondance mathématique des valeurs de paramètre (PARiVALAVESJBREF) déduites, en particulier leur différence ou rapport, à la valeur limite inférieure d'intervalle (LVDFAi) et/ou à la valeur limite supérieure d'intervalle (UVDFAi) de l'intervalle de valeurs effectives de défaut (DFAi) concerné, spécifique du paramètre de mesure; et
**en ce qu'**on calcule, au moment du contrôle de la brasure (SJ), au lieu de la valeur de paramètre de mesure (PAR1VALSJ), une autre valeur de paramètre de mesure (PARi'VALSJ) d'au moins un autre premier paramètre de mesure (PARi'), pour laquelle la valeur de paramètre de mesure déduite (PARiVAIVESJBREF) du troisième nombre (o) des brasures défectueuses de référence est la plus proche ou la plus éloignée de la valeur limite inférieure d'intervalle (LVDFAi) de l'intervalle de valeurs effectives de défaut (DFAi) par comparaison à d'autres intervalles de valeurs effectives de défaut (DFA3, ..., DFAm) spécifiques du paramètre de mesure, et/ou pour laquelle la valeur déduite de paramètre de mesure (PARiVALAVSJBREF) du troisième nombre (o) des brasures défectueuses de référence est la plus éloignée ou la plus proche de la valeur limite supérieure d'intervalle (UVDFAi) de l'intervalle de valeurs effectives de défaut (DFAi) par comparaison à d'autres intervalles de valeurs effectives de défaut (DFA3, ..., DFAm).

4. Procédé selon l'une des revendications qui précèdent, **caractérisé en ce que** la valeur limite inférieure d'intervalle (LVDFAi) ou la valeur limite supérieure d'intervalle de l'intervalle de valeurs effectives de défaut (DFAi) spécifique du paramètre de mesure est déterminée en fonction d'une valeur de paramètre de mesure dans le cas de laquelle la brasure défectueuse présente une surface de contact insuffisante entre l'agent de brasage et l'élément de contact (PIN).

5. Procédé selon l'une des revendications qui précèdent, **caractérisé en ce qu'**on détermine la valeur limite supérieure d'intervalle (UVDFAi) ou la valeur limite inférieure d'intervalle (LVDFAi) de l'intervalle de valeurs effectives de défaut (DFAi) spécifique du paramètre de mesure dépendamment de la fonction de distribution de valeurs de paramètres de mesure (PARi) des brasures de référence sans défaut (SJGREF).

6. Procédé selon la revendication 5, **caractérisé en ce que** la fonction de distribution de valeurs de paramètre de mesure (PARi) des brasures de référence sans défaut est une distribution normale et **en ce que** la valeur limite supérieure d'intervalle (UVDFAi) ou la valeur limite inférieure d'intervalle (LVDFAi) de l'intervalle de valeurs effectives de défaut (DFAi) spécifique du paramètre de mesure est déterminée en fonction de l'écart-type.

7. Procédé selon l'une des revendications 1 à 4, **caractérisé en ce que** la valeur limite supérieure d'intervalle (UVDFAi) ou la valeur limite inférieure d'intervalle de l'intervalle de valeurs effectives de défaut (DFAi) spécifique du paramètre de mesure est fixée à une valeur qui est légèrement inférieure ou supérieure à la valeur du paramètre de mesure d'une brasure de référence encore sans défaut (SFGREF).

8. Procédé selon l'une des revendications qui précèdent, **caractérisé en ce que** la brasure (SJ) est estimée non-défectueuse lors du contrôle si la valeur du paramètre de mesure est au minimum aussi grande ou au maximum aussi grande qu'une première valeur seuil définissable préalablement (Ti1) spécifique du paramètre de mesure.

9. Procédé selon la revendication 8, **caractérisé en ce que** la première valeur seuil (Ti1) spécifique du paramètre de mesure est aussi grande que la valeur limite supérieure d'intervalle (UVDFAi) de l'intervalle de valeurs effectives de défaut (DFAi) spécifique du paramètre de mesure.

10. Procédé selon l'une des revendications 8 ou 9, **caractérisé en ce que** la brasure (SJ) est estimée non-défectueuse lors du contrôle si la valeur du paramètre de mesure est au moins aussi grande qu'une deuxième valeur seuil (Ti2) définissable préalablement, spécifique du paramètre de mesure, qui est inférieure d'un écart (ia) de la valeur seuil spécifique du paramètre de mesure ou plus grande que la première valeur seuil (Ti1) spécifique du paramètre de mesure.

11. Procédé selon la revendication 10, **caractérisé en ce que** la grandeur d'un écart admissible (a) de la valeur seuil spécifique du paramètre de mesure d'un premier paramètre de mesure et/ou les grandeurs d'autres écarts admissibles (b, c) de la valeur seuil spécifique du paramètre de mesure présentés par d'autres paramètres de mesure est déterminée en fonction d'une valeur de référence (CTAREF) définissable préalablement (CTAREF) d'une surface de contact (CTA), qui est formée entre l'agent de brasage (SM) et l'élément de contact (PIN) d'une brasure (SJ) à contrôler.

12. Procédé selon la revendication 10 ou 11, **caractérisé en ce que** la grandeur d'un écart admissible (a) de la valeur seuil spécifique du paramètre de mesure présenté par un premier paramètre et/ou les grandeurs d'autres écarts admissibles (b, c) de la valeur seuil spécifique du paramètre de mesure présentés par d'autres paramètres de mesure sont déterminées en fonction d'une valeur de référence (CTAREF) définissable préalablement d'une combinaison mathématique des écarts de la valeur seuil (a, b, c), en particulier d'une formation de produit, d'une formation de moyenne et/ou d'une formation de somme des écarts de la valeur seuil.

13. Procédé selon la revendication 11, **caractérisé en ce qu'**en fonction de valeurs de paramètres de mesure de premiers paramètres de mesure, on génère une première information signifiant une probabilité d'existence d'un contact électrique entre l'agent de brasage (SM) et l'élément de contact (PIN), et **en ce qu'**à l'aide de valeurs de paramètre de mesure de deuxièmes paramètres de mesure, on détermine la grandeur de la surface de contact (CTA).

14. Procédé selon la revendication 12 ou 13, **caractérisé en ce que** la grandeur de la surface de contact (CTA) est déterminée au moyen d'une information identifiant une étendue en longueur (ml) de la brasure (SJ, SJREF) et/ou une étendue en largeur (b) de la brasure (SJ) et/ou une largeur de vallée (v) d'une section transversale de la brasure (SJ) et/ou d'une première dénivellation (hp) entre un point de sommet (heel) et un point de creux (pad) de la brasure et/ou une seconde dénivellation (phd) entre le point de sommet (heel) de la brasure (SJ) et le substrat (BOARD) etou un abaissement (neg) dans une zone marginale de la brasure (SJ) et/ou un relèvement (sl) dans une zone marginale de la brasure (SJ) et/ou un mélange de matières (d) dans une zone de la brasure (SJ) définissable préalablement.

15. Procédé selon l'une des revendications qui précèdent, **caractérisé en ce que** des opérations à effectuer avant le contrôle de la brasure (SJ) sont effectuées avec un décalage dans le temps.

16. Procédé selon l'une des revendications qui précèdent, **caractérisé en ce que** comme résultat du contrôle, on génère soit une première information (INFSJG) signifiant l'absence de défaut dans une brasure (SJ) sans défaut contrôlée, et/ou une seconde information (INFSJB) signifiant un défaut dans une brasure défectueuse contrôlée (SJ), et **en ce que** la première information (INFSJG) et/ou la seconde information (INFSJB) sont utilisées pour la commande d'un procédé de restauration de brasures.

17. Configuration de circuit (SJTD) pour la sélection d'au moins un paramètre de mesure, lors du contrôle de l'absence de défaut dans une brasure (SJ) par rayons X,
la configuration de circuit présentant un dispositif de traitement de données (C) avec un programme de commande associé,
la brasure (SJ) pouvant être disposée sur un substrat (BOARD),
une brasure (SJG) sans défaut présentant un agent à braser (SM), et
l'agent à braser (SM) d'une brasure sans défaut (SJG) étant connecté électriquement à un élément de contact (PIN) d'un composant (CMP),
la brasure (SJ) étant attribuée à un type de brasure définissable préalablement, en fonction de la forme de l'élément de contact (PIN) dans la zone de la brasure (SJ),
**caractérisée en ce que** le programme de commande définit le procédé selon l'une des revendications qui précédent.

18. Configuration de circuit selon la revendication 17, **caractérisée en ce que** le programme de commande est architecturé de façon que :
avant le contrôle de la brasure (SJ), on détermine avant le contrôle de la brasure (SJ), pour un premier nombre (m) de paramètres de mesure (PARi, i = 1...m), en particulier des paramètres de mesure de valeur de gris, on détermine chaque fois une valeur limite inférieure d'intervalle (LVDFAi) et/ou une valeur limite supérieure d'intervalle (UVDFAi) d'un intervalle de valeurs effectives de défaut (DFAi) spécifique du paramètre de mesure, un défaut comparativement gros de la brasure (SJ) ou un défaut comparativement petit de la brasure (SJ) correspondant à la valeur limite inférieure d'intervalle (LVDFAi), un défaut comparativement petit de la brasure (SJ) ou un défaut comparativement gros de la brasure (SJ) correspondant à la valeur limite supérieure de l'intervalle (UVDFAi), les paramètres de mesure (PARi) décrivant chaque fois la topographie d'un second nombre (n) de brasures sans défaut de référence (SJGREFj, j = 1...n) et/ou la structure interne des brasures sans défaut de référence (SJGREFj), de façon à déterminer m valeurs limites inférieures d'intervalle (LVDFAi) et/ou m valeurs limites supérieures d'intervalle (UVDFAi) d'intervalles de valeurs effectives de défaut (DFAi) spécifiques du paramètre de mesure ;
avant le contrôle de la brasure (SJ), on calcule chaque fois, à partir d'au moins une brasure défectueuse de référence (SJBREF) de type identique, pour le premier nombre (m) des paramètres de mesure (PARi), une valeur de paramètre de mesure (PARiVALSJBREF) spécifique d'une brasure de référence, en particulier une valeur de paramètre de mesure de valeur de gris, de façon à déterminer au moins m valeurs de paramètre de mesure spécifique de brasure de référence (PARiVALSJBREF) pour les m paramètres de mesure (PARi) de brasure défectueuse de référence (SJBREF), au moins une, de type identique;
avant le contrôle de la brasure (SJ), on calcule chaque fois, pour les m valeurs de paramètre de mesure spécifique de brasure de référence (PARiVALSJBREF) des brasures défectueuse de référence (SJBREF) de type identique, leur correspondance mathématique, en particulier leur différence ou rapport, à la valeur limite inférieure d'intervalle (LVDFAi) et/ou la valeur limite supérieure d'intervalle (UVDFAi) de l'intervalle de valeurs effectives de défaut (DFAi) spécifique du paramètre de mesure ;
lors du contrôle de la brasure (SJ), on calcule une valeur de paramètre de mesure (PAR1VALSJ), en particulier une valeur de paramètre de valeur de gris, au moins d'un premier paramètre de mesure (PAR1), pour laquelle la valeur de paramètre de mesure (PAR1VALSJBREF) spécifique de brasure de référence de la brasure défectueuse de référence (SJBREF), au moins une, se trouve le plus près ou le plus loin de la valeur limite inférieure d'intervalle (LVDFA1) de l'intervalle de valeurs effectives de défaut (DFA1) spécifique du paramètre de mesure par comparaison à d'autres intervalles de valeurs effectives de défaut (DFA2, ..., DFAm) spécifiques du paramètre de mesure, et/ou pour laquelle la valeur de paramètre de mesure (PAR1VALSJBREF) spécifique du paramètre de mesure de la brasure défectueuse de référence (SJBREF), au moins une, se trouve le plus loin ou le plus près de la valeur limite supérieure d'intervalle (UVDFA1) de l'intervalle de valeurs effectives de défaut (DFA1) spécifique du paramètre de mesure par comparaison à d'autres intervalles de valeurs effectives de défaut (DFA2, ..., DFAm) spécifiques du paramètre de mesure.

19. Configuration de circuit selon la revendication 17 ou 18, **caractérisée en ce que** le programme de commande est architecturé, en outre, de façon à ce que lors du contrôle de la brasure (SJ), on calcule au moins une deuxième valeur de paramètre de mesure (PAR2VALSJ) d'un deuxième paramètre de mesure (PAR2), pour laquelle la valeur de paramètre de mesure (PAR2VALSJBREF) spécifique de brasure de référence de la brasure défectueuse de référence (SJBREF), au moins une, qui est la deuxième la plus proche ou la deuxième la plus éloignée de la valeur limite inférieure d'intervalle (LVDFA2) de l'intervalle de valeurs effectives de défaut (DFA2) spécifique du paramètre de mesure, par comparaison à d'autres intervalles de valeurs effectives de défaut (DFA3, ..., DFAm) spécifiques du paramètre de mesure, et/ou pour laquelle la valeur de paramètre de mesure (PAR2VALSJBREF) spécifique de la brasure de référence de la brasure défectueuse de référence (SJBREF), au moins une, est la deuxième la plus éloignée ou la deuxième la plus proche de la valeur limite supérieure d'intervalle (UVDFA2) de l'intervalle des valeurs effectives de défaut (DFA2) spécifique du paramètre de mesure par comparaison à d'autres intervalles de valeurs effectives de défaut (DFA3, ..., DFAm) spécifiques du paramètre de mesure.

20. Configuration de circuit selon l'une des revendications 17 à 19, **caractérisée en ce que** le programme de commande est encore architecturé de façon
qu'avant le contrôle de la brasure (SJ), on calcule à partir d'un troisième nombre (o) de brasures défectueuses de référence (SJBREFp, p = 1...o) de même type, des valeurs de paramètres de mesure (PARoVALSJBREF) du premier nombre (m) des paramètres de mesure (PARi),
**en ce qu'**avant le contrôle de la brasure (SJ), on déduit des valeurs de paramètre de mesure (PARoVALSJBREF) spécifiques de o brasures de référence présentées par chaque paramètre de mesure (PARi), au moins une valeur de paramètre de mesure (PARiVAL AVESJBREF) des brasures défectueuses de référence (SJBREF) selon un algorithme (AL1) définissable préalablement ;
**en ce qu'**avant le contrôle de la brasure (SJ), au lieu de déterminer la correspondance mathématique des valeurs de paramètres de mesure (PARiVALSJBREF) spécifiques de la brasure de référence des brasures défectueuses de référence (SJBREF) de même type à la valeur limite inférieure d'intervalle (LVDFAi) et/ou à la valeur limite supérieure d'intervalle (UVDFAi) de l'intervalle de valeurs effectives de défaut (DFAi) spécifique du paramètre de mesure concerné, on détermine la correspondance mathématique des valeurs de paramètre (PARiVALAVESJBREF) déduites, en particulier leur différence ou rapport, à la valeur limite inférieure d'intervalle (LVDFAi) et/ou à la valeur limite supérieure d'intervalle (UVDFAi) de l'intervalle de valeurs effectives de défaut (DFAi) spécifique du paramètre de mesure pris en considération ; et
**en ce qu'**on calcule, au moment du contrôle de la brasure (SJ), au lieu de la valeur de paramètre de mesure (PAR1VALSJ), une autre valeur de paramètre de mesure (PARi'VALSJ) d'au moins un autre premier paramètre de mesure (PARi'), pour laquelle la valeur de paramètre de mesure déduite (PARiVAIAVESJBREF) du troisième nombre (o) des brasures défectueuses de référence est la plus proche ou la plus éloignée de la valeur limite inférieure d'intervalle (LVDFAi) de l'intervalle de valeurs effectives de défaut (DFAi) par comparaison à d'autres intervalles de valeurs effectives de défaut (DFA3, ..., DFAm) spécifiques du paramètre de mesure et/ou pour laquelle la valeur de paramètre de mesure déduite (PARiVALAVESJBREF) du troisième nombre (o) des brasures défectueuses de référence est la plus éloignée ou la plus proche de la valeur limite supérieure d'intervalle (UVDFAi) de l'intervalle de valeurs effectives de défaut (DFAi) par comparaison à d'autres intervalles de valeurs effectives de défaut (DFA3, ..., DFAm) spécifiques du paramètre de mesure.

21. Configuration de circuit selon l'une des revendications 17 à 20, **caractérisée en ce que** le programme de commande est architecturé en outre de façon à ce que la valeur limite inférieure d'intervalle (LVDFAi) ou la valeur limite supérieure d'intervalle de l'intervalle de valeurs effectives de défaut (DFAi) spécifique du paramètre de mesure est déterminée en fonction d'une valeur de paramètre de mesure dans le cas de laquelle la brasure défectueuse présente une surface de contact insuffisante entre l'agent de brasage et l'élément de contact (PIN).

22. Configuration de circuit selon l'une des revendications 17 à 21, **caractérisée en ce qu'**on détermine la valeur limite supérieure d'intervalle ou valeur limite supérieure d'intervalle (UVDFAi) de l'intervalle de valeurs effectives de défaut (DFAi) spécifique du paramètre de mesure dépendamment de la fonction de distribution de valeurs de paramètres de mesure (PARi) des brasures de référence sans défaut (SIGREF).

23. Configuration de circuit selon l'une des revendications 17 à 22, **caractérisée en ce que** le programme de commande est encore architecturé de manière à ce que la fonction de distribution de valeurs de paramètre de mesure (PARi) des brasures de référence sans défaut soit une distribution normale et **en ce que** la valeur limite supérieure d'intervalle (UVDFAi) ou la valeur limite inférieure d'intervalle de l'intervalle de valeurs effectives de défaut (DFAi) spécifique du paramètre de mesure est déterminée en fonction de l'écart-type.

24. Configuration de circuit selon l'une des revendications 17 à 23, **caractérisée en ce que** le programme de commande est encore architecturé de manière à ce que la valeur limite supérieure d'intervalle (UVDFAi) de l'intervalle des valeurs effectives de défaut (DFAi) spécifique du paramètre de mesure soit fixée à un mot qui est légèrement plus petit ou légèrement plus grand que la valeur de paramètre de mesure d'une brasure de référence encore sans défaut (SFGREF).

25. Configuration de circuit selon l'une des revendications 17 à 24, **caractérisée en ce que** le programme de commande est architecturé en outre de façon à ce que la brasure (SJ) est estimée non-défectueuse lors du contrôle si le paramètre de mesure est au minimum aussi grand ou au maximum aussi grand qu'une première valeur seuil (Ti1) définissable au préalable.

26. Configuration de circuit selon la revendication 25, **caractérisée en ce que** le programme de commande est architecturé en outre de façon à ce que la première valeur seuil (Ti1) spécifique du paramètre de mesure est de même grandeur que la valeur limite supérieure d'intervalle (UVDFAi) de l'intervalle de valeurs effectives de défaut (DFAi) spécifiques du paramètre de mesure.

27. Configuration de circuit selon l'une des revendications 25 à 26, **caractérisée en ce que** le programme de commande est architecturé en outre de façon que la brasure (SJ) soit estimée non-défectueuse lors du contrôle si la valeur du paramètre de mesure est au moins égale ou au maximum d'égale grandeur qu'une deuxième valeur seuil (Ti2) spécifique du paramètre de mesure qui est plus petite ou plus grande d'un écart (ia) de la valeur seuil spécifique du paramètre de mesure que la première valeur seuil (Ti1) spécifique du paramètre de mesure.

28. Configuration de circuit selon l'une des revendications 17 à 27, **caractérisée en ce que** le programme de commande est architecturé, en outre, de façon que la grandeur d'un écart admissible (a) de la valeur seuil spécifique du paramètre de mesure d'un premier paramètre de mesure et/ou les grandeurs d'autres écarts admissibles (b, c) de la valeur seuil spécifique du paramètre de mesure présentés par d'autres paramètres de mesure sont déterminées en fonction d'une valeur de référence définissable préalablement (CTAREF) d'une surface de contact (CTA), qui est formée entre l'agent de brasage (SM) et l'élément de contact (PIN) d'une brasure (SJ) à contrôler.

29. Configuration de circuit selon l'une des revendications 27 ou 28, **caractérisée en ce que** le programme de commande est architecturé, en outre, de façon que la grandeur d'un écart admissible (a) de la valeur seuil spécifique du paramètre de mesure présenté par un premier paramètre de mesure et/ou les grandeurs d'autres écarts admissibles (b, c) de la valeur seuil spécifique du paramètre de mesure présentés par d'autres paramètres de mesure sont déterminées en fonction d'une valeur de référence (CTAREF) définissable préalablement d'une combinaison mathématique des écarts de la valeur seuil (a, b, c), en particulier d'une formation de produit, d'une formation de moyenne et/ou d'une formation de somme des écarts de la valeur seuil.

30. Configuration de circuit selon la revendication 28, **caractérisée en ce que** le programme de commande est architecturé, en outre, de façon à ce qu'en fonction de valeurs de paramètre de mesure de premiers paramètres de mesure, on génère une première information signifiant la probabilité de l'existence d'un contact électrique entre l'agent de brasage (SM) et l'élément de contact (PIN), et **en ce qu'**à l'aide de valeurs de paramètre de mesure de deuxièmes paramètres de mesure, la grandeur de la surface de contact (CTA) est déterminée.

31. Configuration de circuit selon l'une des revendications 29 ou 30, **caractérisée en ce que** le programme de commande est encore architecturé de manière à ce que la grandeur de la surface de contact (CTA) est déterminée au moyen d'une information qui identifie une étendue en longueur (ml) de la brasure (SJ, SJREF) et/ou une étendue en largeur (b) de la brasure (SJ) et/ou une largeur de vallée (v) d'une section transversale de la brasure (SJ) et/ou une première dénivellation (hp) entre un point de sommet (heel) et un point de creux (pad) de la brasure et/ou une seconde dénivellation (phd) entre le point de sommet (heel) de la brasure (SJ) et le substrat (BOARD) et/ou un abaissement (neg) dans une zone marginale de la brasure (SJ) et/ou un relèvement dans une zone marginale de la brasure (SJ) et/ou un mélange de matières (d) dans une zone de la brasure (SJ) définissable préalablement.

32. Configuration de circuit selon l'une des revendications 17 à 31, **caractérisée en ce que** le programme de commande est architecturé, en outre, de manière à ce que des opérations à effectuer avant le contrôle de la brasure (SJ) sont effectuées avec un décalage dans le temps.

33. Configuration de circuit selon l'une des revendications 17 à 32, **caractérisée en ce que** le programme de commande est encore architecturé de manière à ce que, comme résultat du contrôle, on génère soit une première information (INFSJG) signifiant l'absence de défaut d'une brasure (SJ) non-défectueuse contrôlée, et/ou une seconde information (INFSJB) signifiant la présence d'un défaut dans une brasure défectueuse contrôlée (SJ), et **en ce que** la première information (INFSJG) et/ou la seconde information (INFSJB) sont utilisées pour la commande d'un procédé de restauration de brasures.
